# EUROPEAN PATENT SPECIFICATION

(11) **EP 2 447 773 B1**
(45) Date of publication and mention of the grant of the patent: **10.07.2013**
(21) Application number: 11187262.8
(22) Date of filing: 31.10.2011
(51) Int. Cl.: G03F 7/039, G03F 7/40

(54) **Method for producing a pattern, method for producing a MEMS structure, use of a cured film of a photosensitive composition as a sacrificial layer or as a component of a MEMS structure**
Musterherstellungsverfahren, Verfahren zur Herstellung einer MEMS-Struktur, Verwendung eines gehärteten Films aus lichtempfindlicher Harzzusammensetzung als Opferschicht oder als Komponente einer MEMS-Struktur
Procédé pour la production d'un motif, procédé pour la production d'une structure MEMS, utilisation d'un film durci de résine photopolymérizable comme couche sacrificielle ou comme composant d'une structure MEMS

(30) Priority: 02.11.2010 JP 2010246703; 02.11.2010 JP 2010246704; 09.02.2011 JP 2011025761; 11.03.2011 JP 2011054361
(43) Date of publication of application: 02.05.2012
(73) Proprietor: Fujifilm Corporation, Minato-ku Tokyo (JP)
(72) Inventor: Yonezawa, Hiroyuki, Shizuoka (JP); Shimono, Katsuhiro, Shizuoka (JP)
(74) Representative: HOFFMANN EITLE

(56) References cited:
- EP-A1- 2 154 571
- WO-A2-2005/079330
- JP-A- 2005 049 691

## Description

The present invention relates to a method for producing a pattern, a method for producing a MEMS structure, and the use of a cured film of a photosensitive resin composition.

In production processes of liquid crystal display apparatuses, organic EL display apparatuses, semiconductor devices, MEMS and the like, photosensitive resin compositions have been used as etching resists. Particularly, chemically amplified positive resists have been actively used for the applications of etching resist, as the resists have high resolution and high sensitivity.

Micro Electro Mechanical Systems (MEMS), to which attention has been paid in recent years as devices in which a mechanical driving part, a sensor, an actuator and an electronic circuit are integrated on a silicon substrate, a glass substrate, an organic material or the like, are expected to be developed in various fields including from the information and communication field, to the fields of automobiles, domestic appliances, medicine, and biotechnology. On the other hand, the demand for downsizing of MEMS devices in these various fields tends to ever increase, such that there is a demand for the development of a photosensitive resin composition capable of forming a fine resist pattern and a process for producing MEMS devices utilizing the resin composition.

As a conventional photosensitive resin composition, for example, JP-A-10-73923 (JP-A denotes a Japanese unexamined patent application publication.) suggests a positive type photosensitive resin composition for etching resists.

JP-T-2008-533510 (JP-T denotes a published Japanese translation of a PCT application.) discloses an example of the production of a MEMS structure using a sacrificial layer resist.

Furthermore, JP-T-2007-522531, JP-A-2008-250200 and JP-A-2009-263544 disclose a photosensitive resin composition capable of forming a fine resist pattern with a large film thickness and a high aspect ratio without any fluctuation in the pattern dimension, and a MEMS device in which the resist pattern is incorporated as a part.

For example, in the case of a sacrificial layer resist used in a production of a MEMS, since the resist shape is directly reflected to a upper laminated structure, the control of the shape of the resist is important.

Furthermore, when a resist is used as an etching resist in a dry etching process, it is required to form a profile with a large taper angle close to a rectangular shape, in order to realize a production of a precise pattern by etching.

Also, durability properties such as solvent resistance, chemical resistance and mechanical strength are required to a certain extent, lest the resist film swell in the dry etching or wet etching process, causing peeling, dissolution or disappearance of the resist film.

In the case of using the resist film as a thick resist film or a thick MEMS structural member, a profile control technology is considered relatively important because high sensitivity is required in order to obtain an appropriate pattern in a development step, and the influence of heat flow or curing shrinkage is increased in thick films. A thick film refers to a usage form of a resist in which a dry film thickness after the removal of solvent is 4 to 100 µm.

In conventional etching resists, it has been difficult to obtain a profile that is rectangular or close to a rectangle, when a bake process for enhancing a cured film strength is carried out.

For example, the photosensitive resin composition described in JP-A-10-73923 has a problem that a rectangular profile cannot be obtained due to a heat flow at the time of a bake process.

JP-A-2005-049691 and EP-A-2 154 571 teach a method of forming a pattern by removing a solvent from a photosensitive composition, exposing the film pattern-wise to active radiation, developing the exposed film with an aqueous developer liquid to form a pattern, and baking the pattern by heating. The photosensitive resin composition contains a polymer, a photo-acid generator and a solvent. The polymer of '691 is formed from an unsaturated carboxylic acid and/or an unsaturated carboxylic acid anhydride, an unsaturated compound containing an alicyclic epoxy group and a third unsaturated compound of a different type and examplifies a two-steps post backing. The polymer of '571 includes units having an acetal/ketal-protected carboxyl group, and units having a group, such as an epoxy group, capable of reacting with a carboxyl group.

A problem that is to be solved by the present invention is to provide a photosensitive resin composition for etching resist or MEMS structural member, which is capable of forming a profile that is rectangular or close to a rectangle even after a formed pattern is baked.

According to a first aspect, the present invention provides a method for producing a pattern comprising:
forming a film by removing the solvent from a photosensitive resin composition containing (Component A) a polymer including a monomer unit (a1) having a residue of a carboxyl group or a phenolic hydroxyl group protected with an acid-decomposable group, and a monomer unit (a2) having an epoxy group and/or an oxetanyl group; (Component B) a photo acid generator; and (Component C) a solvent;
exposing the film patternwise to an active radiation;
developing the exposed film with an aqueous developer liquid to form a pattern; and
baking the pattern by heating it in two stages, the first stage baking being carried out at a temperature in the range of 90°C to 150°C and the second stage baking being carried out at a temperature in the range of 180°C to 250°C.

Preferably the method further comprises the step of exposing the pattern to active radiation after the developing step and before the baking step.

Preferably the thickness of the pattern after the baking is 4 to 100 µm.

Preferably the photosensitive resin composition further contains a thermal crosslinking agent.

Preferably the Component A further comprises a monomer unit (a3) having a cyclic structure in addition to the monomer units (a1) and (a2).

Preferably the Component A further includes a monomer unit (a4) having a carboxyl group or a hydroxyl group, in addition to the monomer units (a1) and (a2).

According to a second aspect, the present invention provides a method for producing a MEMS structure comprising:
either (i) producing a structure by using a pattern produced by the method according to the above first aspect as a sacrificial layer at the time of lamination of the structure, and removing the sacrificial layer by plasma treatment; or
(ii) using a pattern produced by the method according to the above first aspect as a component of the MEMS structure.

According to a third aspect, the present invention provides the use of a cured film of a photosensitive resin composition as a sacrificial layer at the time of lamination of a MEMS structure or as a component of a MEMS structure,
the cured film being formed by performing heating in two stages, the heating in the first stage being carried out at a temperature in the range of 90°C to 150°C, and the heating in the second stage being carried out at a temperature in the range of 180°C to 250°C, and
the photosensitive resin composition comprising:
   (Component A) a polymer including a monomer unit (a1) having a residue of a carboxyl group or a phenolic hydroxyl group protected with an acid-decomposable group, and a monomer unit (a2) having an epoxy group and/or an oxetanyl group;
   (Component B) a photo acid generator; and
   (Component C) a solvent.

Preferably the Component A further includes a monomer unit (a3) having a cyclic structure, in addition to the monomer units (a1) and (a2).

Preferably the component A further includes a monomer unit (a4) having a carboxyl group or a hydroxyl group, in addition to the monomer units (a1) and (a2).

According to the present invention, there is provided a method for producing a baked pattern which is capable of forming a profile that is rectangular or close to a rectangle. Particularly, the photosensitive resin composition for use in the invention is adequate for the application of thick film resist where rectangle-forming properties are required.

### Brief Description of the Drawings

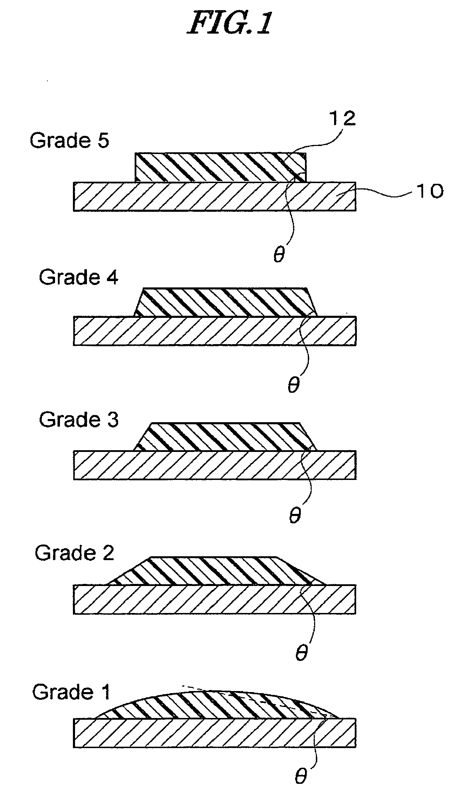

FIG. 1 is a schematic diagram showing the cross-section profile after baking. Description of Reference Numerals and Signs
10: Substrate
12: Pattern
θ: Taper angle

Hereinafter, the photosensitive resin composition of the present invention will be described in detail.

According to the present invention, the description of "lower limit to upper limit", which indicates a range of values, indicates "equal to or more than the lower limit and equal to or less than the upper limit," and the description of "upper limit to lower limit" indicates "equal to or less than the upper limit and equal to or more than the lower limit." That is, the descriptions indicate the ranges of values including the upper limit and the lower limit.

According to the present invention, the "(Component A) polymer including a monomer unit (a1) having a residue of a carboxyl group or a phenolic hydroxyl group protected with an acid-decomposable group, and a monomer unit (a2) having an epoxy group and/or an oxetanyl group" or the like will be simply referred to as "Component A," and the "monomer unit (a1) having a residue of a carboxyl group or a phenolic hydroxyl group protected with an acid-decomposable group" or the like will be simply referred to as "monomer unit (a1)."

### (Photosensitive resin composition for etching resist or for MEMS structural member)

The photosensitive resin composition for etching resist or for a MEMS structural member of the present invention (hereinafter, also simply referred to as "photosensitive resin composition") is characterized by containing (Component A) a polymer including a monomer unit (a1) having a residue of a carboxyl group or a phenolic hydroxyl group protected with an acid-decomposable group, and a monomer unit (a2) having an epoxy group and/or an oxetanyl group; (Component B) a photo acid generator; and (Component C) a solvent.

The photosensitive resin composition of the present invention is preferably a positive type photosensitive resin composition, and particularly preferably a positive type photosensitive resin composition of chemically amplified type (chemically amplified positive type photosensitive resin composition).

The term MEMS has been used with various definitions, but the term 'MEMS' according to the present invention is presumed to include a mechanical driving part, and does not include, for example, a device constituted only of an electronic circuit such as a TFT element.

The photosensitive resin composition for etching resist or for a MEMS structural member of the present invention is preferably a photosensitive resin composition for thick film etching resist or for a thick film MEMS structural member having a thickness of 4 to 100 µm.

Furthermore, the photosensitive resin composition for etching resist or for a MEMS structural member of the present invention is preferably a photosensitive resin composition for etching resist which is capable of forming a baked cross-sectional shape having a taper angle of 70° or larger.

The "taper angle" is the angle formed by the lateral side of the pattern and the substrate plane on which the pattern is formed, in the cross-sectional shape obtained after forming a pattern and performing baking. When the cross-sectional shape of the lateral side of the pattern is not straight, the angle formed between a straight line connecting an end of the lower surface of the pattern which is in contact with the substrate, with an end of the upper surface of the pattern, and the plane of the substrate is designated as the taper angle. Meanwhile, when the cross-sectional shape of the lateral side of the pattern is semicircular or arch-shaped, and the upper surface of the pattern is not recognized, the angle formed between a straight line connecting a point on the arch that is remotest from the substrate, with an end of the lower surface of the pattern that is in contact with the substrate, and the upper surface of the substrate.

As a specific example, θ in the respective pattern cross-sectional shapes shown in FIG. 1 represents a taper angle.

In the example of Evaluation Point 1 of FIG. 1, since the pattern cross-sectional shape is arch-shaped, and the upper surface of the pattern is not recognized, the angle formed between a straight line connecting the apex of the arch, which is the remotest point on the arch from the substrate, and an end of the lower surface of the pattern that is in contact with the substrate, and the plane of the substrate, is designated as θ.

Hereinafter, the respective Components constituting the photosensitive resin composition will be described.

In regard to the description of a group (atomic group) according to the present specification, a description without the term substituted or unsubstituted is intended to include a group having no substituent, as well as a group having a substituent. For example, an "alkyl group" means to include an alkyl group which has no substituent (unsubstituted alkyl group) as well as an alkyl group having a substitute (substituted alkyl group).
(Component A) Polymer including a monomer unit (a1) having a residue of a carboxyl group or a phenolic hydroxyl group protected with an acid-decomposable group, and a monomer unit (a2) having an epoxy group and/or an oxetanyl group

The photosensitive resin composition of the present invention contains (Component A) a polymer including a monomer unit (a1) having a residue of a carboxyl group or a phenolic hydroxyl group protected with an acid-decomposable group, and a monomer unit (a2) having an epoxy group and/or an oxetanyl group.

Component A preferably includes, in addition to the monomer units (a1) and (a2), a monomer unit (a3) having a cyclic structure, and/or a monomer unit (a4) having a carboxyl group or a hydroxyl group.

Component A may also include a monomer unit (a5) in addition to the monomer units (a1) to (a4).

The "monomer unit" according to the present invention is intended to include not only a constituent unit formed from one monomer molecule, but also a constituent unit obtained by modifying a constituent unit formed from one monomer molecule by a polymer reaction or the like.

The residue of a carboxyl group or a phenolic hydroxyl group protected with an acid-decomposable group can produce a carboxyl group or a phenolic hydroxyl group by decomposing (deprotecting) the acid-decomposable group with an acid.

Component A is preferably a resin which is alkali-insoluble, and becomes alkali-soluble when the acid-decomposable group in the monomer unit (a1) is decomposed.

The term "alkali-soluble" according to the present invention means that a coating film (thickness 4 µm) of the compound (resin) formed when a solution of the compound (resin) is applied on a substrate and heated for 2 minutes at 90°C, has a dissolution rate in a 0.4 wt% aqueous solution of tetramethylammonium hydroxide at 23°C of 0.01 µm/second or greater. The term "alkali-insoluble" means that a coating film (thickness 4 µm) of the compound (resin) formed when a solution of the compound (resin) is applied on a substrate and heated for 2 minutes at 90°C, has a dissolution rate in a 0.4 wt% aqueous solution of tetramethylammonium hydroxide at 23°C of less than 0.01 µm/second, preferably less than 0.005 µm/second.

The weight average molecular weight (Mw) of Component A is preferably 5,000 or greater, more preferably 12,000 or greater, and yet more preferably 20,000 or greater, and is preferably 1,000,000 or less, more preferably 80,000 or less, and yet more preferably 60,000 or less. When the weight average molecular weight is 12,000 or greater, a profile having a satisfactory rectangular shape or a shape close to a rectangle can be obtained even after a bake step. Furthermore, when the weight average molecular weight is 80,000 or less, excellent pattern formability at the time of development is obtained.

Meanwhile, the weight average molecular weight is a value measured by gel permeation chromatography (GPC) and calculated relative to polystyrene standards. It is preferable to measure the weight average molecular weight using THF as a solvent, and using TSKgel SuperHZ3000 and TSKgel SuperHZM-M columns (all manufactured by Tosoh Corp.).

Component A is preferably an acrylic polymer.

The "acrylic polymer" according to the present invention is an addition polymerized resin, and is a polymer containing a monomer unit derived from (meth)acrylic acid or an ester thereof. The "acrylic polymer" may also have a monomer unit other than the monomer derived from (meth)acrylic acid or an ester thereof, for example, a monomer unit derived from a styrene or a monomer unit derived from a vinyl compound. Furthermore, Component A may also include a monomer unit derived from (meth)acrylic acid and a monomer unit derived from a (meth)acrylic acid ester together.

In the present specification, the "monomer unit derived from (meth)acrylic acid or an ester thereof is also referred to as an "acrylic monomer unit." Furthermore, (meth)acrylic acid is meant to collectively refer to methacrylic acid and acrylic acid.

Component A preferably has an acetal structure or a ketal structure, and may have both an acetal structure and a ketal structure.

The acetal structure or the ketal structure is preferably a structure represented by the following formula (I).

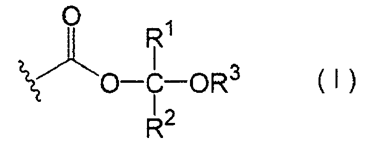

In the formula (I), R¹ and R² each independently represent a hydrogen atom, a linear or branched alkyl group, or a cycloalkyl group, provided that at least one of R¹ and R² represents an alkyl group or a cycloalkyl group.

In the formula (I), R³ represents a linear or branched alkyl group, a cycloalkyl group, or an aralkyl group.

R¹ or R² and R³ may be joined to form a cyclic ether.

In the formula (I), the wavy line represents the position of bonding to another structure.

The alkyl group for R¹ and R² of the formula (I) is preferably a linear or branched alkyl group having 1 to 6 carbon atoms. The cycloalkyl group for R¹ and R² is preferably a cycloalkyl group having 3 to 6 carbon atoms.

The alkyl group for R³ of the formula (I) is preferably a linear or branched alkyl group having 1 to 10 carbon atoms. The cycloalkyl group for R³ is preferably a cycloalkyl group having 3 to 10 carbon atoms. The aralkyl group for R³ is preferably an aralkyl group having 7 to 10 carbon atoms.

When R¹ or R² and R³ are joined to form a cyclic ether, it is preferable that R¹ or R² and R³ be joined to form an alkylene chain having 2 to 5 carbon atoms.

The alkyl group, cycloalkyl group and aralkyl group for R³ may be substituted with a substituent. Examples of the substituent include an alkyl group, an alkoxy group, and a halogen atom. Furthermore, the number of carbon atoms of the substituent is preferably 6 or less.

In the formula (I), examples of R⁷ in an acetal ester structure (-COOR⁷) of a carboxylic acid in which one of R¹ and R² is a hydrogen atom, include a 1-methoxyethyl group, a 1-ethoxyethyl group, a 1-*n*-propoxyethyl group, a 1-*i*-propoxyethyl group, a 1-*n*-butoxyethyl group, a 1-*i*-butoxyethyl group, a 1-*sec*-butoxyethyl group, a 1-*t*-butoxyethyl group, a 1-cyclopentyloxyethyl group, a 1-cyclohexyloxyethyl group, a 1-norbornyloxyethyl group, a 1-bornyloxyethyl group, a 1-benzyloxyethyl group, a 1-phenethyloxyethyl group, a cyclohexyl(methoxy)methyl group, a cyclohexyl(ethoxy)methyl group, a cyclohexyl(*n*-propoxy)methyl group, a cyclohexyl(*i*-propoxy)methyl group, a cyclohexyl(cyclohexyloxy)methyl group, a cyclohexyl(benzyloxy)methyl group, an α-methoxybenzyl group, an α-ethoxybenzyl group, an α-*n*-propoxybenzyl group, an α-*i*-propoxybenzyl group, an α -cyclohexyloxybenzyl group, an α-benzyloxybenzyl group, a 2-phenyl-1-methoxyethyl group, a 2-phenyl-1-ethoxyethyl group, a 2-phenyl-1-*n*-propoxyethyl group, a 2-phenyl-1-*i*-propoxyethyl group, a 2-phenyl-1-cyclohexxyloxyethyl group, a 2-phenyl-1-benzyloxyethyl group, a 2-tetrahydrofuranyl group, and a 2-tetrahydropyranyl group.

In the formula (I), examples of R⁸ in a ketal ester structure (-COOR⁸) of a carboxylic acid in which none of R¹ and R² is a hydrogen atom, include a 1-methyl-1-methoxyethyl group, a 1-methyl-1-ethoxyethyl group, a 1-methyl-1-*n*-propoxyethyl group, a 1-methyl-9-*i*-propoxyethyl group, a 1-methyl-1-*n*-butoxyethyl group, a 1-methyl-1-*i*-butoxyethyl group, a 1-methyl-1-*sec*-butoxyethyl group, a 1-methyl-1-*t*-butoxyethyl group, a 1-methyl-1-cyclopentyloxyethyl group, a 1-methyl-1-cyclohexyloxyethyl group, a 1-methyl-1-norbornyloxyethyl group, a 1-methyl-1-bornyloxyethyl group, a 1-methyl-1-benzyloxyethyl group, a 1-methyl-1-phenethyloxyethyl group, a 1-cyclohexyl-1-methoxyethyl group, a 1-cyclohexyl-1-ethoxyethyl group, a 1-cyclohexyl-1-*n*-propoxyethyl group, a 1-cyclohexyl-1-*i*-propoxyethyl group, a 1-cyclohexyl-1-cyclohexyloxyethyl group, a 1-cyclohexyl-1-benzyloxyethyl group, a 1-phenyl-1-methoxyethyl group, a 1-phenyl-1-ethoxyethyl group, a 1-phenyl-1-*n*-propoxyethyl group, a 1-phenyl-1-*i*-propoxyethyl group, a 1-phenyl-1-cyclohexyloxyethyl group, a 1-phenyl-1-benzyloxyethyl group, a 1-benzyl-1-methoxyethyl group, a 1-benzyl-1-ethoxyethyl group, a 1-benzyl-1-*n*-propoxyethyl group, a 1-benzyl-1-*i*-propoxyethyl group, a 1-benzyl-1-cyclohexyloxyethyl group, a 1-benzyl-1-benzyloxyethyl group, a 2-methyl-2-tetrahydrofuranyl group, a 2-methyl-2-tetrahydropyranyl group, a 1-methoxycyclopentyl group, and a 1-methoxycyclohexyl group.

In regard to the acetal structure or ketal structure of a carboxylic acid, the acetal structure is more preferable from the viewpoint of process stability.

R⁷ in the acetal ester structure (-COOR⁷) of a carboxylic acid is preferably a 1-ethoxyethyl group, a 1-cyclohexyloxyethyl group, a 2-tetrahydrofuranyl group, or a 2-tetrahydropyranyl group, and from the viewpoint of sensitivity, a 1-ethoxyethyl group or a 1-cyclohexyloxyethyl group is particularly preferable.

Component A preferably includes a monomer unit derived from (meth)acrylic acid and/or an ester thereof in an amount of 50 mol% or more, and more preferably 90 mol% or more, based on all the monomer units of Component A, and it is particularly preferable that Component A be a polymer composed only of a monomer unit derived from (meth)acrylic acid and/or an ester thereof.

Hereinafter, various monomer units such as the monomer unit (a1) and the monomer unit (a2) will be described.

### <Monomer unit (a1) having a residue of a carboxyl group or a phenolic hydroxyl group protected with an acid-decomposable group>

Component A has at least a monomer unit (a1) having a residue of a carboxyl group or a phenolic hydroxyl group protected with an acid-decomposable group.

When Component A has the monomer unit (a1), a photosensitive resin composition having very high sensitivity can be obtained. A monomer unit having a residue of a carboxyl group protected with an acid-decomposable group, is characterized in that development is rapidly achieved, as compared with a monomer unit having a residue of a phenolic hydroxyl group protected with an acid-decomposable group. Therefore, for development to be rapid, a monomer unit having a residue of a carboxyl group protected with an acid-decomposable group is preferable. On the contrary, for development to be delayed, it is preferable to use a monomer unit having a residue of a phenolic hydroxyl group protected with an acid-decomposable group. {Monomer unit (a1-1) having residue of carboxyl group protected with acid-decomposable group}

### - Monomer unit (a1-1-1) having carboxyl group -

A monomer unit having a carboxyl group may be, for example, a monomer unit derived from an unsaturated carboxylic acid having at least one carboxyl group in the molecule, such as an unsaturated monocarboxylic acid, an unsaturated dicarboxylic acid, or an unsaturated tricarboxylic acid.

Examples of the unsaturated carboxylic acid used to obtain the monomer unit having a carboxyl group include the acids described below. That is, examples of the unsaturated monocarboxylic acid include acrylic acid, methacrylic acid, crotonic acid, α -chloroacrylic acid, and cinnamic acid. Examples of the unsaturated dicarboxylic acid include maleic acid, fumaric acid, itaconic acid, citraconic acid, and mesaconic acid. Furthermore, the unsaturated polyvalent carboxylic acid used to obtain the monomer unit having a carboxyl group may also be in the form of an acid anhydride thereof. Specific examples include maleic anhydride, itaconic anhydride, and citraconic anhydride. Furthermore, the unsaturated polyvalent carboxylic acid may be a mono(2-methacryloyloxyalkyl) ester of a polyvalent carboxylic acid, and examples include mono(2-acryloyloxyethyl) succinate, mono(2-methacryloyloxyethyl) succinate, mono(2-acryloyloxyethyl) phthalate, and mono(2-methacryloyloxyethyl) phthalate.

Furthermore, the unsaturated polyvalent carboxylic acid may be a mono(meth)acrylate of a dicarboxypolymer having the unsaturated polyvalent carboxylic acid at the two ends, and examples thereof include ω-carboxypolycaprolactone monoacrylate, and ω-carboxypolycaprolactone monomethacrylate.

As the unsaturated carboxylic acid, acrylic acid-2-carboxyethyl ester, methacrylic acid-2-carboxyethyl ester, maleic acid monoalkyl ester, fumaric acid monoalkyl ester, 4-carboxystyrene and the like can also be used.

Among them, from the viewpoint of developability, it is preferable to use acrylic acid, methacrylic acid, or an anhydride of an unsaturated polyvalent carboxylic acid in order to form the monomer unit having a carboxyl group, and it is more preferable to use acrylic acid or methacrylic acid.

The monomer unit (a1-1-1) having a carboxyl group may be composed of one kind only, or may be composed of two or more kinds.

The monomer unit (a1-1-1) having a carboxyl group may be a monomer unit obtained by allowing a monomer unit having a hydroxyl group to react with an acid anhydride.

As the acid anhydride, known compounds may be used, and specific examples include dibasic acid anhydrides such as maleic anhydride, succinic anhydride, itaconic anhydride, phthalic anhydride, tetrahydrophthalic anhydride, hexahydrophthalic anhydride, and chlorendic anhydride; and acid anhydrides such as trimellitic anhydride, pyromellitic anhydride, benzophenonetetracarboxylic acid anhydride, and biphenyltetracarboxylic acid anhydride. Among these, from the viewpoint of developability, phthalic anhydride, tetrahydrophthalic anhydride, and succinic anhydride are preferable.

The reaction ratio of the acid anhydride with respect to the hydroxyl group is preferably 10 to 100 mol%, and more preferably 30 to 100 mol%, from the viewpoint of developability.

### (a1-1-2) Monomer unit having a residue of a carboxyl group protected with an acid-decomposable group

The monomer unit having a residue of a carboxyl group protected with an acid-decomposable group is preferably a monomer unit in which the carboxyl group of the monomer unit (a1-1-1) having a carboxyl group has a residue protected by an acid-decomposable group that will be described in detail below.

As the acid-decomposable group, groups hitherto known as acid-decomposable groups for positive resist for KrF and positive resist for ArF can be used, and there are no particular limitations thereon. Conventionally, a group that can be relatively easily decomposed by an acid (for example, an acetal-based functional group such as a tetrahydropyranyl group) and a group which cannot be relatively easily decomposed by an acid (for example, a t-butyl-based functional group such as a t-butyl ester group or a t-butyl carbonate group) are known.

Among these acid-decomposable groups, a monomer unit in which the acid-decomposable group is a residue in which a carboxyl group is protected with an acetal, or is a residue in which a carboxyl group protected with a ketal, is preferable from the viewpoints of the fundamental properties of the resist, particularly sensitivity, pattern shape, contact hole formability, and storage stability of the photosensitive resin composition. Furthermore, among the acid-decomposable groups, it is more preferable, from the viewpoint of sensitivity, that the monomer unit have a residue in which a carboxyl group is protected with an acetal or ketal represented by the following formula (a1-1). Meanwhile, in the case of a residue in which a carboxyl group is protected with an acetal or ketal represented by the following formula (a1-1), the residue has an overall structure of -C(=O)-O-CR¹R²(OR³), 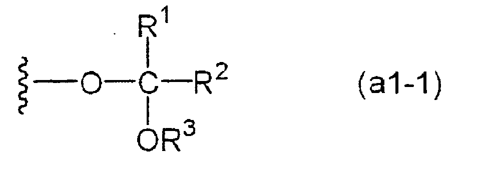 wherein R¹ and R² each independently represent a hydrogen atom or an alkyl group, provided that the case where R¹ and R² are both hydrogen atoms is excluded; R³ represents an alkyl group; R¹ or R² and R³ may be joined to form a cyclic ether; and the wavy line represents the position of bonding to another structure.

In the formula (a1-1), R¹ to R³ each independently represent a hydrogen atom or an alkyl group, and the alkyl group may be either linear, branched or cyclic. Here, it is not necessary that both of R¹ and R² represent hydrogen atoms, and at least one of R¹ and R² represents an alkyl group.

In the formula (a1-1), when R¹, R² and R³ represent alkyl groups, the alkyl group may be either linear, branched or cyclic.

The linear or branched alkyl group preferably has 1 to 12 carbon atoms, more preferably 1 to 6 carbon atoms, and yet more preferably 1 to 4 carbon atoms. Specific examples include a methyl group, an ethyl group, a *n*-propyl group, an *i*-propyl group, a *n*-butyl group, an *i*-butyl group, a *sec*-butyl group, a *t*-butyl group, a *n*-pentyl group, a neopentyl group, a *n*-hexyl group, a thexyl group (2,3-dimethyl-2-butyl group), a *n*-heptyl group, a *n*-octyl group, a 2-ethylhexyl group, a *n*-nonyl group, and a *n*-decyl group.

The cyclic alkyl group preferably has 3 to 12 carbon atoms, more preferably 4 to 8 carbon atoms, and yet more preferably 4 to 6 carbon atoms. Examples of the cyclic alkyl group include a cyclopropyl group, a cyclobutyl group, a cyclopentyl group, a cyclohexyl group, a cycloheptyl group, a cyclooctyl group, a norbornyl group, and an isobornyl group.

The alkyl group may be substituted with a substituent, and examples of the substituent include a halogen atom, an aryl group, and an alkoxy group. When the alkyl group has a halogen atom as the substituent, R¹, R² and R³ becomes haloalkyl groups, and when the alkyl group has an aryl group as the substituent, R¹, R² and R³ become aralkyl groups.

Examples of the halogen atom include a fluorine atom, a chlorine atom, a bromine atom, and an iodine atom, and among these, a fluorine atom and a chlorine atom are preferable.

The aryl group is preferably an aryl group having 6 to 20 carbon atoms, and more preferably an aryl group having 6 to 12 carbon atoms. Specific examples include a phenyl group, an α-methylphenyl group, and a naphthyl group.

The aralkyl group is preferably an aralkyl group having 7 to 32 carbon atoms, and more preferably an aralkyl group having 7 to 20 carbon atoms. Specific examples include a benzyl group, an α-methylphenyl group, a phenethyl group, and a naphthylmethyl group.

The alkoxy group is preferably an alkoxy group having 1 to 6 carbon atoms, and more preferably an alkoxy group having 1 to 4 carbon atoms. A methoxy group or an ethoxy group is yet more preferable.

When the alkyl group is a cycloalkyl group, the cycloalkyl group may have a linear or branched alkyl group having 1 to 10 carbon atoms as a substituent, and when the alkyl group is a linear or branched alkyl group, the group may have a cycloalkyl group having 3 to 12 carbon atoms as a substituent.

These substituents may be further substituted with the substituents described above.

In the formula (a1-1), when R¹, R² and R³ represent aryl groups, the aryl group preferably has 6 to 12 carbon atoms, and more preferably has 6 to 10 carbon atoms. The aryl group may be substituted with a substituent, and a preferable example of the substituent is an alkyl group having 1 to 6 carbon atoms. Examples of the aryl group include a phenyl group, a tolyl group, a silyl group, a cumenyl group, and a 1-naphthyl group.

Furthermore, R¹, R² and R³ may be joined to each other and may form a ring together with the carbon atoms to which they are bonded. Examples of the cyclic structure that can be formed when R¹ and R², R¹ and R³, or R² and R³ are joined, include a cyclobutyl group, a cyclopentyl group, a cyclohexyl group, a cycloheptyl group, a tetrahydrofuranyl group, an adamantyl group, and a tetrahydropyranyl group.

In the formula (a1-1), it is preferable that any one of R¹ and R² be a hydrogen atom or a methyl group.

For the radical polymerizable monomer used to form the monomer unit having a residue represented by the formula (a1-1), a commercially available compound may be used, or a product synthesized by a known method may also be used. For example, as shown below, the monomer can be synthesized by allowing (meth)acrylic acid to react with a vinyl ether in the presence of an acid catalyst.

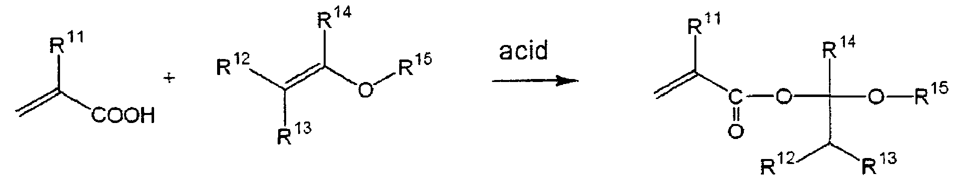

R¹¹ represents a hydrogen atom or an alkyl group, and is preferably a hydrogen atom or a methyl group.

R¹² and R¹³, as in the form of -CH(R¹²)(R¹³), have the same meaning as R² defined for the formula (a1-1), and R¹⁴ has the same meaning as R¹ defined for the formula (a1-1). R¹⁵ has the same meaning as R³ defined for the formula (a1-1), and these substituents also have the same preferable ranges as R¹, R² and R³.

The above-mentioned synthesis may be carried out by copolymerizing (meth)acrylic acid with the other monomer in advance, and then allowing the product to react with a vinyl ether in the presence of an acid catalyst.

Specific preferable examples of the monomer unit (a1-1) having a residue of a carboxyl group protected with an acid-decomposable group include the following monomer units. R represents a hydrogen atom or a methyl group.

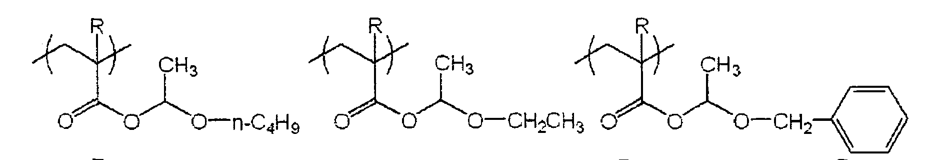

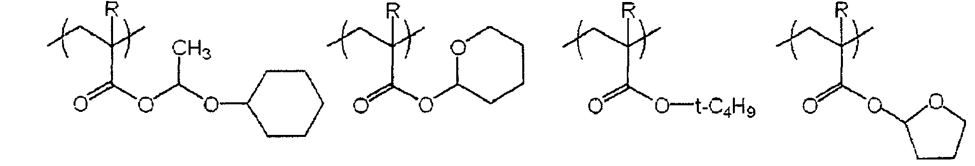

### {Monomer unit (a1-2) having residue of phenolic hydroxyl group protected with acid-decomposable group}

### - Monomer unit (a1-2-1) having phenolic hydroxyl group -

Examples of a monomer unit having a phenolic hydroxyl group include a hydroxystyrene-based monomer unit and a monomer unit found in a novolac-based resin. Among these, a monomer unit derived from α-methylhydroxystyrene is preferable from the viewpoint of transparency. Among the monomer units having a phenolic hydroxyl group, a monomer represented by formula (a1-2) is preferable from the viewpoint of transparency and sensitivity. 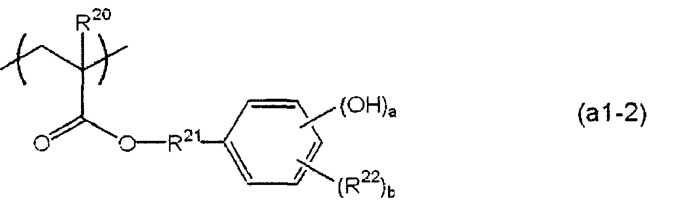 wherein R²⁰ represents a hydrogen atom or a methyl group; R²¹ represents a single bond or a divalent linking group; R²² represents a halogen atom or an alkyl group; a represents an integer from 1 to 5, b represents an integer from 1 to 4, while a+b is 5 or less; and when there are two or more of R²², these R²²'s may be different or may be identical.

In the formula (a1-2), R²⁰ represents a hydrogen atom or a methyl group, and is preferably a methyl group.

Furthermore, R²¹ in the formula (a1-2) represents a single bond or a divalent linking group. In the case of a single bond, it is preferable because sensitivity can be increased, and the transparency of the cured film can be increased. The divalent linking group of R²¹ may be an alkylene group, and specific examples of the alkylene group as R²¹ include a methylene group, an ethylene group, a propylene group, an isopropylene group, an n-butylene group, an isobutylene group, a tert-butylene group, a pentylene group, an isopentylene group, a neopentylene group, and a hexylene group. Among these, it is preferable that R²¹ be a single bond, a methylene group or an ethylene group. Furthermore, the divalent linking group may be substituted with a substituent, and examples of the substituent include a halogen atom, a hydroxyl group, and an alkoxy group.

Furthermore, a in the formula (a1-2) represents an integer from 1 to 5, but from the viewpoints of the effect of the present invention or facilitated production, a is preferably 1 or 2, and a is more preferably 1.

The position of bonding of the hydroxyl group in the benzene ring is preferably such that R²¹ is bonded at the 4-position when the carbon atom bonded to R²¹ is taken as the reference position (1-position).

R²² in the formula (a1-2) represents a halogen atom, or a linear or branched alkyl group having 1 to 5 carbon atoms. Specific examples include a fluorine atom, a chlorine atom, a bromine atom, a methyl group, an ethyl group, a propyl group, an isopropyl group, a *n*-butyl group, an isobutyl group, a *tert*-butyl group, a pentyl group, an isopentyl group, and a neopentyl group. Among them, from the viewpoint that production is easy, R²² is preferably a chlorine atom, a bromine atom, a methyl group or an ethyl group.

Also, b represents 0 or an integer from 1 to 4.

Among the monomer units having a phenolic hydroxyl group, when R²¹ in the formula (a1-2) is not an alkylene group, a monomer unit represented by the formula (a1-2') is more preferable from the viewpoints of transparency and sensitivity. Preferable examples of the linking group of R²¹ include, in addition to an alkylene group, an alkyleneoxycarbonyl group (from the side of the main chain of the copolymer). In this case, it is preferable that the monomer unit having a phenolic hydroxyl group be represented by the following formula (a1-2'). 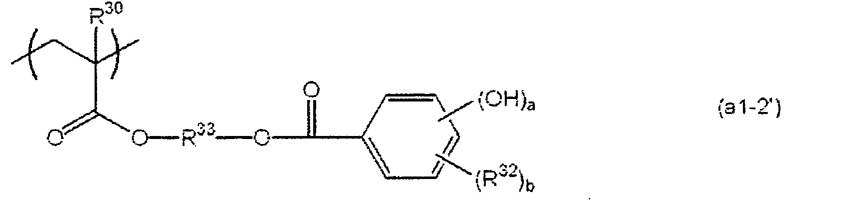 wherein R³⁰ represents a hydrogen atom or a methyl group; R³³ represents a divalent linking group; R³² represents a halogen atom or an alkyl group; a represents an integer from 1 to 5; b represents an integer from 0 to 4, while a+b is 5 or less; and when there are two or more R^{32'}s, these R^{32'}s may be identical with or different from each other.

In the formula (a1-2'), R³⁰ has the same meaning as R²⁰ in the formula (a1-2), R³² has the same meaning as R²² in the formula (a1-2), and a and b respectively have the same meanings as a and b in the formula (a1-2). They also have the same preferable ranges.

In the formula (a1-2'), R³³ represents a divalent linking group, and a preferable example may be an alkylene group. The alkylene group may be either a linear group or a branched group, and preferably has 2 to 6 carbon atoms. Examples thereof include an ethylene group, a propylene group, an isopropylene group, an n-butylene group, a tert-butylene group, a pentylene group, an isopentylene group, a neopentylene group, and a hexylene group. The divalent linking group may be substituted with a substituent, and examples of the substituent include a halogen atom, a hydroxyl group, and an alkoxy group. Among these, R³³ is preferably an ethylene group, a propylene group, or a 2-hydroxypropylene group, from the viewpoint of sensitivity.

### - Monomer unit (a1-2-2) having residue of phenolic hydroxyl group protected with acid-decomposable group -

The monomer unit having a residue of a phenolic hydroxyl group protected with an acid-decomposable group, is a monomer unit having a residue in which the phenolic hydroxyl group of the monomer unit (a1-2-1) having a phenolic hydroxyl group is protected by the acid-decomposable group that will be described in detail below.

As the acid-decomposable group, those groups that are well known can be used as previously described, and there are no particular limitations. Among the acid-decomposable group, a monomer unit having a residue of a phenolic hydroxyl group protected with an acetal, or a residue of a phenolic hydroxyl group protected with a ketal, is preferable from the viewpoints of the fundamental properties of the resist, particularly sensitivity, pattern shape, storage stability of the photosensitive resin composition, and contact hole formability. Furthermore, among the acid-decomposable groups, a residue in which a phenolic hydroxyl group is protected with an acetal or ketal represented by the formula (a1-1) is more preferable from the viewpoint of sensitivity. When the phenolic hydroxyl group is a residue protected with the acetal or ketal represented by the formula (a1-1), the overall structure of the residue is -Ar-O-CR¹R²(OR³). Here, Ar represents an arylene group.

Preferable examples of an acetal ester structure protecting the phenolic hydroxyl group include a combination of R¹, R² and R³ each being a methyl group, and a combination of R¹ and R² each being a methyl group and R³ being a benzyl group.

Examples of radical polymerizable monomers used to form the monomer unit having a residue of a phenolic hydroxyl group protected with an acetal or a ketal, include a 1-alkoxyalkyl-protected product of hydroxystyrene, a tetrahydropyranyl-protected product of hydroxystyrene, a 1-alkoxyalkyl-protected product of α -methylhydroxystyrene, a tetrahydropyranyl-protected product of α-methylhydroxystyrene, a 1-alkoxyalkyl-protected product of 4-hydroxyphenyl methacrylate, a tetrahydropyranyl-protected product of 4-hydroxyphenyl methacrylate, a 1-alkoxyaklyl-protected product of 4-hydroxybenzoic acid (1-methacryloyloxymethyl) ester, a tetrahydropyranyl-protected product of 4-hydroxybenzoic acid (1-methacryloyloxymethyl) ester, a 1-alkoxyalkyl-protected product of 4-hydroxybenzoic acid (2-methacryloyloxyethyl) ester, a tetrahydropyranyl-protected product of 4-hydroxybenzoic acid (2-methacryloyloxyethyl) ester, a 1-alkoxyalkyl-protected product of 4-hydroxybenzoic acid (3-methaeryloyloxypropyl) ester, a tetrahydropyranyl-protected product of 4-hydroxybenzoic acid (3-methacryloyloxypropyl) ester, a 1-alkoxyalkyl-protected product of 4-hydroxybenzoic acid (3-methacryloyloxy-2-hydroxypropyl) ester, and a tetrahydropyranyl-protected product of 4-hydroxybenzoic acid (3-methacryloyloxy-2-hydroxypropyl) ester.

Among these, a 1-alkoxyalkyl-protected product of 4-hydroxyphenyl methacrylate, a tetrahydropyranyl-protected product of 4-hydroxyphenyl methacrylate, a 1-alkoxyalkyl-protected product of 4-hydroxybenzoic acid (1-methacryloyloxymethyl) ester, a tetrahydropyranyl-protected product of 4-hydroxybenzoic acid (1-methacryloyloxymethyl) ester, a 1-alkoxyalkyl-protected product of 4-hydroxybenzoic acid (2-methacryloyloxyethyl) ester, a tetrahydropyranyl-protected product of 4-hydroxybenzoic acid (2-methacryloyloxyethyl) ester, a 1-alkoxyalkyl-protected product of 4-hydroxybenzoic acid (3-methacryloyloxypropyl) ester, a tetrahydropyranyl-protected product of 4-hydroxybenzoic acid (3-methacryloyloxypropyl) ester, a 1-alkoxyalkyl-protected product of 4-hydroxybenzoic acid (3-methacryloyloxy-2-hydroxypropyl) ester, and a tetrahydropyranyi-protected product of 4-hydroxybenzoic acid (3-methacryloyloxy-2-hydroxypropyl) ester are preferable from the viewpoint of transparency.

Specific examples of an acetal protective group and a ketal protective group for the phenolic hydroxyl group include 1-alkoxyalkyl groups, and examples include a 1-ethoxyethyl group, a 1-methoxyethyl group, a 1-*n*-butoxyethyl group, a 1-isobutoxyethyl group, a 1-(2-chloroethoxy)ethyl group, a 1-(2-ethylhexyloxy)ethyl group, a 1-*n*-propoxyethyl group, a 1-cyclohexyloxyethyl group, a 1-(2-cyclohexylethoxy)ethyl group, and a 1-benzyloxyethyl group. These can be used singly or in combination of two or more kinds.

For the radical polymerizable monomer used to form the monomer unit (a1), a commercially available monomer may be used, or a product synthesized by a known method can also be used. For example, the monomer can be synthesized by allowing a compound having a phenolic hydroxyl group to react with a vinyl ether in the presence of an acid catalyst. The synthesis may be carried out by copolymerizing a monomer having a phenolic hydroxyl group and another monomer in advance, and then allowing the product to react with a vinyl ether in the presence of an acid catalyst.

Preferable specific examples of the monomer unit (a1-2) include the following monomer units, but the present invention is not limited to these examples.

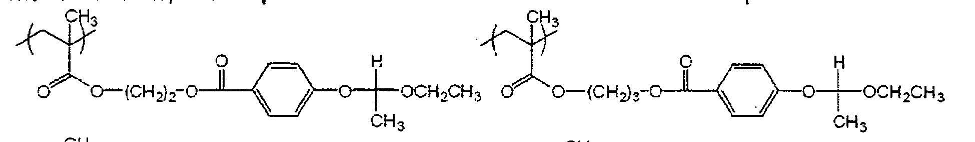

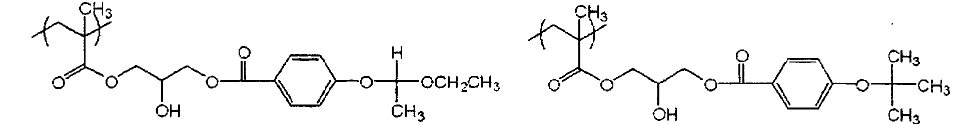

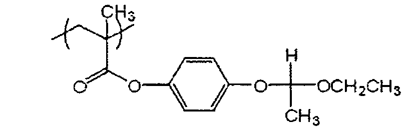

The content of the monomer unit (a1) in Component A is preferably 3 to 70 mol%, more preferably 5 to 60 mol%, and yet more preferably 10 to 50 mol%, based on all the monomer units of Component A. On the other hand, the content of the monomer unit (a1) is preferably 45 mol% or less, in view of deterioration of the profile due to deprotection shrinkage, and is particularly preferably in the range of 10 to 45 mol% in view of a balance between sensitivity and rectangle formability.

### <Monomer unit (a2) having epoxy group and/or oxetanyl group>

Component A has a monomer unit (a2) having an epoxy group and/or an oxetanyl group. Component A may have both of a monomer unit having an epoxy group and a monomer unit having an oxetanyl group.

The group having an epoxy group is not particularly limited as long as it has an epoxy ring, but preferable examples include a glycidyl group, and a 3,4-epoxycyclohexylmethyl group.

The group having an oxetanyl group is not particularly limited as long as it has an oxetane ring, and a preferable example may be a (3-ethyloxetan-3-yl)methyl group.

The monomer unit (a2) may have at least one epoxy group or oxetanyl group in one monomer unit, and may also have one or more epoxy groups and one or more oxetanyl group, two or more epoxy groups, or two or more oxetanyl groups. There are no particular limitations, but the monomer unit (a2) preferably has one to three epoxy groups and/or oxetanyl groups in total, more preferably has one or two epoxy groups and/or oxetanyl groups in total, and yet more preferably has one epoxy group or one oxetanyl group.

Specific examples of the radical polymerizable monomer used to form the monomer unit having an epoxy group include glycidyl acrylate, glycidyl methacrylate, glycidyl α-ethylacrylate, glycidyl α-*n*-propylacrylate, glycidyl α-*n*-butylacrylate, 3,4-epoxybutyl acrylate, 3,4-epoxybutyl methacrylate, 6,7-epoxyheptyl acrylate, 6,7-epoxyheptyl methacrylate, 6,7-epoxyheptyl α-ethylacrylate, *o*-vinylbenzyl glycidyl ether, *m*-vinylbenzyl glycidyl ether, *p*-vinylbenzyl glycidyl ether, and the compound containing an alicyclic epoxy skeleton described in paragraphs 0031 to 0035 of Japanese Patent No. 4168443.

Examples of the radical polymerizable monomer used to form the monomer unit having an oxetanyl group include the (meth)acrylic acid esters having an oxetanyl group described in paragraphs 0011 to 0016 of JP-A-2001-330953.

Preferable examples of the radical polymerizable monomer used to form the monomer unit (a2) include a monomer containing a methacrylic acid ester structure, and a monomer containing an acrylic acid ester structure.

Among these monomers, more preferable examples include glycidyl methacrylate, glycidyl acrylate, a compound containing an alicyclic epoxy skeleton as described in paragraphs 0034 to 0035 of Japanese Patent No. 4168443, and a (meth)acrylic acid ester having an oxetanyl group as described in paragraphs 0011 to 0016 of JP-A-2001-330953.

A particularly preferable example, from the viewpoint of heat resistance and transparency, is a monomer unit derived from any one of (3-ethyloxetan-3-yl)methyl acrylate and (3-ethyloxetan-3-yl)methyl methacrylate.

These monomer units (a2) can be used singly or in combination of two or more kinds.

Specific preferable examples of the monomer unit (a2) include the following monomer units.

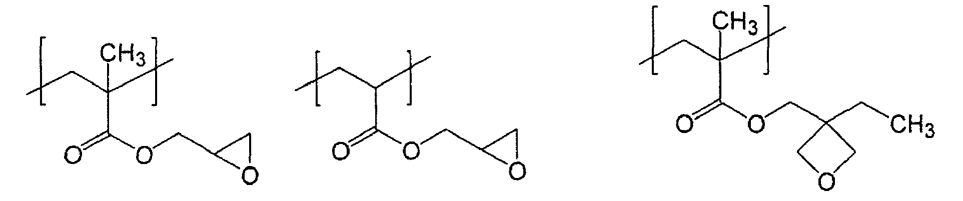

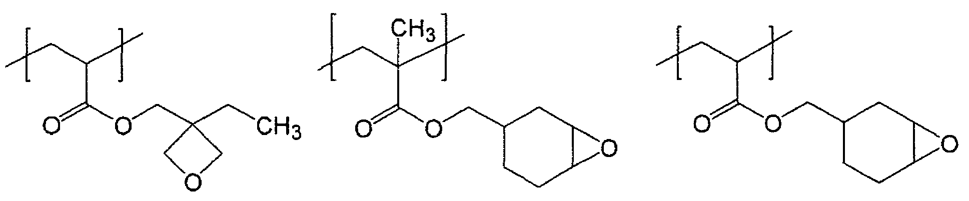

The content of the monomer unit (a2) in Component A is preferably 20 mol% to 55 mol%, more preferably 25 mol% to 55 mol%, and particularly preferably 25 mol% to 50 mol%, based on all the monomer units of Component A. When the monomer unit (a2) is incorporated at the above-described proportion, the properties of the cured film become satisfactory.

### <Monomer unit (a3) having cyclic structure>

Component A preferably contains a monomer unit (a3) having a cyclic structure, from the viewpoint of enhancing dry etching resistance or chemical resistance.

Examples of the monomer forming the monomer unit (a3) include (meth)acrylic acid cyclic alkyl esters such as styrenes, dicyclopentanyl (meth)acrylate, cyclohexyl (meth)acrylate, and cyclohexyl (meth)acrylate; and unsaturated aromatic compounds.

A preferable example of the monomer unit (a3) having a cyclic structure may be a monomer unit represented by the following formula (a3-1) or formula (a3-2). 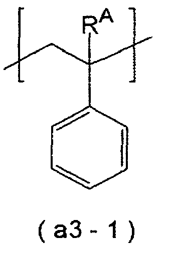 wherein R^{A} represents a hydrogen atom or an alkyl group having 1 to 6 carbon atoms.

R^{A} in the formula (a3-1) is preferably a hydrogen atom or a methyl group, and particularly preferably a hydrogen atom, from the viewpoint of the uniformity of polymerization rate of each monomer at the time of polymerization. 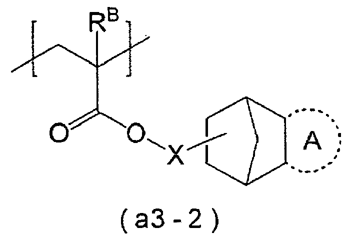 wherein R^{B} represents a hydrogen atom or a methyl group; X represents a single bond or an alkylene group having 1 to 4 carbon atoms; ring A represents a cyclopentane ring or a cyclopentene ring; and the structure may or may not have the ring A.

R^{B} in the formula (a3-2) is preferably a methyl group from the viewpoint of the uniformity of the polymerization rate of each monomer at the time of polymerization.

X in the formula (a3-2) is preferably a single bond, a methylene group or an ethylene group, and more preferably a single bond.

The ring A in the formula (a3-2) is preferably a cyclopentane ring.

It is preferable that the formula (a3-2) have the ring A. The position of the double bond of a cyclopentene ring for the ring A is not particularly limited, and any position may be acceptable.

The content of the monomer unit (a3) in Component A is preferably 1 mol% to 30 mol%, more preferably 5 mol% to 25 mol%, and particularly preferably 10 mol% to 20 mol%, based on all the monomer units of Component A. When the monomer unit (a3) is incorporated at the above-described proportion, the resulting pattern has excellent dry etching resistance and chemical resistance.

### <Monomer unit (a4) having carboxyl group or hydroxyl group>

Component A preferably has a monomer unit (a4) having a carboxyl group or a hydroxyl group, from the viewpoint of developability.

The monomer unit (a4) is preferably introduced to the extent that Component A does not become alkali-soluble. The content of the monomer unit (a4) in Component A is preferably 2 mol% to 20 mol%, more preferably 2 mol% to 15 mol%, and particularly preferably 3 mol% to 15 mol%, based on all the monomer units of Component A. When the monomer unit (a4) is incorporated at the above-described proportion, high sensitivity is obtained, and developability is improved.

### {Monomer unit (a4-1) having carboxyl group}

Examples of the monomer unit (a4-1) having a carboxyl group include monomer units derived from an unsaturated carboxylic acid having at least one carboxyl group in the molecule, such as an unsaturated monocarboxylic acid, unsaturated dicarboxylic acid, and unsaturated tricarboxylic acid.

As the unsaturated carboxylic acid used to obtain the monomer unit (a4-1) having a carboxyl group, the compounds exemplified below are used.

That is, examples of the unsaturated monocarboxylic acid include acrylic acid, methacrylic acid, crotonic acid, α-chloroacrylic acid, and cinnamic acid.

Furthermore, examples of the unsaturated dicarboxylic acid include maleic acid, fumaric acid, itaconic acid, citraconic acid, and mesaconic acid.

The unsaturated polyvalent carboxylic acid used to obtain the monomer unit (a4-1) having a carboxylic acid may be an acid anhydride thereof. Specific examples include maleic anhydride, itaconic anhydride, and citraconic anhydride. Furthermore, the unsaturated polyvalent carboxylic acid may be a mono(2-methacryloyloxyalkyl) ester of a polyvalent carboxylic acid, and for example, mono(2-acryloyloxyethyl) succinate, mono(2-methacryloyloxyethyl) succinate, mono(2-acryloyloxyethyl) phthalate, and mono(2-methacryloyloxyethyl) phthalate.

The unsaturated polyvalent carboxylic acid may also be a mono(meth)acrylate of a dicarboxy polymer having the unsaturated polyvalent carboxylic acid at the two ends, and examples thereof include ω-carboxypolycaprolactone monoacrylate, and ω -carboxypolycaprolactone monomethacrylate.

Furthermore examples of the unsaturated carboxylic acid that can be used include acrylic acid-2-carboxyethyl ester, methacrylic acid-2-carboxylethyl ester, maleic acid monoalkyl ester, fumaric acid monoalkyl ester, and 4-carboxystyrene.

Among them, from the viewpoint of developability, it is preferable to use acrylic acid or methacrylic acid in order to form the monomer unit (a4-1) having a carboxyl group.

The monomer unit (a4-1) having a carboxyl group can also be obtained by allowing a monomer unit (a4-2) having a hydroxyl group that will be described below, to react with an acid anhydride.

Any known acid anhydride can be used, and specific examples thereof include dibasic acid anhydrides such as maleic anhydride, succinic anhydride, itaconic anhydride, phthalic anhydride, tetrahydrophthalic anhydride, hexahydrophthalic anhydride, and chlorendic anhydride; and acid anhydrides such as trimellitic anhydride, pyromellitic anhydride, benzophenone tetracarboxylic acid anhydride, and biphenyl tetracarboxylic acid anhydride. Among these, from the viewpoint of developability, phthalic anhydride, tetrahydrophthalic anhydride, and succinic anhydride are preferable.

### {Monomer unit (a4-2) having hydroxyl group}

An example of the monomer unit (a4-2) having a hydroxyl group may be a monomer unit (a4-2-1) having a phenolic hydroxyl group.

Among monomer units (a4-2) having a hydroxyl group, preferable examples of a radical polymerizable monomer used to form a monomer unit (a4-2-1) having a phenolic hydroxyl group include hydroxystyrenes such as *p*-hydroxystyrene and α -methyl-*p*-hydroxystyrene; the compounds described in paragraphs 0011 to 0016 of JP-A-2008-40183; the 4-hydroxybenzoic acid derivatives described in paragraphs 0007 to 0010 of Japanese Patent No. 2888454; addition reaction products of 4-hydroxybenzoic acid and glycidyl methacrylate; and addition reaction products of 4-hydroxybenzoic acid and glycidyl acrylate.

Among the radical polymerizable monomers used to form the monomer unit (a4-2-1) having a phenolic hydroxyl group, methacrylic acid, acrylic acid; the compounds described in paragraphs 0011 to 0016 of JP-A-2008-40183; the 4-hydroxybenzoic acid derivatives described in paragraphs 0007 to 0010 of Japanese Patent No. 2888454; addition reaction products of 4-hydroxybenzoic acid and glycidyl methacrylate; and addition reaction products of 4-hydroxybenzoic acid and glycidyl acrylate are more preferable. However, from the viewpoint of transparency, methacrylic acid and acrylic acid are particularly preferable. These monomer units can be used singly or in combination of two or more kinds.

Among the monomer units (a4-2) having a hydroxyl group, any monomer unit having a hydroxyl group can be used as the monomer unit (a4-2-2) having a hydroxyl group other than a phenolic hydroxyl group, but preferable examples include monomer units derived from a hydroxyl group-containing (meth)acrylic acid ester, a (meth)acrylic acid ester of an alkyl group-terminated polyalkylene glycol, and a (meth)acrylic acid ester of an aryl group-terminated polyalkylene glycol.

Preferable examples of the hydroxyl group-containing (meth)acrylic acid ester include (meth)acrylic acid hydroxyalkyl esters such as 2-hydroxyethyl acrylate, 2-hydroxypropyl (meth)acrylate, 3-hydroxypropyl (meth)acrylate, 2,3-dihydroxypropyl (meth)acrylate, and 4-hydroxybutyl (meth)acrylate; polyethylene glycol mono(meth)acrylate, polypropylene glycol mono(meth)acrylate, poly(ethylene glycol-propylene glycol) mono(meth)acrylate, polyethylene glycol-polyproylene glycol mono(meth)acrylate, poly(ethylene glycol-tetramethylene glycol) mono(meth)acrylate, poly(propylene glycol-tetramethylene glycol) mono(meth)acrylate, and propylene glycol-polybutylene glycol mono(meth)acrylate.

Preferable examples of the (meth)acrylic acid ester of alkyl group-terminated polyalkylene glycol include methoxypolyethylene glycol (meth)acrylate, octoxypolyethylene glycol polypropylene glycol (meth)acrylate, lauroxypolyethylene glycol (meth)acrylate, and stearoxypolyethylene glycol (meth)acrylate.

Preferable examples of the (meth)acrylic acid ester of aryl group-terminated polyalkylene glycol include phenoxypolyethylene glycol (meth)acrylate, phenoxypolyethylene glycol-polypropylene glycol (meth)acrylate, nonylphenoxy-polyethylene glycol (meth)acrylate, nonylphenoxy-polypropylene glycol (meth)acrylate, and nonylphenoxy-poly(ethylene glycol-propylene glycol) (meth)acrylate.

For the hydroxyl group-containing (meth)acrylic acid ester, alkyl group-terminated polyalkylene glycol (meth)acrylic acid ester, and aryl group-terminated polyalkylene glycol (meth)acrylic acid ester, commercially available products can be used. Representative examples include BLEMMER E, BLEMMER PE-90, BLEMMER PE-200, BLEMMER PE-350, BLEMMER P, BLEMMER PP-1000, BLEMMER PP-500, BLEMMER PP-800, BLEMMER 50 PEP-300, BLEMMER 70 PEP-350 B, BLEMMER 55 PET-800, BLEMMER PPT SERIES, BLEMMER 10 PPB-500 B, BLEMMER AE-90, BLEMMER AE-200, BLEMMER AE-400, BLEMMER AP-150, BLEMMER AP-400, BLEMMER AP-550, BLEMMER PME-100, BLEMMER PME-200, BLEMMER PME-400, BLEMMER PME-1000, BLEMMER 50 POEP-800 B, BLEMMER PLE-200, BLEMMER PSE-400, BLEMMER PSE-1300, BLEMMER PAE-50, BLEMMER PAE-100, BLEMMER 43 PAPE-600 B, BLEMMER AME-400, BLEMMER ALE series, BLEMMER ANP-300, BLEMMER 75 ANP-600, BLEMMER AAE-50, and BLEMMER AAE-300 (all manufactured by NOF Corp.).

The number of hydroxyl groups in the monomer unit (a4-2) is preferably 1 to 10, more preferably 1 to 5, and particularly preferably 1 to 3.

Furthermore, when the monomer unit (a4-2) has an alkyleneoxy group, the number of repeating units in the alkyleneoxy group is preferably 1 to 25, more preferably 1 to 15, and most preferably 1 to 10.

Specific preferable examples of the radical polymerizable monomer used to form the monomer unit (a4-2) include 2-hydroxyethyl (meth)acrylate, 2-hydroxypropyl (meth)acrylate, 3-hydroxypropyl (meth)acrylate, 2,3-dihydroxypropyl (meth)acrylate, methoxypolyethylene glycol (meth)acrylate having 2 to 10 ethylene glycol repeating units, methoxypolypropylene glycol (meth)acrylate having 2 to 10 propylene glycol repeating units, methoxypolyethylene glycol-polypropylene glycol (meth)acrylate having 2 to 10 ethylene glycol repeating units and polypropylene glycol repeating units in total, octoxypolyethylene glycol polypropylene glycol (meth)acrylate having 2 to 10 ethylene glycol repeating units and propylene glycol repeating units in total, polyethylene glycol mono(meth)acrylate having 2 to 10 ethylene glycol repeating units, polypropylene glycol mono(meth)acrylate having 2 to 10 propylene glycol repeating units, poly(ethylene glycol-propylene glycol) mono(meth)acrylate having 3 to 10 ethylene glycol repeating units and propylene glycol repeating units in total and polyethylene glycol-polypropylene glycol) mono(meth)acrylate having 3 to 10 ethylene glycol repeating units and propylene glycol repeating units in total.

Among these, 2-hydroxyethyl (meth)acrylate, 2-hydroxypropyl (meth)acrylate, 3-hydroxypropyl (meth)acrylate, 2,3-dihydroxypropyl (meth)acrylate, methoxypolyethylene glycol (meth)acrylate having 2 to 10 ethylene glycol repeating units, and octoxypolyethylene glycol polypropylene glycol (meth)acrylate having 2 to 10 ethylene glycol repeating units and propylene glycol repeating units in total, are more preferable, and methoxypolyethylene glycol (meth)acrylate having 2 to 10 ethylene glycol repeating units, and 2-hydroxyethyl (meth)acrylate are particularly preferable.

The monomer unit (a4) can be used singly or in combination of two or more kinds.

The content of the monomer unit (a4) in Component A is preferably 0.5 mol% to 30 mol%, more preferably 0.5 mol% to 25 mol%, and particularly preferably 1 mol% to 25 mol%, based on all the monomer units of Component A.

Furthermore, the content of the monomer unit (a4) in Component A is preferably 3 wt% to 30 wt%, more preferably 3 wt% to 25 wt%, and particularly preferably 5 wt% to 25 wt%, based on the total weight of Component A. When the monomer unit (a4) is incorporated at the above-described proportion, developability is improved, and a photosensitive composition having high sensitivity can be obtained. Particularly, when the monomer unit (a2) described above and the monomer unit (a4) are combined, a photosensitive resin composition having very high sensitivity can be obtained.

### <Other monomer unit (a5)>

Component A may include a monomer unit (a5) other than the monomer units (a1) to (a4), to the extent that the effect of the present invention is not impaired.

Examples of the radical polymerizable monomer used to form the monomer unit (a5) include the compounds described in paragraphs 0021 to 0024 of JP-A-2004-264623 (provided that the monomers forming the monomer units (a1) to (a4) are excluded).

Component A may have only one kind of the monomer unit (a5), or may have two or more kinds of the monomer unit (a5).

The content of the monomer unit (a5) in Component A is preferably 0 mol% to 40 mol% based on all the monomer units of Component A.

When Component A includes the monomer unit (a5), the content of the monomer unit (a5) in Component A is preferably 1 mol% to 40 mol%, more preferably 5 mol% to 30 mol%, and particularly preferably 5 mol% to 25 mol%, based on all the monomer units of Component A.

The weight average molecular weight according to the present invention is a weight average molecular weight measured by gel permeation chromatography (GPC) and calculated relative to polystyrene standards.

The method of introducing the various monomer units of Component A may be a polymerization method or may be a polymer reaction method.

In a polymerization method, monomers containing predetermined functional groups are synthesized in advance, and then these monomers are copolymerized. That is, Component A can be synthesized by polymerizing a radical polymerization monomer mixture including the radical polymerizable monomers used to form the monomer unit (a1), monomer unit (a2), monomer unit (a3), monomer unit (a4), and if necessary, the monomer unit (a5), in an organic solvent using a radical polymerization initiator.

In a polymer reaction method, after a polymerization reaction is carried out, necessary functional groups are introduced into the monomer units using the reactive groups contained in the monomer units of the copolymer thus obtained.

The introduction of the monomer units (a1 to (a5) into Component A may be carried out by the polymerization method or by the polymer reaction method, and these two methods may also be used in combination.

Component A can be used singly or in combination of two or more kinds, in the photosensitive resin composition of the present invention.

The content of Component A in the photosensitive resin composition of the present invention is preferably 20 wt% to 99 wt%, more preferably 40 wt% to 97 wt%, and yet more preferably 60 wt% to 95 wt%, based on the total solids content of the photosensitive resin composition. When the content is in this range, pattern formability is improved when the pattern is developed. The solids content of the photosensitive resin composition herein means the amount of Components excluding volatile Components such as solvent.

Furthermore, in the photosensitive resin composition of the present invention, a resin other than Component A may be used in combination to the extent that the effect of the present invention is not impaired. However, the content of the resin other than Component A is preferably smaller than the content of Component A from the viewpoint of developability.

### (Component B) Photo acid generator

The photosensitive resin composition of the present invention contains (Component B) a photo acid generator.

Component B is preferably a compound which generates an acid in response to an active radiation having a wavelength of 300 nm or greater, and preferably a wavelength of 300 to 450 nm, but there are no limitations on the chemical structure. Furthermore, even in the case of a photo acid generator which does not directly respond to an active radiation having a wavelength of 300 nm or greater, a compound which generates an acid in response to an active radiation having a wavelength of 300 nm or greater when used together with a sensitizer, can be preferably used in combination with a sensitizer.

Component B is preferably a photo acid generator which generates an acid having a pKa of 4 or lower, and more preferably a photo acid generator which generates an acid having a pKa of 3 or lower.

Examples of the photo acid generator include trichloromethyl-s-triazines, sulfonium salts or iodonium salts, quaternary ammonium salts, diazomethane compounds, imidosulfonate compounds, and oxime sulfonate compounds. Among these, it is preferable to use oxime sulfonate compounds from the viewpoint of having high sensitivity. These photo acid generators can be used singly or in combination of two or more kinds.

Specific examples thereof include the following compounds.

As trichloromethyl-*s*-triazines, 2-(3-chlorophenyl)bis(4,6-trichloromethyl)-*s*-triazine, 2-(4-methoxyphenyl)bis(4,6-trichloromethyl)-*s*-triazine, 2-(4-methylthiophenyl)bis(4,6-trichloromethyl)-*s*-triazine, 2-(4-methoxy-β-styryl)bis(4,6-trichloromethyl)-*s*-triazine, 2-piperonylbis(4,6-trichloromethyl)-*s*-triazine, 2-[2-(furan-2-yl)ethenyl]bis(4,6-trichloromethyl)-s-triazine, 2-[2-(5-methylfuran-2-yl)ethenyl]bis(4,6-trichloromethyl)-s-triazine, 2-[2-(4-diethylamino-2-methylphenyl)ethenyl]bis(4,6-trichloromethyl)-s-triazine, and 2-(4-methoxynaphthyl)bis(4,6-trichloromethyl)-s-triazine;
as diaryliodonium salts, diphenyliodonium trifluoroacetate, diphenyliodonium trifluoromethanesulfonate, 4-methoxyphenylphenyliodonium trifluoromethanesulfonate, 4-methoxyphenylphenyliodonium trifluoroacetate, phenyl-4-(2'-hydroxy-1'-tetradecaoxy)phenyliodonium trifluoromethanesulfonate, 4-(2'-hydroxy-1'-tetradecaoxy)phenyliodonium hexafluoroantimonate, and phenyl-4-(2'-hydroxy-1'-tetradecaoxy)phenyliodonium *p*-toluenesulfonate;
as triarylsulfonium salts, triphenylsulfonium trifluoromethanesulfonate, triphenylsulfonium trifluoroacetate, 4-methoxyphenyldiphenylsulfonium trifluoromethanesulfonate, 4-methoxyphenyldiphenylsulfonium trifluoroacetate, 4-phenylthiophenyldiphenylsulfonium trifluoromethanesulfonate, and 4-phenylthiophenyldiphenylsulfonium trifluoroacetate;
as quaternary ammonium salts, tetramethylammonium butyltrsi(2,6-difluorophenyl)borate, tetramethylammonium hexyltris(*p*-chlorophenyl)borate, tetramethylammonium hexyltris(3-trifluoromethylphenyl)borate, benzyldimethylphenylammonium butyltris(2,6-difluorophenyl)borate, benzyldimethylphenylammonium hexyltris(*p*-chlorophenyl)borate, and benzyldimethylphenylammonium hexyltris(3-trifluoromethylphenyl)borate;
as diazomethane derivatives, bis(cyclohexylsulfonyl)diazomethane, bis(t-butylsulfonyl)diazomethane, and bis(*p*-toluenesulfonyl)diazomethane; and
as imidosulfonate derivatives, trifluoromethylsulfonyloxybicyclo[2.2.1]hept-5-enedicarboxylimide, succinimidotrifluoromethyl sulfonate, phthalimidotrifluoromethyl sulfonate, *N*-hydroxynaphthalimidomethane sulfonate, and *N*-hydroxy-5-norbornene-2,3-dicarboxylimidopropane sulfonate.

The photosensitive resin composition of the present invention preferably contains, as (Component B) photo acid generator, an oxime sulfonate compound having at least one oxime sulfonate residue represented by the following formula (1). Meanwhile, the wavy line represents the position of bonding to another chemical structure.

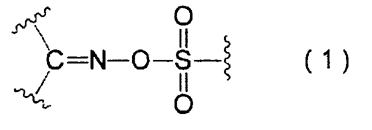

The oxime sulfonate compound having at least one oxime sulfonate residue represented by the above formula (1) is preferably a compound represented by the following formula (2).

R^{1A}-C(R^{2A})=N-O-SO₂-R^{3A} (2)

In the formula (2), R^{1A} represents an alkyl group having 1 to 6 carbon atoms, a halogenated alkyl group having 1 to 4 carbon atoms, a phenyl group, a biphenyl group, a naphthyl group, a 2-furyl group, a 2-thienyl group, an alkoxy group having 1 to 4 carbon atoms, or a cyano group. When R^{1A} is a phenyl group, a biphenyl group, a naphthyl group or an anthranyl group, these groups may be substituted with a substituent selected from the group consisting of a halogen atom, a hydroxyl group, an alkyl group having 1 to 4 carbon atoms, an alkoxy group having 1 to 4 carbon atoms, and a nitro group.

In the formula (2), R^{2A} represents an alkyl group having 1 to 10 carbon atoms, an alkoxy group having 1 to 10 carbon atoms, a halogenated alkyl group having 1 to 5 carbon atoms, a halogenated alkoxy group having 1 to 5 carbon atoms, a phenyl group which may be substituted with W, a naphthyl group which may be substituted with W, or an anthranyl group which may be substituted with W, a dialkylamino group, a morpholino group, or a cyano group. R^{2A} and R^{1A} may be joined together to form a 5-membered ring or a 6-membered ring, and the 5-membered ring or the 6-membered ring may be bonded to a benzene ring which may be substituted with any one or two substituents.

In the formula (2), R^{3A} represents an alkyl group having 1 to 10 carbon atoms, an alkoxy group having 1 to 10 carbon atoms, a halogenated alkyl group having 1 to 5 carbon atoms, a halogenated alkoxy group having 1 to 5 carbon atoms, a phenyl group which may be substituted with W, a naphthyl group which may be substituted with W, or an anthranyl group which may be substituted with W. W represents a halogen atom, a cyano group, a nitro group, an alkyl group having 1 to 10 carbon atoms, an alkoxy group having 1 to 10 carbon atoms, a halogenated alkyl group having 1 to 5 carbon atoms, or a halogenated alkoxy group having 1 to 5 carbon atoms.

The alkyl group having 1 to 6 carbon atoms represented by R^{1A} may be a linear or branched alkyl group, and examples include a methyl group, an ethyl group, a propyl group, an isopropyl group, a *n*-butyl group, a sec-butyl group, a *tert*-butyl group, a *n*-pentyl group, an isoamyl group, a *n*-hexyl group, and a 2-ethylbutyl group.

Examples of the halogenated alkyl group having 1 to 4 carbon atoms represented by R^{1A} include a chloromethyl group, a trichloromethyl group, a trifluoromethyl group, and a 2-bromopropyl group.

Examples of the alkoxy group having 1 to 4 carbon atoms represented by R^{1A} include a methoxy group and an ethoxy group.

When R^{1A} represents a phenyl group, a biphenyl group, a naphthyl group or an anthranyl group, these groups may be substituted with a substituent selected from the group consisting of a halogen atom (for example, a chlorine atom, a bromine atom, or an iodine atom), a hydroxyl group, an alkyl group having 1 to 4 carbon atoms (for example, a methyl group, an ethyl group, a propyl group, an isopropyl group, a *n*-butyl group, a *sec*-butyl group, or a *tert*-butyl group), an alkoxy group having 1 to 4 carbon atoms (for example, a methoxy group, an ethoxy group, a *n*-propoxy group, an *i*-propoxy group, or a *n*-butoxy group), and a nitro group.

Specific examples of the alkyl group having 1 to 10 carbon atoms represented by R^{2A} include a methyl group, an ethyl group, a *n*-propyl group, an *i*-propyl group, a *n*-butyl group, an *i*-butyl group, a s-butyl group, a *t*-butyl group, a *n*-amyl group, an *i*-amyl group, a *s*-amyl group, a *n*-hexyl group, a *n*-heptyl group, a *n*-octyl group, a *n*-nonyl group, and a *n*-decyl group.

Specific examples of the alkoxy group having 1 to 10 carbon atoms represented by R^{2A} include a methoxy group, an ethoxy group, a *n*-propoxy group, an *i*-propoxy group, a *n*-butoxy group, a *n*-amyloxy group, a *n*-octyloxy group, and a *n*-decyloxy group.

Specific examples of the halogenated alkyl group having 1 to 5 carbon atoms represented by R^{2A} include a trifluoromethyl group, a pentafluoroethyl group, a perfluoro-*n*-propyl group, a perfluoro-*n*-butyl group, and a perfluoro-*n*-amyl group.

Specific examples of the halogenated alkoxy group having 1 to 5 carbon atoms represented by R^{2A} include a trifluoromethoxy group, a pentafluoroethoxy group, a perfluoro-n-propoxy group, a perfluoro-n-butoxy group, and a perfluoro-n-amyloxy group.

Specific examples of the phenyl group which may be substituted with W, as represented by R^{2A}, include an *o*-tolyl group, a *m*-tolyl group, a *p*-tolyl group, an *o*-ethylphenyl group, a *m*-ethylphenyl group, a *p*-ethylphenyl group, a *p*-(*n*-propyl)phenyl group, a *p*-(i-propyl)phenyl group, a *p*-(n-butyl)phenyl group, a *p*-(*i*-butyl)phenyl group, a *p*-(*s*-butyl)phenyl group, a *p*-(*t*-butyl)phenyl group, a *p*-(*n*-amyl)phenyl group, a *p*-(*i*-amyl)phenyl group, a *p*-(*t*-amyl)phenyl group, an *o*-methoxyphenyl group, a *m*-methoxyphenyl group, a *p*-methoxyphenyl group, an *o*-ethoxyphenyl group, a *m*-ethoxyphenyl group, a *p*-ethoxyphenyl group, a *p*-(*n*-propoxy)phenyl group, a *p*-(*i*-propoxy)phenyl group, a *p*-(*n*-butoxy)phenyl group, a *p*-(*i*-butoxy)phenyl group, a *p*-(s-butoxy)phenyl group, a *p*-(*t*-butoxy)phenyl group, a *p*-(*n*-amyloxy)phenyl group, a *p*-(*i*-amyloxy)phenyl group, a *p*-(*t*-amyloxy)phenyl group, a *p*-chlorophenyl group, a *p*-bromophenyl group, a *p*-fluorophenyl group, a 2,4-dichlorophenyl group, a 2,4-dibromophenyl group, a 2,4-difluorophenyl group, a 2,4,6-dichlorophenyl group, a 2,4,6-tribromophenyl group, a 2,4,6-trifluorophenyl group, a pentachlorophenyl group, a pentabromophenyl group, a pentafluorophenyl group, and a p-biphenylyl group.

Specific examples of the naphthyl group which may be substituted with W, as represented by R^{2A}, include a 2-methyl-1-naphthyl group, a 3-methyl-1-naphthyl group, a 4-methyl-1-naphthyl group, a 5-methyl-1-naphthyl group, a 6-methyl-1-naphthyl group, a 7-methyl-1-naphthyl group, an 8-methyl-1-naphthyl group, a 1-methyl-2-naphthyl group, a 3-methyl-2-naphthyl group, a 4-methyl-2-naphthyl group, a 5-methyl-2-naphthyl group, a 6-methyl-2-naphthyl group, a 7-methyl-2-naphthyl group, and an 8-methyl-2-naphthyl group.

Specific examples of the anthranyl group which may be substituted with W, as represented by R^{2A}, include a 2-methyl-1-anthranyl group, a 3-methyl-1-anthranyl group, a 4-methyl-1-anthranyl group, a 5-methyl-1-anthranyl group, a 6-methyl-1-anthranyl group, a 7-methyl-1-anthranyl group, an 8-methyl-1-anthranyl group, a 9-methyl-1-anthranyl group, a 10-methyl-1-anthranyl group, a 1-methyl-2-anthranyl group, a 8-methyl-2-anthranyl group, a 4-methyl-2-anthranyl group, a 5-methyl-2-anthranyl group, a 6-methyl-2-anthranyl group, a 7-methyl-2-anthranyl group, an 8-methyl-2-anthranyl group, a 9-methyl-2-anthranyl group, and a 10-methyl-2-anthranyl group.

Examples of the dialkylamino group represented by R^{2A} include a dimethylamino group, a diethylamino group, a dipropylamino group, a dibutylamino group, and a diphenylamino group.

Specific examples of the alkyl group having 1 to 10 carbon atoms represented by R^{3A} include a methyl group, an ethyl group, a *n*-propyl group, an *i*-propyl group, a *n*-butyl group, an *i*-butyl group, a *s*-butyl group, a *t*-butyl group, a *n*-amyl group, an *i*-amyl group, a *s*-amyl group, a *n*-hexyl group, a *n*-heptyl group, a *n*-octyl group, a *n*-nonyl group, and a *n*-decyl group.

Specific examples of the alkoxy group having 1 to 10 carbon atoms represented by R^{3A} include a methoxy group, an ethoxy group, a *n*-propoxy group, an *i*-propoxy group, a *n*-butoxy group, a *n*-amyloxy group, a *n*-octyloxy group, and a *n*-decyloxy group.

Specific examples of the halogenated alkyl group having 1 to 5 carbon atoms represented by R^{3A} include a trifluoromethyl group, a pentafluoroethyl group, a perfluoro-*n*-propyl group, a perfluoro-*n*-butyl group, and a perfluoro-*n*-amyl group.

Specific examples of the halogenated alkoxy group having 1 to 5 carbon atoms represented by R^{3A} include a trifluoromethoxy group, a pentafluoroethoxy group, a perfluoro-*n*-propoxy group, a perfluoro-*n*-butoxy group, and a perfluoro-*n*-amyloxy group.

Specific examples of the phenyl group which may be substituted with W, as represented by R^{3A}, include an *o*-tolyl group, a *m*-tolyl group, a *p*-tolyl group, an *o*-ethylphenyl group, a *m*-ethylphenyl group, a *p*-ethylphenyl group, a *p*-(n-propyl)phenyl group, a *p*-(*i*-propyl)phenyl group, a *p*-(*n*-butyl)phenyl group, a *p*-(*i*-butyl)phenyl group, a *p*-(*s*-butyl)phenyl group, a *p*-(*t*-butyl)phenyl group, a *p*-(*n*-amyl)phenyl group, a *p*-(*i*-amyl)phenyl group, a *p*-(*t*-amyl)phenyl group, an *o*-methoxyphenyl group, a *m*-methoxyphenyl group, a *p*-methoxyphenyl group, an *o*-ethoxyphenyl group, a *m*-ethoxyphenyl group, a *p*-ethoxyphenyl group, a *p*-(*n*-propoxy)phenyl group, a *p*-(*i*-propoxy)phenyl group, a *p*-(*n*-butoxy)phenyl group, a *p*-(*i*-butoxy)phenyl group, a *p*-(*s*-butoxy)phenyl group, a *p*-(*t*-butoxy)phenyl group, a *p*-(*n*-amyloxy)phenyl group, a *p*-(*i*-amyloxy)phenyl group, a *p*-(*t*-amyloxy)phenyl group, a *p*-chlorophenyl group, a *p*-bromophenyl group, a *p*-fluorophenyl group, a 2,4-dichlorophenyl group, a 2,4-dibromophenyl group, a 2,4-difluorophenyl group, a 2,4,6-dichlorophenyl group, a 2,4,6-tribromophenyl group, a 2,4,6-trifluorophenyl group, a pentachlorophenyl group, a pentabromophenyl group, a pentafluorophenyl group, and a p-biphenylyl group.

Specific examples of the naphthyl group which may be substituted with W, as represented by R^{3A}, include a 2-methyl-1-naphthyl group, a 3-methyl-1-naphthyl group, a 4-methyl-1-naphthyl group, a 5-methyl-1-naphthyl group, a 6-methyl-1-naphthyl group, a 7-methyl-1-naphthyl group, an 8-methyl-1-naphthyl group, a 1-methyl-2-naphthyl group, a 3-methyl-2-naphthyl group, a 4-methyl-2-naphthyl group, a 5-methyl-2-naphthyl group, a 6-methyl-2-naphthyl group, a 7-methyl-2-naphthyl group, and an 8-methyl-2-naphthyl group.

Specific examples of the anthranyl group which may be substituted with W, as represented by R^{3A}, include a 2-methyl-1-anthranyl group, a 3-methyl-1-anthranyl group, a 4-methyl-1-anthranyl group, a 5-methyl-1-anthranyl group, a 6-methyl-1-anthranyl group, a 7-methyl-1-anthranyl group, an 8-methyl-1-anthranyl group, a 9-methyl-1-anthranyl group, a 10-methyl-1-anthranyl group, a 1-methyl-2-anthranyl group, a 3-methyl-2-anthranyl group, a 4-methyl-2-anthranyl group, a 5-methyl-2-anthranyl group, a 6-methyl-2-anthranyl group, a 7-methyl-2-anthranyl group, an 8-methyl-2-anthranyl group, a 9-methyl-2-anthranyl group, and a 10-methyl-2-anthranyl group.

Specific examples of the alkyl group having 1 to 10 carbon atoms, the alkoxy group having 1 to 10 carbon atoms, the halogenated alkyl group having 1 to 5 carbon atoms, and the halogenated alkoxy group having 1 to 5 carbon atoms, which are represented by W, include the same groups mentioned as specific examples of the alkyl group having 1 to 10 carbon atoms, the alkoxy group having 1 to 10 carbon atoms, the halogenated alkyl group having 1 to 5 carbon atoms, and the halogenated alkoxy group having 1 to 5 carbon atoms, which are represented by R^{2A} or R^{3A}.

R^{2A} and R^{1A} may be joined together to form a 5-membered ring or a 6-membered ring.

When R^{2A} and R^{1A} are joined together to form a 5-membered ring or a 6-membered ring, the 5-membered ring or the 6-membered ring may be a carbocyclic group or a heterocyclic group, and examples thereof include cyclopentane, cyclohexane, cycloheptane, pyrrole, furane, thiophene, imidazole, oxazole, thiazole, pyrane, pyridine, pyrazine, morpholine, piperidine, and piperazine rings. The 5-membered ring or 6-memebred ring may be bonded to a benzene ring which may be arbitrarily substituted, and examples thereof include tetrahydronaphthalene, dihydroanthracene, indene, chromane, fluorene, xanthene, and thioxanthene rings. The 5-membered ring or 6-membered ring may contain a carboxyl group, and examples thereof include cyclohexadienone, naphthalenone, and anthrone rings.

One of suitable embodiments of the compound represented by the formula (2) is a compound represented by the following formula (2-1). The compound represented by the formula (2-1) is a compound in which R^{2A} and R^{1A} in the formula (2) are joined to form a 5-membered ring. 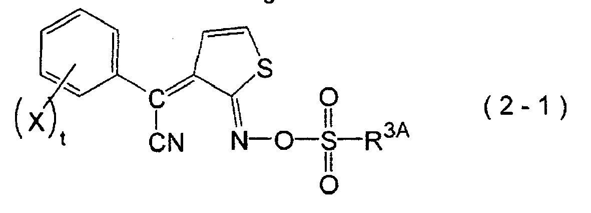 wherein R^{3A} has the same meaning as R^{3A} in the formula (2); X represents an alkyl group, an alkoxy group or a halogen atom; t represents an integer from 0 to 3, and when t is 2 or 3, plural X's may be identical or different.

The alkyl group represented by X is preferably a linear or branched alkyl group having 1 to 4 carbon atoms.

The alkoxy group represented by X is preferably a linear or branched alkoxy group having 1 to 4 carbon atoms.

The halogen atom represented by X is preferably a chlorine atom or a fluorine atom.

t is preferably 0 or 1.

A compound in which, in the formula (2-1), t is 1; X is a methyl group; the substitution position of X is the ortho-position; R^{3A} is a linear alkyl group having 1 to 10 carbon atoms, a 7,7-dimethyl-2-oxonorbornylmethyl group or a p-toluyl group, is particularly preferable.

Specific examples of the oxime sulfonate compound represented by the formula (2-1) include the following compound (i), compound (ii), compound (iii), compound (iv), and the like. These compounds may be used singly, or two or more kinds may be used in combination. The compounds (i) to (iv) are available as commercial products.

Furthermore, the oxime sulfonate compound can also be used in combination with a photo acid generator of different type.

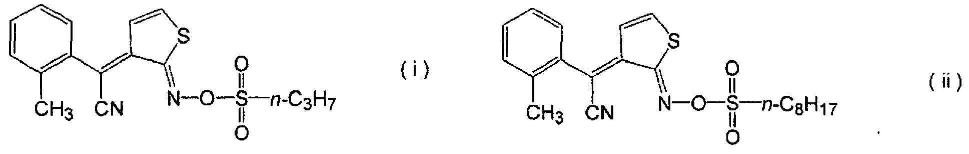

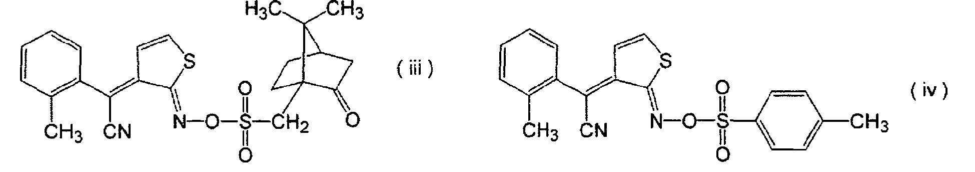

According to one preferable embodiment of the compound represented by the formula (2),

R^{1A} represents an alkyl group having 1 to 4 carbon atoms, a trifluoromethyl group, a phenyl group, a chlorophenyl group, a dichlorophenyl group, a methoxyphenyl group, a 4-biphenyl group, a naphthyl group, or an anthranyl group;

R^{2A} represents a cyano group; and

R^{3A} represents an alkyl group having 1 to 10 carbon atoms, an alkoxy group having 1 to 10 carbon atoms, a halogenated alkyl group having 1 to 5 carbon atoms, a halogenated alkoxy group having 1 to 5 carbon atoms, a phenyl group which may be substituted with W, a naphthyl group which may be substituted with W, or an anthranyl group which may be substituted with W, while W represents a halogen atom, a cyano group, a nitro group, an alkyl group having 1 to 10 carbon atoms, an alkoxy group having 1 to 10 carbon atoms, a halogenated alkyl group having 1 to 5 carbon atoms, or a halogenated alkoxy group having 1 to 5 carbon atoms.

The compound represented by the formula (2) may be preferably a compound represented by the following formula (2-2).

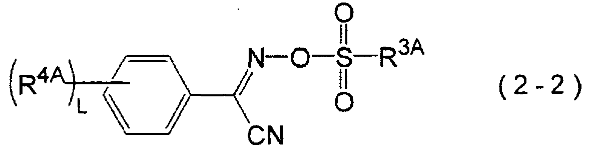

In the formula (2-2), R^{4A} represents a halogen atom, a hydroxyl group, an alkyl group having 1 to 4 carbon atoms, an alkoxy group having 1 to 4 carbon atoms, or a nitro group; and L represents an integer from 0 to 5. R^{3A} represents an alkyl group having 1 to 10 carbon atoms, an alkoxy group having 1 to 10 carbon atoms, a halogenated alkyl group having 1 to 5 carbon atoms, a halogenated alkoxy group having 1 to 5 carbon atoms, a phenyl group which may be substituted with W, a naphthyl group which may be substituted with W, or an anthranyl group which may be substituted with W; and W represents a halogen atom, a cyano group, a nitro group, an alkyl group having 1 to 10 carbon atoms, an alkoxy group having 1 to 10 carbon atoms, a halogenated alkyl group having 1 to 5 carbon atoms, or a halogenated alkoxy group having 1 to 5 carbon atoms.

R^{3A} in the formula (2-2) is preferably a methyl group, an ethyl group, a *n*-propyl group, a *n*-butyl group, a *n*-octyl group, a trifluoromethyl group, a pentafluoroethyl group, a perfluoro-*n*-propyl group, a perfluoro-*n*-butyl group, a *p*-tolyl group, a 4-chlorophenyl group, or a pentafluorophenyl group, and particularly preferably a methyl group, an ethyl group, a *n*-propyl group, a *n*-butyl group or a *p*-tolyl group.

The halogen atom represented by R^{4A} is preferably a fluorine atom, a chlorine atom, or a bromine atom.

The alkyl group having 1 to 4 carbon atoms represented by R^{4A} is preferably a methyl group or an ethyl group.

The alkoxy group having 1 to 4 carbon atoms represented by R^{4A} is preferably a methoxy group or an ethoxy group.

L is preferably 0 to 2, and particularly preferably 0 to 1.

Among the compounds represented by the formula (2), a preferable embodiment of the compound included in the compounds represented by the formula (2-2) is a compound in which, in the formula (2), R^{1A} represents a phenyl group or a 4-methoxyphenyl group; R^{2A} represents a cyano group; and R^{3A} represents a methyl group, an ethyl group, a *n*-propyl group, a *n*-butyl group, or a 4-tolyl group.

Particularly preferable examples of the compound included in the compounds represented by the formula (2-2) among the compounds represented by the formula (2) will be shown below, but the present invention is not intended to be limited to these.

α-(methylsulfonyloxyimino)benzylcyanide (R^{1A} = phenyl group, R^{2A} = cyano group, R^{3A} = methyl group)

α-(ethylsulfonyloxyimino)benzylcyanide (R^{1A} = phenyl group, R^{2A} = cyano group, R^{3A} = ethyl group)

α-(*n*-propylsulfonyloxyimino)benzylcyanide (R^{1A} = phenyl group, R^{2A} = cyano group, R^{3A} = *n*-propyl group)

α-(*n*-butylsulfonyloxyimino)benzylcyanide (R^{1A} = phenyl group, R^{2A} = cyano group, R^{3A} = *n*-butyl group)

α-(4-toluenesulfonyloxyimino)benzylcyanide (R^{1A} = phenyl group, R^{2A} = cyano group, R^{3A} = 4-tolyl group)

α-[(methylsulfonyloxyimino)-4-methoxyphenyl]acetonitrile (R^{1A} = 4-methoxyphenyl group, R^{2A} = cyano group, R^{3A} = methyl group)

α-[(ethylsulfonyloxyimino)-4-methoxyphenyl]acetonitrile (R^{1A} = 4-methoxyphenyl group, R^{2A} = cyano group, R^{3A} = ethyl group)

α-[(*n*-propylsulfonyloxyimino)-4-methoxyphenyl]acetonitrile (R^{1A} = 4-methoxyphenyl group, R^{2A} = cyano group, R^{3A} = *n*-propyl group)

α-[(*n*-butylsulfonyloxyimino)-4-methoxyphenyl]acetonitrile (R^{1A} = 4-methoxyphenyl group, R^{2A} = cyano group, R^{3A} = *n*-butyl group)

α-[(4-toluenesulfonyloxyimino)-4-methoxyphenyl]acetonitrile (R^{1A} = 4-methoxyphenyl group, R^{2A} = cyano group, R^{3A} = 4-tolyl group)

The compound having at least one oxime sulfonate residue, as represented by the formula (1), is preferably an oxime sulfonate compound represented by the following formula (OS-3), formula (OS-4) or formula (OS-5). 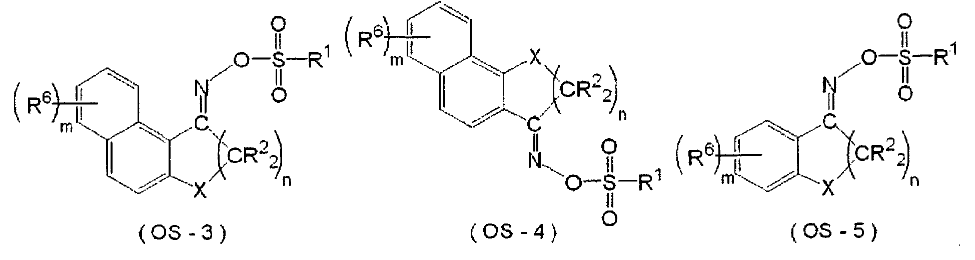 wherein R¹ represents an alky group, an aryl group or a heteroaryl group; plural R²'s each independently represent a hydrogen atom, an alkyl group, an aryl group, or a halogen atom; plural R⁶'s each independently represent a halogen atom, an alkyl group, an alkyloxy group, a sulfonic acid group, an aminosulfonyl group, or an alkoxysulfonyl group; X represents O or S; n represents an integer of 1 or 2; and m represents an integer from 0 to 6.

The alkyl group, aryl group or heteroaryl group represented by R¹ in the formulae (OS-3) to (OS-5) may be substituted.

The alkyl group represented by R¹ in the formulae (OS-3) to (OS-5) is preferably an alkyl group having 1 to 30 carbon atoms in total, which may be substituted.

The aryl group represented by R¹ in the formulae (OS-3) to (OS-5) is preferably an aryl group having 6 to 30 carbon atoms, which may be substituted.

The heteroaryl group represented by R¹ in the formulae (OS-3) to (OS-5) is preferably a heteroaryl group having 4 to 30 carbon atoms, which may be substituted, and may have at least one heteroaromatic ring. For example, a heteroaromatic ring and a benzene ring may be fused.

Examples of the substituent which may be carried by the alkyl group, aryl group or heteroaryl group represented by R¹, include a halogen atom, an alkyloxy group, an aryloxy group, an alkylthio group, an arylthio group, an alkyloxycarbonyl group, an aryloxycarbonyl group, and an aminocarbonyl group.

In the formulae (OS-3) to (OS-5), R² is preferably a hydrogen atom, an alkyl group, or an aryl group, and more preferably a hydrogen atom, or an alkyl group.

In the formulae (OS-3) to (OS-5), among two or more R²'s present in the compound, it is preferable that one or two be an alkyl group, an aryl group or a halogen atom, and it is more preferable that one be an alkyl group, an aryl group, or a halogen atom. It is particularly preferable that one be an alkyl group, and the other be a hydrogen atom.

In the formulae (OS-3) to (OS-5), the alkyl group or aryl group represented by R² may be substituted with a substituent.

Examples of the substituent which may be carried by the alkyl group or aryl group represented by R² may be the same groups as the substituents which may be carried by the alkyl group or aryl group for R¹.

The alkyl group represented by R² in the formulae (OS-3) to (OS-5) is preferably an alkyl group having 1 to 12 carbon atoms in total, which may be substituted, and more preferably an alky group having 1 to 6 carbon atoms, which may be substituted.

The alkyl group represented by R² is preferably a methyl group, an ethyl group, a *n*-propyl group, a *n*-butyl group, or a *n*-hexyl group, and more preferably a methyl group.

In the formulae (OS-3) to (OS-5), the aryl group represented by R² is preferably an aryl group having 6 to 30 carbon atoms, which may be substituted.

The aryl group represented by R² is preferably a phenyl group, a *p*-methylphenyl group, an *o*-chlorophenyl group, a *p*-chlorophenyl group, an *o*-methoxyphenyl group, or a *p*-phenoxyphenyl group.

In the formulae (OS-3) to (OS-5), X represents O or S, and is preferably O.

in the formulae (OS-3) to (OS-5), the ring containing X as a ring member is a 5-membered ring or a 6-membered ring.

In the formulae (OS-3) to (OS-5), n represents 1 or 2, and when X is O, n is preferably 1, while when X is S, n is preferably 2.

In the formulae (OS-3) to (OS-5), the alkyl group and alkyloxy group represented by R⁶ may be substituted.

In the formulae (OS-3) to (OS-5), the alkyl group represented by R⁶ is preferably an alkyl group having 1 to 30 carbon atoms in total, which may be substituted.

The alkyloxy group represented by R⁶ is preferably a methyloxy group, an ethyloxy group, a butyloxy group, a hexyloxy group, a phenoxyethyloxy group, a trichloromethyloxy group, or an ethoxyethyloxy group.

Examples of the aminosulfonyl group for R⁶ include a methylaminosulfonyl group, a dimethylaminosulfonyl group, a phenylaminosulfonyl group, a methylphenylaminosulfonyl group, and an aminosulfonyl group.

Examples of the alkoxysulfonyl group represented by R⁶ include a methoxysulfonyl group, an ethoxysulfonyl group, a propyloxysulfonyl group, and a butyloxysulfonyl group.

Examples of the substituent which may be carried by the alkyl group or alkyloxy group represented by R⁶ include a halogen atom, an alkyloxy group, an aryloxy group, an alkylthio group, an arylthio group, an alkyloxycarbonyl group, an aryloxycarbonyl group, and an aminocarbonyl group.

In the formulae (OS-3) to (OS-5), m represents an integer from 0 to 6, and m is preferably an integer from 0 to 2, more preferably 0 or 1, and particularly preferably 0.

The compound represented by the formula (OS-3) is particularly preferably a compound represented by the following formula (OS-6), formula (OS-10) or formula (OS-11). The compound represented by the formula (OS-4) is particularly preferably a compound represented by the following formula (OS-7), and the compound represented by the formula (OS-5) is particularly preferably a compound represented by the following formula (OS-8) or formula (OS-9).

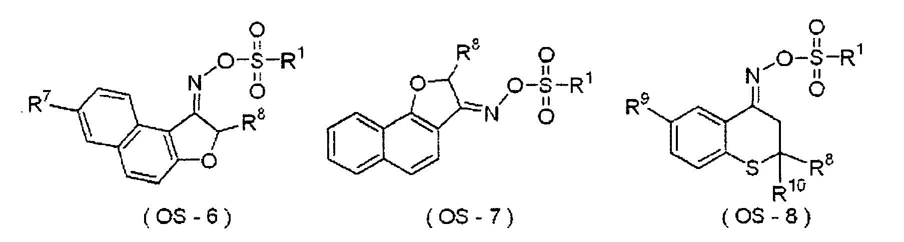

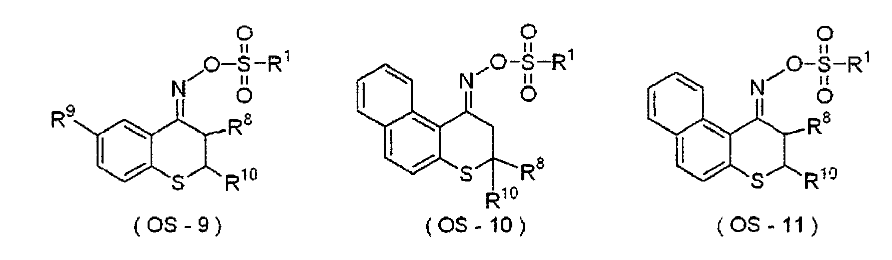

In the formulae (OS-6) to (OS-11), R¹ represents an alkyl group, an aryl group or a heteroaryl group; R⁷ represents a hydrogen atom or a bromine atom; R⁸ represents a hydrogen atom, an alkyl group having 1 to 8 carbon atoms, a halogen atom, a chloromethyl group, a bromomethyl group, a bromoethyl group, a methoxymethyl group, a phenyl group or a chlorophenyl group; R⁹ represents a hydrogen atom, a halogen atom, a methyl group or a methoxy group; and R¹⁰ represents a hydrogen atom or a methyl group.

In the formulae (OS-6) to (OS-11), R¹ has the same meaning as R¹ for the formulae (OS-3) to (OS-5), and has the same preferable meanings.

R⁷ in the formula (OS-6) represents a hydrogen atom or a bromine atom, and is preferably a hydrogen atom.

R⁸ in the formulae (OS-6) to (OS-11) represents a hydrogen atom, an alkyl group having 1 to 8 carbon atoms, a halogen atom, a chloromethyl group, a bromomethyl group, a bromoethyl group, a methoxymethyl group, a phenyl group, or a chlorophenyl group. R⁸ is preferably an alkyl group having 1 to 8 carbon atoms, a halogen atom, or a phenyl group; more preferably an alkyl group having 1 to 8 carbon atoms; yet more preferably an alkyl group having 1 to 6 carbon atoms; and particularly preferably a methyl group.

R⁹ in the formulae (OS-8) and formula (OS-9) represents a hydrogen atom, a halogen atom, a methyl group or a methoxy group, and is preferably a hydrogen atom.

R¹⁰ in the formulae (OS-8) to (OS-11) represents a hydrogen atom or a methyl group, and is preferably a hydrogen atom.

For the oxime sulfonate compound, the configuration (E or Z) of the oxime may adopt any one structure or may be a mixture of configurations.

Specific examples of the oxime sulfonate compound represented by the formulae (OS-3) to (OS-5) include the following exemplary compounds, but the present invention is not limited to these compounds.

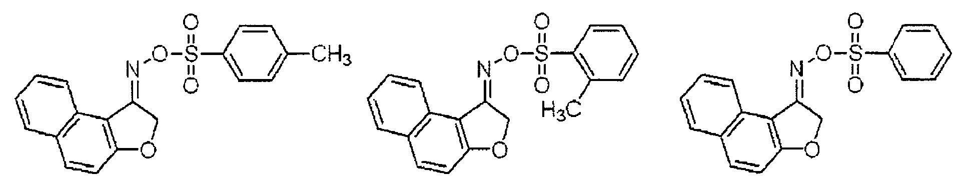

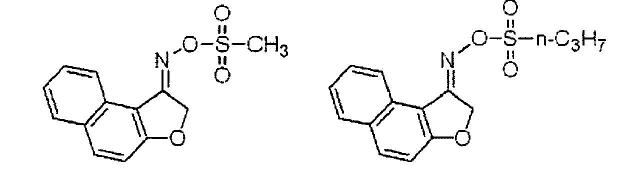

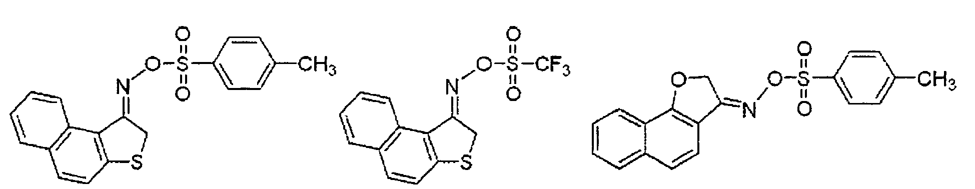

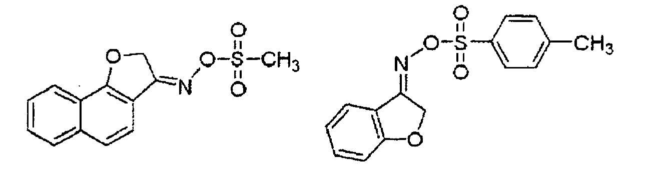

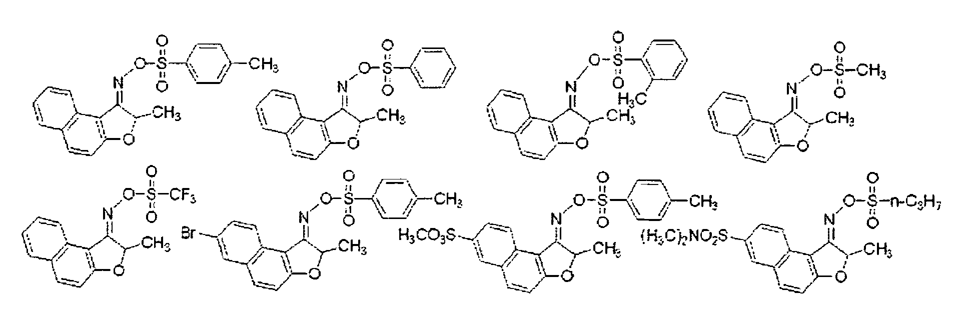

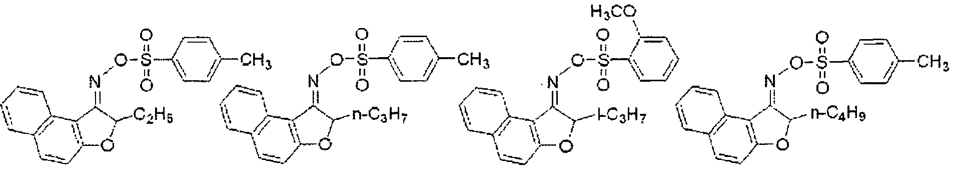

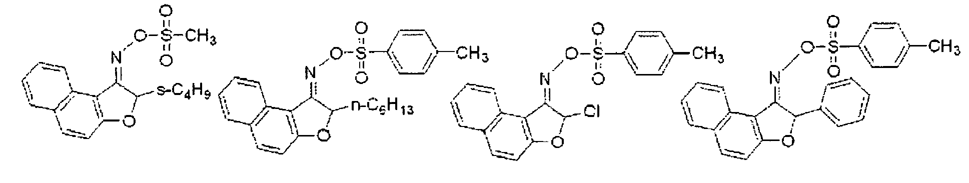

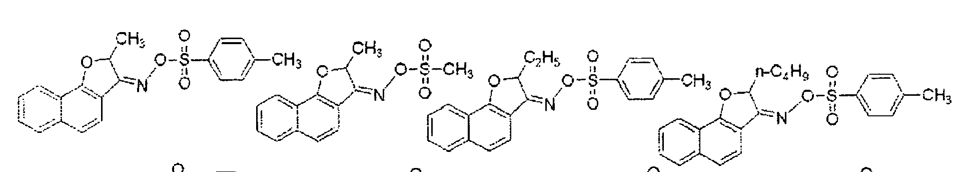

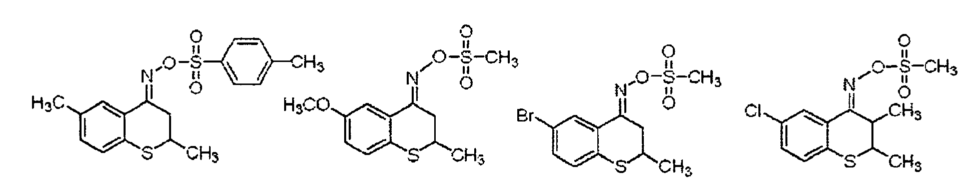

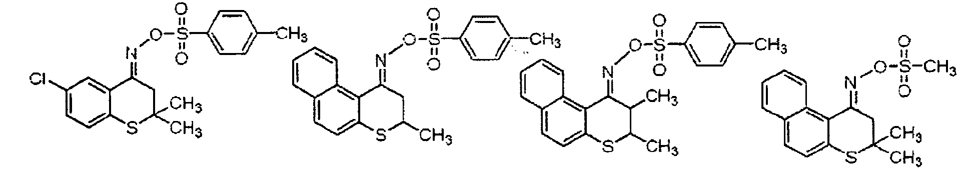

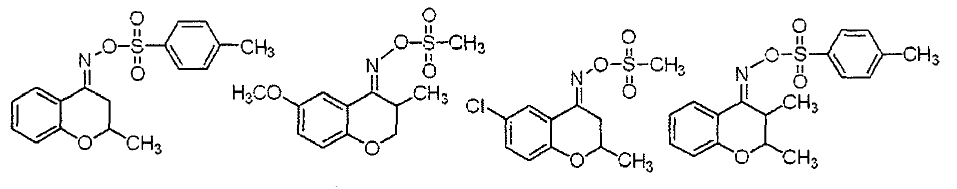

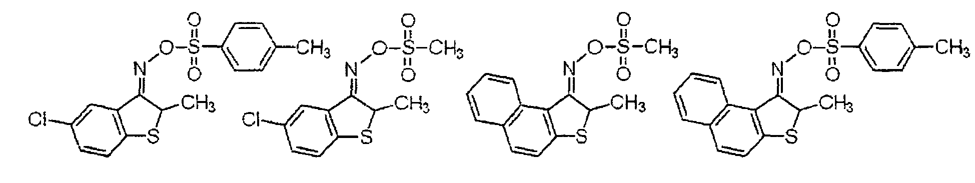

Another suitable embodiment of the oxime sulfonate, compound having at least one oxime sulfonate, residue represented by the formula (1) may be a compound represented by the following formula (OS-1).

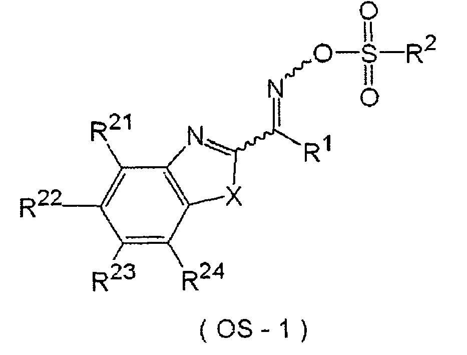

In the formula (OS-1), R¹ represents a hydrogen atom, an alkyl group, an alkenyl group, an alkoxy group, an alkoxycarbonyl group, an acyl group, a carbamoyl group, a sulfamoyl group, a sulfo group, a cyano group, an aryl group, or a heteroaryl group. R² represents an alkyl group or an aryl group.

X represents -O-, -S-, -NH-, -NR⁵-, -CH₂-, -CR⁶H-, or -CR⁶R⁷-, and R⁵ to R⁷ each represent an alkyl group or an aryl group.

R²¹ to R²⁴ each independently represent a hydrogen atom, a halogen atom, an alkyl group, an alkenyl group, an alkoxy group, an amino group, an alkoxycarbonyl group, an alkylcarbonyl group, an arylcarbonyl group, an amide group, a sulfo group, a cyano group, or an aryl group. Two among R²¹ to R²⁴ may be respectively joined together to form a ring.

R²¹ to R²⁴ are each preferably a hydrogen atom, a halogen atom, or an alkyl group, and in a preferable embodiment, at least two among R²¹ to R²⁴ may be joined together to form an aryl group. Among them, it is preferable that all of R²¹ to R²⁴ be hydrogen atoms, from the viewpoint of sensitivity.

The substituents described above may all be further substituted.

The compound represented by the formula (OS-1) is more preferably a compound represented by the following formula (OS-2).

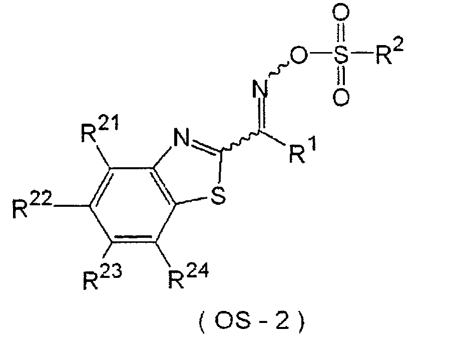

In the formula (OS-2), R¹, R², and R²¹ to R²⁴ respectively have the same meanings as R¹, R², and R²¹ to R²⁴ for the formula (OS-1), and also have the same preferable meanings.

Among these, it is more preferable that R¹ in the formula (OS-1) and formula (OS-2) be a cyano group or an aryl group, and it is most preferable that the compound be represented by the formula (OS-2), while R¹ be a cyano group, a phenyl group, or a naphthyl group.

Furthermore, in regard to the oxime sulfonate compound, the configuration (E, Z or the like) of the oxime or benzothiazole ring may adopt any one structure, or may be a mixture of different configurations.

Specific examples of the compound represented by the formula (OS-1) (exemplary compounds b-1 to b-34) that can be suitably used in the present invention are shown below, but the present invention is not limited to these compounds. In the specific examples, Me represents a methyl group, Et represents an ethyl group, Bn represents a benzyl group, and Ph represents a phenyl group.

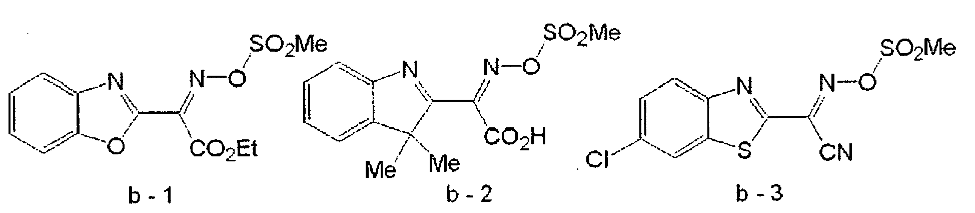

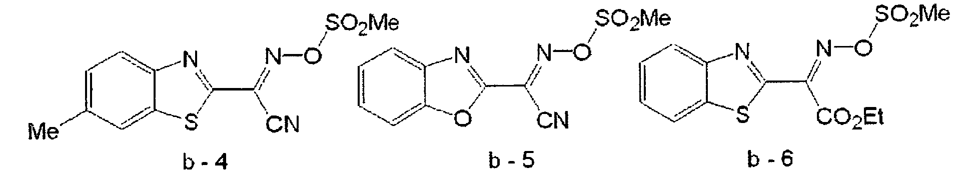

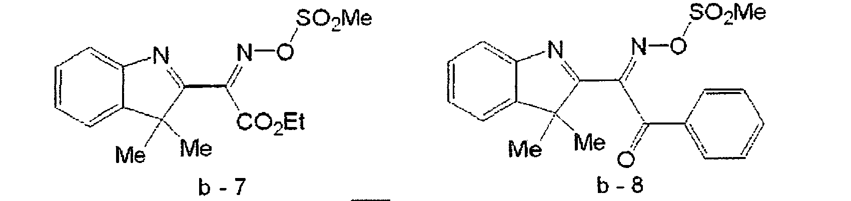

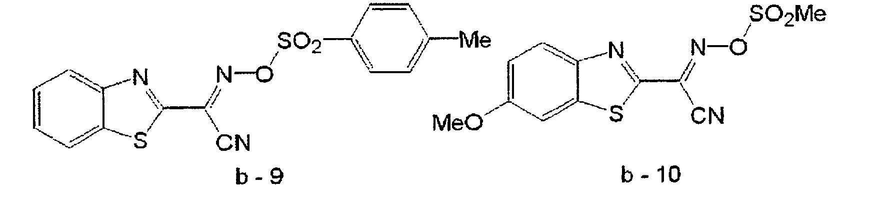

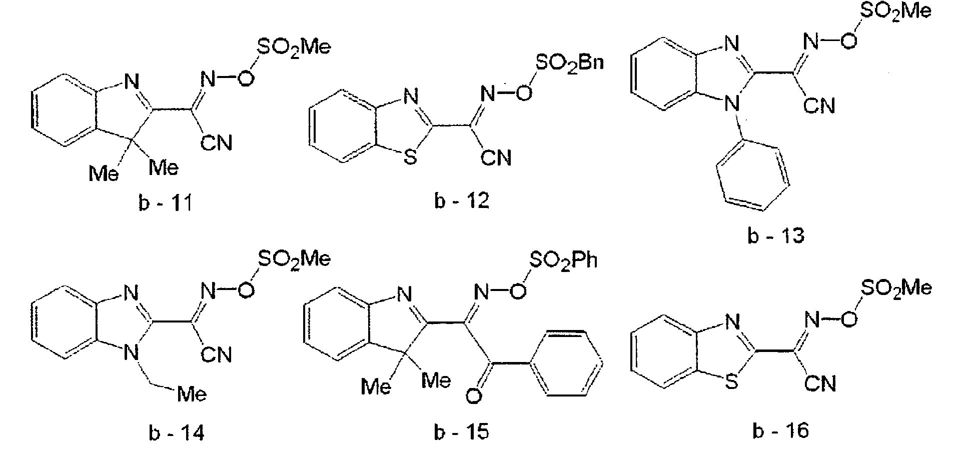

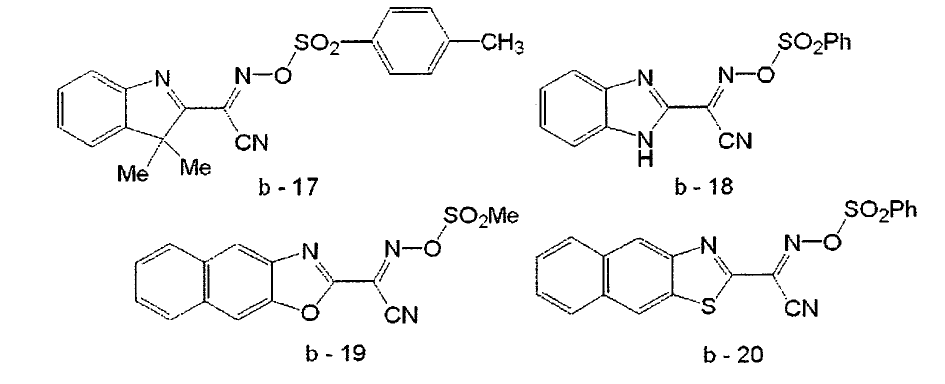

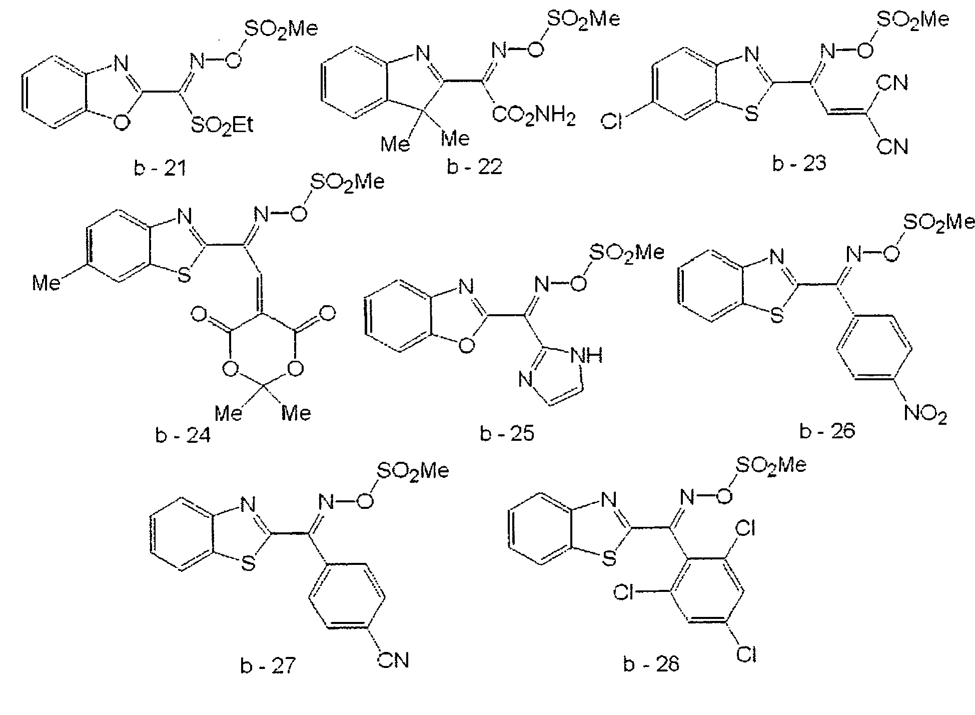

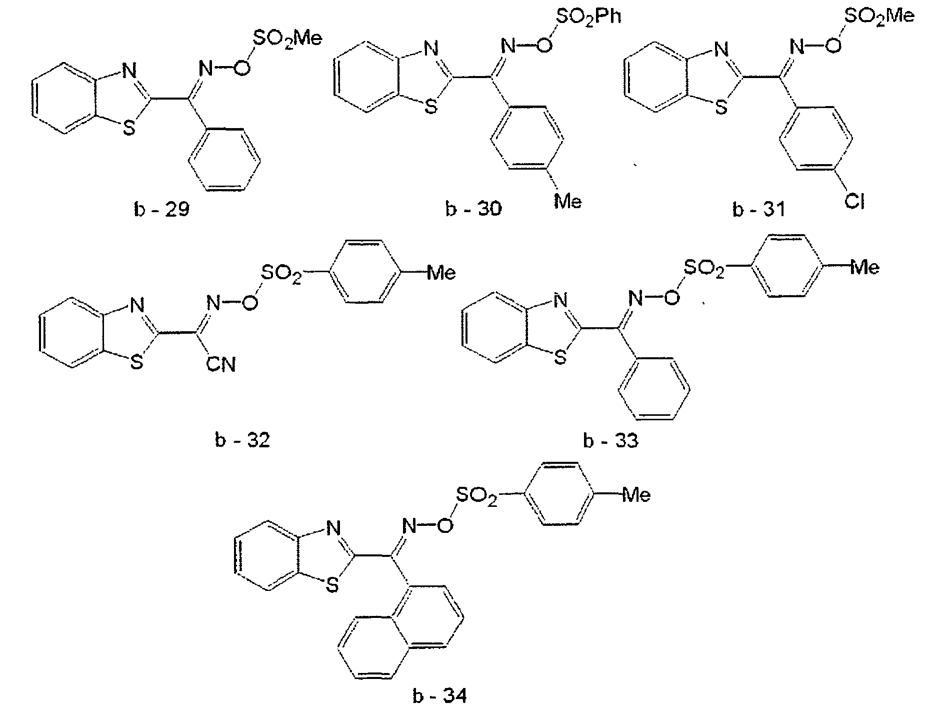

Among the compounds shown above, compounds b-9, b-16, b-31 and b-33 are preferable from the viewpoint of achieving a balance between sensitivity and stability.

The photosensitive resin composition of the present invention preferably does not contain a 1,2-quinonediazide compound as (Component B) photo acid generator which responds to active radiation. It is because, although a 1,2-quinonediazide compound produces a carboxyl group through a series of photochemical reactions, the quantum yield is 1 or less, and the compound has lower sensitivity than oxime sulfonate compounds.

On the contrary, an oxime sulfonate compound acts as a catalyst for the deprotection of an acidic group, by which the acid produced in response to an active radiation is protected. Therefore, the acid produced by the action of one photon contributes to the deprotection reaction of many others, so that the quantum yield reaches a large value which exceeds 1, for example, a value such as 10 to the power of some number. Thus, it is speculated that as a result of the so-called chemical amplification, high sensitivity can be obtained.

For the photosensitive resin composition of the present invention, (Component B) photo acid generator is preferably used in an amount of 0.1 to 10 parts by weight, and more preferably in an amount of 0.5 to 10 parts by weight, based on 100 parts by weight of Component A.

### (Component C) Solvent

The photosensitive resin composition of the present invention contains (Component C) a solvent.

The photosensitive resin composition of the present invention is preferably prepared as a solution in which Component A and Component B, which are essential Components, and optional Components such as various additives that will be described below, as preferable Components, in (Component C) solvent.

As (Component C) solvent used in the photosensitive resin composition of the present invention, a known solvent can be used, and examples include ethylene glycol monoalkyl ethers, ethylene glycol dialkyl ethers, ethylene glycol monoalkyl ether acetates, propylene glycol monoalkyl ethers, propylene glycol dialkyl ethers, propylene glycol monoalkyl ether acetates, diethylene glycol dialkyl ethers, diethylene glycol monoalkyl ether acetates, dipropylene glycol monoalkyl ethers, dipropylene glycol dialkyl ethers, dipropylene glycol monoalkyl ether acetates, esters, ketones, amides, and lactones.

Examples of (Component C) solvent used in the photosensitive resin composition of the present invention include (1) ethylene glycol monoalkyl ethers such as ethylene glycol monomethyl ether, ethylene glycol monoethyl ether, ethylene glycol monopropyl ether, and ethylene glycol monobutyl ether; (2) ethylene glycol dialkyl ethers such as ethylene glycol dimethyl ether, ethylene glycol diethyl ether, and ethylene glycol dipropyl ether; (3) ethylene glycol monoalkyl ether acetates such as ethylene glycol monomethyl ether acetate, ethylene glycol monoethyl ether acetate, ethylene glycol monopropyl ether acetate, and ethylene glycol monobutyl ether acetate; (4) propylene glycol monoalkyl ethers such as propylene glycol monomethyl ether, propylene glycol monoethyl ether, propylene glycol monopropyl ether, and propylene glycol monobutyl ether; (5) propylene glycol dialkyl ethers such as propylene glycol dimethyl ether, propylene glycol diethyl ether, diethylene glycol monomethyl ether, and diethylene glycol monoethyl ether;
(6) propylene glycol monoalkyl ether acetates such as propylene glycol monomethyl ether acetate, propylene glycol monoethyl ether acetate, propylene glycol monopropyl acetate, and propylene glycol monobutyl acetate; (7) diethylene glycol dialkyl ethers such as diethylene glycol dimethyl ether, diethylene glycol diethyl ether, and diethylene glycol ethyl methyl ether; (8) diethylene glycol monoalkyl ether acetates such as diethylene glycol monomethyl ether acetate, diethylene glycol monoethyl ether acetate, diethylene glycol monopropyl ether acetate, and diethylene glycol monobutyl ether acetate; (9) dipropylene glycol monoalkyl ethers such as dipropylene glycol monomethyl ether, dipropylene glycol monoethyl ether, dipropylene glycol monopropyl ether, and dipropylene glycol monobutyl ether; (10) dipropylene glycol dialkyl ethers such as dipropylene glycol dimethyl ether, dipropylene glycol diethyl ether, and dipropylene glycol ethyl methyl ether;
(11) dipropylene glycol monoalkyl ether acetates such as dipropylene glycol monomethyl ether acetate, dipropylene glycol monoethyl ether acetate, dipropylene glycol monopropyl ether acetate, and dipropylene glycol monobutyl ether acetate; (12) lactic acid esters such as methyl lactate, ethyl lactate, *n*-propyl lactate, isopropyl lactate, *n*-butyl lactate, isobutyl lactate, *n*-amyl lactate, and isoamyl lactate; (13) aliphatic carboxylic acid esters such as *n*-butyl acetate, isobutyl acetate, *n*-amyl acetate, isoamyl acetate, *n*-hexyl acetate, 2-ethylhexyl acetate, ethyl propionate, *n*-propyl propionate, isopropyl propionate, *n*-butyl propionate, isobutyl propionate, methyl butyrate, ethyl butyrate, ethyl butyrate, *n*-propyl butyrate, isopropyl butyrate, *n*-butyl butyrate, and isobutyl butyrate; (14) other esters such as ethyl hydroxyacetate, ethyl 2-hydroxy-2-methylpropionate, ethyl 2-hydroxy-3-methylbutyrate, ethyl methoxyacetate, ethyl ethoxyacetate, methyl 3-methoxypropionate, ethyl 3-methoxypropionate, methyl 3-ethoxypropionate, ethyl 3-ethoxypropionate, 3-methoxybutyl acetate, 3-methyl-3-methoxybutyl acetate, 3-methyl-3-methoxybutyl propionate, 3-methyl-3-methoxybutyl butyrate, methyl acetoacetate, ethyl acetoacetate, methyl pyruvate, and ethyl pyruvate;
(15) ketones such as methyl ethyl ketone, methyl propyl ketone, methyl *n*-butyl ketone, methyl isobutyl ketone, 2-heptanone, 3-heptanone, 4-heptanone, and cyclohexanone; (16) amides such as *N*-methylformamide, *N,N*-dimethylformamide, *N*-methylacetamide, *N,N*-dimethylacetamide, and *N*-methylpyrrolidone; and (17) lactones such as γ-butyrolactone.

These solvents may be further mixed, if necessary, with solvents such as benzyl ethyl ether, dihexyl ether, ethylene glycol monophenyl ether acetate, diethylene glycol monomethyl ether, diethylene glycol monoethyl ether, isophorone, caproic acid, caprylic acid, 1-octanol, 1-nonal, benzyl alcohol, anisole, benzyl acetate, ethyl benzoate, diethyl oxalate, diethyl maleate, ethylene carbonate, and propylene carbonate.

Among the solvents described above, diethylene glycol ethyl methyl ether, and/or propylene glycol monomethyl ether acetate are particularly preferable.

These solvents may be used singly or as mixtures of two or more kinds.

The solvents that can be used in the present invention are preferably used singly or in combination of two or more kinds. It is more preferable to use two kinds of solvents in combination, and it is yet more preferable to use a propylene glycol monoalkyl ether acetate and a diethylene glycol dialkyl ether in combination.

The content of (Component C) solvent in the photosensitive resin composition of the present invention is preferably 50 to 3,000 parts by weight, more preferably 100 to 2,000 parts by weight, and yet more preferably 150 to 1,500 parts by weight, per 100 parts by weight of Component A.

### (Component D) Thermal crosslinking agent

The photosensitive resin composition of the present invention preferably contains (Component D) a thermal crosslinking agent, according to necessity. When the composition contains (Component D) thermal crosslinking agent, the heat flow in the bake step can be suppressed. Component D according to the present invention is a compound other than Component A.

Preferable examples of the thermal crosslinking agent include a blocked isocyanate-based crosslinking agent, an alkoxymethyl group-containing crosslinking agent, an epoxy resin having an epoxy group, or a (meth)acrylic resin having a carboxyl group, which will be described later.

For the photosensitive resin composition for etching resist, among others, a blocked isocyanate-based crosslinking agent is particularly preferable from the viewpoints of resist sensitivity and storage stability. Furthermore, an alkoxymethyl group-containing crosslinking agent can also be suitably used, and the crosslinking agent preferably includes at least a methylolated melamine compound.

Furthermore, for the photosensitive resin composition for MEMS structural members, among others, the crosslinking agent preferably includes at least an alkoxymethyl group-containing crosslinking agent, and particularly preferably includes at least a methylolated melamine compound.

### <Alkoxymethyl group-containing crosslinking agent>

The alkoxymethyl group-containing crosslinking agent is preferably alkoxymethylated melamine, akloxymethylated benzoguanamine, alkoxymethylated glycoluril, alkoxymethylated urea, or the like. These can be obtained by converting the respective methylol groups of methylolated melamine, methylolated benzoguanamine, methylolated glycoluril, and methylolated urea into alkoxymethyl groups. There are no particular limitations on the type of this alkoxymethyl group, and examples include a methoxymethyl group, an ethoxymethyl group, a propoxymethyl group, and a butoxymethyl group. However, from the viewpoint of the amount of outgas generation, a methoxymethyl group is particularly preferable.

Among these alkoxymethyl group-containing crosslinking agents, preferable examples of the alkoxymethyl group-containing crosslinking agent include alkoxymethylated melamine, alkoxymethylated benzoguanamine, and alkoxymethylated glycoluril. From the viewpoint of transparency, alkoxymethylated glycoluril is particularly preferable.

These alkoxymethyl group-containing crosslinking agents are available as commercial products, and preferable examples that can be used include CYMEL 300, 301, 303, 370, 325, 327, 701, 266, 267, 238, 1141, 272, 202, 1156, 1158, 1123, 1170, 1174, UFR65 and 300 (all manufactured by Mitsui Cyanamide, Ltd.); NIKALAC MX-750, -032, -706, -708, -40, -31, -270, -280 and -290, NIKALAC MS-11, NIKALAC MW-30HM, -100 LM, and -390 (all manufactured by Sanwa Chemical Co., Ltd.). Among these, NIKALAC MX-270 and NIKALAC MW-100LM are particularly preferable.

In the case of using an alkoxymethyl group-containing crosslinking agent in the photosensitive resin composition of the present invention, the addition amount of the alkoxymethyl group-containing crosslinking agent is preferably 0.05 to 50 parts by weight, more preferably 0.5 to 10 parts by weight, and yet more preferably 0.5 to 5 parts by weight, based on 100 parts by weight of Component A. When the crosslinking agent is added in this range, high sensitivity, and preferable alkali solubility at the time of development are obtained.

### <Blocked isocyanate-based crosslinking agent>

The blocked isocyanate-based crosslinking agent is not particularly limited as long as it is a compound having a blocked isocyanate group (blocked isocyanate compound). However, from the viewpoint of curability, the crosslinking agent is preferably a compound having two or more blocked isocyanate groups in one molecule.

The blocked isocyanate group according to the present invention is a group capable of producing an isocyanate group under the action of heat, and a preferable example may be a group protecting an isocyanate group by allowing a blocking agent to react with an isocyanate group. Furthermore, the blocked isocyanate group is preferably a group capable of producing an isocyanate group under the action of heat at 90°C to 250°C.

There are no particular limitations on the skeleton of the blocked isocyanate-based crosslinking agent, and compounds having a hexamethylene diisocyanate (HDI) skeleton, an isophorone diisocyanate (IPDI) skeleton, and a prepolymer type skeleton derived from HDI or IPDI can be suitably used.

The blocking agent for the isocyanate group with regard to the blocked isocyanate group is not particularly limited, and an active methylene compound such as a diester compound, and an active hydrogen compound such as an oxime compound, a lactam compound or an amine compound can be preferably used. Among these, an active methylene compound is particularly preferable from the viewpoint of reactivity.

Examples of the active methylene compound include diethyl malonate, dimethyl malonate, ethyl acetoacetate, and methyl acetoacetate.

Examples of the oxime compound include cyclohexanone oxime, benzophenone oxime, and acetoxime.

Examples of the lactam compound include ε-caprolactam, and γ-butyrolactam. Examples of the amine compound include aniline, diphenylamine, ethyleneimine, and polyethyleneimine.

The active hydrogen compound reacts with an isocyanate group as shown in the following formula, and forms a blocked isocyanate group.

R-NCO + H-R' → R-NH-C(=O)-R'

wherein H-R' represents an active hydrogen compound; H in H-R' represents an active hydrogen atom; R represents a moiety other than the isocyanate group in an isocyanate compound; and R' represents a moiety other than the active hydrogen atom in an active hydrogen compound.

These blocked isocyanate-based crosslinking agents are available as commercial products, and preferable examples that can be used include DURANATE MF-K60X, MF-K60B, MF-B60X, 17B-60P, TPA-B80E, E402-B80B, SBN-70D, and K6000 (all manufactured by Asahi Kasei Chemicals Corp.), DESMODUR BL3272, BL3575/1, BL3475, BL3370, BL4265, BL5375, VPLS2376/1, VPLS2257, VPLS2078/1 and VPLS2352/1, SUMIDUR BL3175 (all manufactured by Sumitomo Bayer Urethane Co., Ltd.), and UREHYPER PUR-1804 (manufactured by DIC Corp.). Among these, DURANATE MF-K60X, MF-K60B, SBN-70D and K6000 are particularly preferable.

In the case of using a blocked isocyanate crosslinking agent in the photosensitive resin composition of the present invention, the addition amount of the blocked isocyanate-based crosslinking agent is preferably 0.1 to 50 parts by weight, more preferably 1 to 20 parts by weight, and yet more preferably 3 to 15 parts by weight, based on 100 parts by weight of Component A. When the blocked isocyanate-based crosslinking agent is added in this range, high sensitivity, and preferable alkali solubility at the time of development can be obtained.
(Component E) Compound having total functional group equivalent for epoxy group, oxetanyl group, hydroxyl group and carboxyl group of 400 g/eq or greater

It is effective for the photosensitive resin composition of the present invention to add a compound having a total functional group equivalent for an epoxy group, an oxetanyl group, a hydroxyl group and a carboxyl group of 400 g/eq or greater, in order to suppress the curing shrinkage of the film and to obtain a rectangular profile after baking.

Component E is preferably a resin having a weight average molecular weight of 1,000 or greater.

Specific examples include copolymers including monomer units containing an epoxy group, an oxetanyl group, a hydroxyl group and/or a carboxyl group.

Furthermore, a compound which contains none of the functional groups described above, such as a homopolymer of polymethyl methacrylate (PMMA), can also be added as Component E.

According to the present invention, when Component E satisfies the definition of Component D, the compound is classified as belonging to both of the classes. For example, when Component E is an epoxy resin having an epoxy equivalent of 400 g/eq or greater, the epoxy resin is Component D, and also Component E. Component E according to the present invention is other than Component A.

Furthermore, there are no particular limitations on the method of measuring the epoxy equivalent, oxetanyl equivalent, hydroxyl group equivalent and carboxyl group equivalent, and any known method can be used. For example, the equivalent can be calculated by measuring the content of the relevant group in a specific amount of the compound through titration or the like. For example, measurement can be made by making reference to the method described in JIS K7236, K0070 or the like.

### <Epoxy resin>

Component E is preferably an epoxy resin. When an epoxy resin is added, heat flow at the time of baking can be suppressed. Furthermore, the epoxy resin preferably has a large epoxy equivalent, so that curing shrinkage of the cross-linked film is suppressed, and a profile that is rectangular or close to a rectangle is obtained. Specifically, the epoxy equivalent is preferably 400 g/eq or greater, more preferably 400 to 1,000 g/eq, and particularly preferably 400 to 600 g/eq. When the epoxy equivalent is in this range, curing shrinkage occurs to a reduced extent, and a profile that is rectangular or close to a rectangle can be obtained. Also, the tolerance level of the process conditions at the time of production of a cured film is large.

Meanwhile, the method for measuring the epoxy equivalent is preferably carried out according to JIS K7236.

As the epoxy resin, commercially available products and synthesized products can be used. Specific examples of the epoxy resin having an epoxy equivalent of 400 g/eq or greater, which are commercially available, are listed below.

EPICLON 1050, 1055, 3050, 4050, 7050, AM-020-P, AM-040-P, NM-091, HM-101, 1050-70X, 1050-75X, 1055-75X, 1051-75M, 7070-40K, HM-091-40AX, 152, 153, 153-60T, 153-60M, 1121N-80M, 1123P-75M, TSR-601, 1650-75MPX, 5500, 5800, 5300-70, 5500-60, EXA-4850-150, EXA-4850-1000, EXA-4816, and EXA-4822 (all manufactured by DIC Corp.);

Epoxy resins 1001, 1002, 1003, 1055, 1004, 1004 AF, 1007, 1009, 1010, 1003F, 1004F, 1005F, 1009F, 1004FS, 1006FS, 1007FS, 1001B80, 1001X70, 1001X75, 1001 T75, 4004P, 4005P, 4007P, 4010P, 1256, 4250, 4275, 5046B80, 5047B75, 5050T60, 5050, 5051, 871, 872, and 872X75 (all manufactured by Mitsubishi Chemical Corp.); and

YD-011, YD-012, YD-013, YD-014, YD-017, YD-019, YD-020G, YD-7011R, YD-901, YD-902, YD-903N, YD-904, YD-907, YD-6020, YDF-2001, YDF-2004, YDF-2005RL, YDB-400, YDB-405, YDB-400T60, YDB-400EK60, YDB-500EK80, FX-305EK70, and ERF-001 M30 (all manufactured by Nippon Steel Chemical Co., Ltd.).

As the structure of the epoxy resin, it is preferable that the epoxy resin have a bisphenol A (BPA) skeleton, and specific examples include EPICLON 1050, 1055, 3050, 4050, EXA-4850-150, EXA-4850-1000, EXA-4816, and EXA-4822 (all manufactured by DIC Corp.), Epoxy resins 1001, 1002, 1003, 1055, 1004, and 1004AF (all manufactured by Mitsubishi Chemical Corp.), YD-011, YD-012, YD-013, and YD-014 (all manufactured by Nippon Steel Chemical Co., Ltd.).

An epoxy resin having an epoxy equivalent of less than 400 g/eq can also be added to the photosensitive resin composition of the present invention.

Specific examples of commercially available products include EPICLON HP4700, HP4710, 830, 830-S, 835, EXA-830CRP, EXA-830LVP, EXA-835LV, 840, 840-S, 850, 850-S, 850-LC, 860, 860-90X, N-740, N-770, N-775, N-865, and TSR-960 (all manufactured by DIC Corp.), 827, 828, 828 EL, 828XA, 834, 801 N, 801 PN, 802, 811, 813, 816A, 816C, 819, 806, 807, 152, 154, 157S65, 157S70, 1031 S, 1032H60, 604, and 630 (all manufactured by Mitsubishi Chemical Corp.).

The addition amount of the epoxy resin is preferably 10 wt% to 50 wt%, and particularly preferably 20 wt% to 40 wt%, based on the total solids content of the photosensitive resin composition. When the addition amount is in this range, it is easier to obtain a profile that is rectangular or close to a rectangle, and to form a desired pattern by the development process.

The molecular weight (weight average molecular weight) of the epoxy resin is preferably 500 or greater. When the molecular weight is 500 or less, volatilization of the epoxy resin in the solvent drying step or discharge of the epoxy resin in the development step can be suppressed, and thus the effect of adding an epoxy resin can be sufficiently obtained.

The epoxy resin can be used singly, or as mixtures of two or more kinds.

Furthermore, the photosensitive resin composition of the present invention preferably contains an alkoxymethyl group-containing crosslinking agent and an epoxy resin having an epoxy equivalent of 400 g/eq or greater, from the viewpoint of obtaining a profile that is closer to rectangle.

### <(Meth)acrylic resin having carboxyl group>

Component E may be a (meth)acrylic resin having a carboxyl group.

The (meth)acrylic resin having a carboxyl group preferably has a large carboxyl group equivalent, in order to suppress curing shrinkage of the cross-linked film and to obtain a rectangular profile. Specifically, the carboxyl group equivalent is preferably 400 g/eq or greater, more preferably 400 to 1,000 g/eq, and particularly preferably 400 to 600 g/eq.

The (meth)acrylic resin having a carboxyl group can be obtained by using a known (meth)acrylic monomer, and the adjustment of the carboxyl group equivalent can be achieved by regulating the type of the monomer, and the amount ratios of the monomers.

The acrylic monomer is preferably, for example, an unsaturated monocarboxylic acid, a (meth)acrylic acid ester, a crotonic acid ester, or a (meth)acrylamide.

Specific examples of such a monomer include, for example, the compounds described below.

Examples of the unsaturated monocarboxylic acid include (meth)acrylic acid, crotonic acid, α-chloroacrylic acid, and cinnamic acid.

Examples of the (meth)acrylic acid ester include methyl (meth)acrylate, ethyl (meth)acrylate, *n*-propyl (meth)acrylate, isopropyl (meth)acrylate, *n*-butyl (meth)acrylate, isobutyl (meth)acrylate, *tert*-butyl (meth)acrylate, *n*-hexyl (meth)acrylate, 2-ethylhexyl (meth)acrylate, acetoxyethyl (meth)acrylate, phenyl (meth)acrylate, 2-hydroxyethyl (meth)acrylate, 2-hydroxypropyl (meth)acrylate, 4-hydroxybutyl (meth)acrylate, 2-methoxyethyl (meth)acrylate, 2-ethoxyethyl (meth)acrylate, 2-(2-methoxyethoxy)ethyl (meth)acrylate, cyclohexyl (meth)acrylate, benzyl (meth)acrylate, diethylene glycol monomethyl ether (meth)acrylate, diethylene glycol monoethyl ether (meth)acrylate, diethylene glycol monophenyl ether (meth)acrylate, triethylene glycol monomethyl ether (meth)acrylate, triethylene glycol monoethyl ether (meth)acrylate, dipropylene glycol monomethyl ether (meth)acrylate, polyethylene glycol monomethyl ether (meth)acrylate, polypropylene glycol monomethyl ether (meth)acrylate, monomethyl ether (meth)acrylate of a copolymer of ethylene glycol and propylene glycol, *N,N*-dimethylaminoethyl (meth)acrylate, *N,N*-diethylaminoethyl (meth)acrylate, and *N,N*-dimethylaminopropyl (meth)acrylate.

Examples of the crotonic acid ester include butyl crotonate, and hexyl crotonate.

Examples of the (meth)acrylamide include (meth)acrylamide, *N*-methyl(meth)acrylamide, *N*-ethyl(meth)acrylamide, *N*-propyl(meth)acrylamide, *N*-n-butylacryl(meth)amide, *N*-*tert*-butyl(meth)acrylamide, *N*-cyclohexyl(meth)acrylamide, *N*-(2-methoxyethyl)(meth)acrylamide, *N,N*-dimethyl(meth)acrylamide, *N,N*-diethyl(meth)acrylamide, *N*-phenyl(meth)acrylamide, *N*-benzyl(meth)acrylamide, and (meth)acryloylmorpholine.

Among these, the (meth)acrylic resin having a carboxyl group is preferably a copolymer of benzyl (meth)acrylate and (meth)acrylic acid.

The content of Component E in the photosensitive resin composition of the present invention is preferably 0.5 to 50 parts by weight, more preferably 1 to 40 parts by weight, and yet more preferably 5 to 30 parts by weight, based on 100 parts by weight of Component A. When the content is in this range, it is easier to obtain a profile that is rectangular or close to a rectangle.

### <Other Components>

The photosensitive resin composition of the present invention may contain other Components other than Component A to Component E.

As the other Components, it is preferable that the photosensitive resin composition contain (Component F) a sensitizer, from the viewpoint of sensitivity. Also, from the viewpoint of sensitivity, it is preferable to add (Component G) a development accelerator.

Furthermore, the photosensitive resin composition of the present invention preferably contains (Component H) an adhesion improving agent from the viewpoint of the adhesiveness to substrate, preferably contains (Component I) a basic compound from the viewpoint of liquid storage stability, and preferably contains (Component J) a surfactant (a fluorine-based surfactant, a silicone-based surfactant, or the like) from the viewpoint of coatability.

Furthermore, if necessary, known additives such as (Component K) an antioxidant, (Component L) a plasticizer, (Component M) a thermal radical generator, (Component N) a thermal acid generator, (Component O) an acid amplifier, an ultraviolet absorbent, a thickening agent, and organic or inorganic precipitation preventing agent, can be added to the photosensitive resin composition of the present invention.

Furthermore, from the viewpoint of obtaining a profile that is closer to rectangle, it is preferable that the photosensitive resin composition of the present invention contain an epoxy resin having an epoxy equivalent of 400 g/eq or greater, (Component H) an adhesion improving agent, (Component I) a basic compound, and (Component J) a surfactant, and it is particularly preferable that the composition contain an alkoxymethyl group-containing crosslinking agent, an epoxy resin having an epoxy equivalent of 400 g/eq or greater, (Component H) an adhesion improving agent, (Component I) a basic compound, and (Component J) a surfactant.

Hereinafter, the other Components that can be contained in the photosensitive resin composition of the present invention will be described.

### (Component F) Sensitizer

It is preferable to add (Component F) a sensitizer to the photosensitive resin composition of the present invention, for the combination with (Component B) photo acid generator, in order to accelerate the decomposition of the photo acid generator. The sensitizer absorbs active rays or radiation, and enters an electron-excited state. The sensitizer in the electron-excited state is brought into contact with the photo acid generator, and actions such as electron transfer, energy transfer, and heat generation occur. Thereby, the photo acid generator undergoes a chemical change and is decomposed, thus producing an acid.

Preferable examples of the sensitizer include compounds which belong to the following compounds and have an absorption wavelength in the range of 350 nm to 450 nm.

Examples include polynuclear aromatic compounds (for example, pyrene, perylene, triphenylene, and anthracene), xanthenes (for example, fluorescein, eosin, erythrosine, rhodamin B, and Rose Bengal), xanthones (for example, xanthone, thioxanthone, dimethylthioxanthone, and diethylthioxanthone), cyanines (for example, thiacarbocyanine and oxacarbocyanine), merocyanines (for example, merocyanine and carbomerocyanine), rhodacyanines, oxonols, thiazines (for example, thionine, methylene blue, and toluidine blue), acridines (for example, acridine orange, chloroflavine, and acriflavine), acridones (for example, acridone and 10-butyl-2-chloroacridone), anthraquinones (for example, anthraquinone), squariums (for example, squarium), styryls, base styryls, and coumarins (for example, 7-diethylamino-4-methylcoumarin). Among these sensitizers, a sensitizer which absorbs active rays or radiation, enters an electron-excited state, and effects electron transfer to the photo acid generator is preferable, and polynuclear aromatic compounds, acridones, coumarins, and base styryls are particularly preferable.

In regard to the sensitizer, commercially available products may be used, or the sensitizer may be synthesized by a known synthesis method.

The addition amount of the sensitizer is preferably 20 to 300 parts by weight, and particularly preferably 30 to 200 parts by weight, based on 100 parts by weight of (Component B) photo acid generator.

### (Component G) Development accelerator

The photosensitive resin composition of the present invention preferably contains (Component G) a development accelerator.

As (Component G) development accelerator, any compound having a development accelerating effect can be used, but the development accelerator is preferably a compound having at least one kind of structure selected from the group consisting of a carboxyl group, a phenolic hydroxyl group, and an alkyleneoxy group, more preferably a compound having a carboxyl group or a phenolic hydroxyl group, and most preferably a compound having a phenolic hydroxyl group.

Furthermore, the molecular weight of (Component G) development accelerator is preferably 100 to 2,000, more preferably 150 to 1,500, and particularly preferably 150 to 1,000.

Examples of the development accelerator include, as the compound having an alkyleneoxy group, polyethylene glycol, monomethyl ether of polyethylene glycol, dimethyl ether of polyethylene glycol, polyethylene glycol glyceryl ester, polypropylene glycol glyceryl ester, polypropylene glycol diglyceryl ester, polybutylene glycol, polyethylene glycol-bisphenol A ether, polypropylene glycol-bisphenol A ether, alkyl ether of polyoxyethylene, alkyl ester of polyoxyethylene, and the compounds described in JP-A-9-222724.

Examples of the compound having a carboxyl group include the compounds described in JP-A-2000-66406, JP-A-9-6001, JP-A-10-20501, JP-A-11-338150, and the like.

Examples of the compound having a phenolic hydroxyl group include the compounds described in JP-A-2005-346024, JP-A-10-133366, JP-A-9-194415, J P-A-9-222724, JP-A-11-171810, JP-A-2007-121766, JP-A-9-297396, JP-A-2003-43679, and the like. Among these, a phenol compound having 2 to 10 benzene rings is suitable, and a phenol compound having 2 to 5 benzene rings is more suitable. Particularly preferable examples include the phenolic compounds disclosed as dissolution accelerators in JP-A-10-133366.

(Component G) development accelerator may be used singly, or two or more kinds may also be used in combination.

The addition amount of (Component G) development accelerator in the photosensitive resin composition of the present invention is preferably 0.1 to 30 parts by weight, more preferably 0.2 to 20 parts by weight, and most preferably 0.5 to 10 parts by weight, based on 100 parts by weight of Component A, from the viewpoint of sensitivity and the residual film ratio.

### (Component H) Adhesion improving agent

The photosensitive resin composition of the present invention preferably contains (Component H) an adhesion improving agent.

(Component H) adhesion improving agent that can be used in the photosensitive resin composition of the present invention is a compound which enhances adhesiveness between an inorganic substance that forms a substrate, for example, a silicon compound such as silicon, silicon oxide, or silicon nitride, or a metal such as gold, copper or aluminum, and an insulating film. Specific examples include a silane coupling agent, and a thiol-based compound. The silane coupling agent as (Component H) adhesion improving agent used in the present invention is intended for the modification of the interface, and any known silane coupling agent can be used without particular limitations.

Preferable examples of the silane coupling agent include γ -aminopropyltrimethoxysilane, γ -aminopropyltriethoxysilane, γ-glycidoxypropyltrialkoxysilane, γ-glycidoxypropylalkyldialkoxysilane, γ -methacryloxypropyltrialkoxysilane, γ-methacryloxypropylalkyldialkoxysilane, γ -chloropropyltrialkoxysilane, γ-mercaptopropyltrialkoxysilane, β -(3,4-epoxycyclohexyl)ethyltrialkoxysilane, and vinyltrialkoxysilane.

Among these, γ-glycidoxypropyltrialkoxysilane, and γ -methacryloxypropyltrialkoxysilane are more preferable, and γ -glycidoxypropyltrialkoxysilane is yet more preferable.

These can be used singly, or in combination of two or more kinds. These are effective in the enhancement of the adhesiveness to the substrate, and are also effective in the regulation of the taper angle with the subsrate.

The content of (Component H) adhesion improving agent in the photosensitive resin composition of the present invention is preferably 0.1 to 20 parts by weight, and more preferably 0.5 to 10 parts by weight, based on 100 parts by weight of Component A.

### (Component I) Basic compound

The photosensitive resin composition of the present invention preferably contains (Component I) a basic compound.

As (Component I) basic compound, any compound among those used in chemically amplified resists can be selected and used. Examples include an aliphatic amine, an aromatic amine, a heterocyclic amine, a quaternary ammonium hydroxide, and a quaternary ammonium salt of a carboxylic acid.

Examples of the aliphatic amine include trimethylamine, diethylamine, triethylamine, di-*n*-propylamine, tri-n-propylamine, di-*n*-pentylamine, tri-*n*-pentylamine, diethanolamine, triethanolamine, dicyclohexylamine, and dicyclohexylmethylamine.

Examples of the aromatic amine include aniline, benzylamine, *N,N*-dimethylaniline, and diphenylamine.

Examples of the heterocyclic amine include pyridine, 2-methylpyridine, 4-methylpyridine, 2-ethylpyridine, 4-ethylpyridine, 2-phenylpyridine, 4-phenylpyridine, *N*-methyl-4-phenylpyridine, 4-dimethylaminopyridine, imidazole, benzimidazole, 4-methylimidazole, 2-phenylbenzimidazole, 2,4,5-triphenylimidazole, nicotine, nicotinic acid, nicotinic acid amide, quinoline, 8-oxyquinoline, pyrazine, pyrazole, pyridazine, purine, pyrrolidine, piperidine, cyclohexylmorpholinoethylthiourea, piperazine, morpholine, 4-methylmorpholine, 1,5-diazabicyclo[4.3.0]-5-nonene, and 1,8-diazabicyclo[5.3.0]-7-undecene.

Examples of the quaternary ammonium hydroxide include tetramethylammonium hydroxide, tetraethylammonium hydroxide, tetra-*n*-butylammonium hydroxide, and tetra-*n*-hexylammonium hydroxide.

Examples of the quaternary ammonium salt of a carboxylic acid include tetramethylammonium acetate, tetramethylammonium benzoate, tetra-n-butylammonium acetate, and tetra-*n*-butylammonium benzoate.

The basic compound that can be used in the present invention may be used singly, or two or more kinds may be used in combination. However, it is preferable to use two or more kinds in combination, it is more preferable to use two kinds in combination, and it is yet more preferable to use two kinds of heterocyclic amines in combination.

The content of (Component I) basic compound in the photosensitive resin composition of the present invention is preferably 0.001 to 1 part by weight, and more preferably 0.002 to 0.2 parts by weight, based on 100 parts by weight of Component A.

### (Component J) Surfactant (fluorine-based surfactant, silicone-based surfactant, or the like)

The photosensitive resin composition of the present invention preferably contains (Component J) a surfactant (a fluorine-based surfactant, a silicone-based surfactant, or the like).

A preferable example of the surfactant may be a copolymer (3) including a constituent unit A and a constituent unit B represented by the following formulae. The weight average molecular weight (Mw) of the copolymer is preferably from 1,000 to 10,000, and more preferably from 1,500 to 5,000. The weight average molecular weight is a value measured by gel permeation chromatography (GPC) and calculated relative to polystyrene standards.

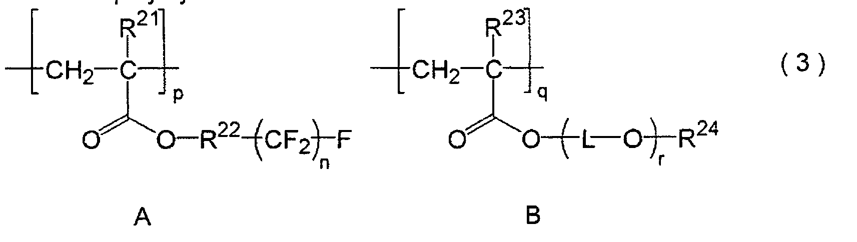

In the copolymer (3), R²¹ and R²³ each independently represent a hydrogen atom or a methyl group; R²² represents a linear alkylene group having from 1 to 4 carbon atoms; R²⁴ represents a hydrogen atom or an alkyl group having from 1 to 4 carbon atoms; L represents an alkylene group having from 3 to 6 carbon atoms; p and q represent weight percentages representing polymerization ratios, while p represents a value of from 10 wt% to 80 wt%, and q represents a value of from 20 wt% to 90 wt%; r represents an integer from 1 to 18; and n represents an integer from 1 to 10.

L in the constituent unit B is preferably an alkylene group represented by the following formula (4).

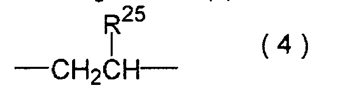

In the formula (4), R²⁵ represents an alkyl group having from 1 to 4 carbon atoms, and from the viewpoints of compatibility and wettability to the surface to be coated, an alkyl group having from 1 to 3 carbon atoms is preferable, and an alkyl group having 2 or 3 carbon atoms is more preferable.

Furthermore, the sum of p and q (p+q) is preferably such that p + q = 100, that is, 100wt%.

Specific examples of the fluorine-based surfactant and the silicone-based surfactant include the surfactants described in JP-A-62-36663, JP-A-61-226746, JP-A-61-226745, JP-A-62-170950, JP-A-63-34540, JP-A-7-230165, JP-A-8-62834, JP-A-9-54432, JP-A-9-5988, JP-A-2001-330953, and the like, and commercially available surfactants can also be used. Examples of commercially available surfactants that can be used include fluorine-based surfactants such as EFTOP EF301 and EF303 (all manufactured by Mitsubishi Materials Electronic Chemicals Co., Ltd.), FLUORAD FC430 and 431 (all manufactured by Sumitomo 3M, Ltd.), MEGAFAC F171, F173, F176, F189 and R08 (all manufactured by DIC Corp.), SURFLON S-382, SC101, 102, 103, 104, 105 and 106 (all manufactured by Asahi Glass Co., Ltd.), and POLYFOX series (manufactured by OMNOVA Solutions, Inc.); and silicone-based surfactants. Furthermore, Polysiloxane Polymer KP-341 (manufactured by Shin-Etsu Chemical Co., Ltd.) can also be used as a silicone-based surfactant.

These surfactants can be used singly, or as mixtures of two or more kinds. Furthermore, fluorine-based surfactants and silicone-based surfactants may also be used in combination.

The addition amount of (Component J) surfactant (a fluorine-based surfactant, a silicone-based surfactant, or the like) in the photosensitive resin composition of the present invention is preferably 10 parts by weight or less, more preferably 0.01 to 10 parts by weight, and yet more preferably 0.01 to 1 part by weight, based on 100 parts by weight of Component A.

### (Component K) Antioxidant

The photosensitive resin composition of the present invention may contain (Component K) an antioxidant.

As (Component K) antioxidant, the photosensitive resin composition can contain a known antioxidant. When (Component K) antioxidant is added, coloration of the cured film can be prevented. The antioxidant also advantages that it can also reduce a decrease in the film thickness due to decomposition, and has excellent heat resistance and transparency.

Examples of such an antioxidant include phosphorus-based antioxidants, hydrazides, hindered amine-based antioxidants, sulfur-based antioxidants, phenol-based antioxidants, ascorbic acid compounds, zinc sulfate, sugars, nitrites, sulfites, thiosulfates, and hydroxylamine derivatives. Among these, phenol-based antioxidants are particularly preferable from the viewpoint of the coloration of the cured film and a decrease in the film thickness. These may be used singly, or may be used in combination of two or more kinds.

Examples of commercially available products of the phenolic antioxidants include ADK STAB AO-60, ADK STAB AO-80 (all manufactured by Adeka Corp.), and IRGANOX 1098 (manufactured by Ciba-Geigy Japan, Ltd.).

The content of (Component K) antioxidant is preferably 0.1 wt% to 6 wt%, more preferably 0.2 wt% to 5 wt%, and particularly preferably 0.5 wt% to 4 wt%, based on the total solids content of the photosensitive resin composition. When the content is in this range, sufficient transparency of the formed film is obtained, and the sensitivity at the time of pattern formation also becomes satisfactory.

Furthermore, various ultraviolet absorbents, metal inactivators and the like described in "Kobunshi Tenkazai no Shintenkai (New Development of Polymer Additives; Nikkan Kogyo Shimbun, Ltd.)" may also be added to the photosensitive resin composition of the present invention, as additives other than the antioxidant.

### (Component L) Plasticizer

The photosensitive resin composition of the present invention may contain (Component L) a plasticizer.

Examples of (Component L) plasticizer include dibutyl phthalate, dioctyl phthalate, didodecyl phthalate, polyethylene glycol, glycerin, dimethyl glycerin phthalate, dibutyl stannate, dioctyl adipate, and triacetylglycerin.

The content of (Component L) plasticizer in the photosensitive resin composition of the present invention is preferably 0.1 to 30 parts by weight, and more preferably 1 to 10 parts by weight, based on 100 parts by weight of Component A.

### (Component M) Thermal radical generator

The photosensitive resin composition of the present invention may contain (Component M) a thermal radical generator, and when the composition contains an ethylenic unsaturated compound such as a compound having at least one ethylenic unsaturated double bond described above, it is preferable that the composition contain (Component M) thermal radical generator.

As the thermal radical generator, a known thermal radical generator can be used.

The thermal radical generator is a compound which generates a radical under the action of thermal energy, and initiates or accelerates the polymerization reaction of a polymerizable compound. When the thermal radical generator is added, the cured film thus obtained becomes tougher, and heat resistance and solvent resistance may increase.

Preferable examples of the thermal radical generator include aromatic ketones, onium salt compounds, organic peroxides, thio compounds, hexaarylbiimidazole compounds, keto oxime ester compounds, borate compounds, azinium compounds, metallocene compounds, active ester compounds, compounds having a carbon-halogen bond, azo compounds, and bibenzyl compounds.

(Component M) thermal radical generator may be used singly, or can also be used in combination of two or more kinds.

The content of (Component M) thermal radical generator in the photosensitive resin composition of the present invention is preferably 0.01 to 50 parts by weight, more preferably 0.1 to 20 parts by weight, and most preferably 0.5 to 10 parts by weight, based on 100 parts by weight of Component A, from the viewpoint of an enhancement of the film properties.

### (Component N) Thermal acid generator

According to the present invention, (Component N) a thermal acid generator may be used to improve the film properties and the like under low temperature curing.

The thermal acid generator is a compound which generates an acid under the action of heat, and is preferably a compound having a thermal decomposition point in the range of 130°C to 250°C, and more preferably 150°C to 220°C. For example, the thermal acid generator is a compound which generates a less nucleophilic acid such as sulfonic acid, carboxylic acid, or disulfonylimide.

The acid to be generated is preferably strong sulfonic acid having a pKa value of 2 or less, an alkylcarboxylic acid or arylcarboxylic acid substituted with an electron-withdrawing group, or disulfonylimide substituted with a similar electron-withdrawing group. Examples of the electron-withdrawing group include a halogen atom such as a fluorine atom, a haloalkyl group such as a trifluoromethyl group, a nitro group, and a cyano group.

According to the present invention, it is also preferable to use a sulfonic acid ester which substantially does not generate an acid under irradiation of exposure light, but generates an acid under the action of heat.

That an acid is substantially not generated under irradiation of exposure light can be judged by measuring the IR spectrum and the NMR spectrum before and after the exposure of the compound, and observing if there is no change in the spectra.

The molecular weight of the thermal acid generator is preferably 230 to 1,000, and more preferably 230 to 800.

For the sulfonic acid ester that can be used in the present invention, a commercially available product may be used, or a product synthesized by a known method may also be used. The sulfonic acid ester may be synthesized by, for example, allowing sulfonyl chloride or sulfonic acid anhydride to react with a corresponding polyhydric alcohol under basic conditions.

The content of the photosensitive resin composition of the thermal acid generator is preferably 0.5 to 20 parts by weight, and particularly preferably 1 to 15 parts by weight, based on 100 parts by weight of Component A.

### (Component O) Acid amplifier

The photosensitive resin composition of the present invention can use (Component O) an acid amplifier for the purpose of sensitivity enhancement. The acid amplifier used in the present invention is a compound which can further generate an acid by an acid-catalyzed reaction, and can increase the acid concentration within the reaction system, and is a compound which stably exists in the state where acid is not present. Since such a compound causes an increase in one or more acid molecules through a single reaction, the reaction proceeds in an accelerating manner along with the progress of the reaction. However, because the generated acid itself causes self-decomposition, the strength of the acid generated here is preferably 3 or less, and particularly preferably 2 or less, in terms of the acid dissociation constant, pKa.

Specific examples of the acid amplifier include the compound described in paragraphs 0203 to 0223 of JP-A-10-1508, paragraphs 0016 to 0055 of JP-A-10-282642, and page 39, line 12 to page 47, line 2 of JP-T-9-512498.

The acid amplifier that can be used in the present invention may be a compound which is decomposed by the acid generated from an acid generator, and generates an acid having a pKa value of 3 or less, such as dichloroacetic acid, trichloroacetic acid, methanesulfonic acid, benzenesulfonic acid, trifluoromethanesulfonic acid, or phenylphosphonic acid.

The content of the acid amplifier in the photosensitive resin composition is preferably set to 10 to 1,000 parts by weight from the viewpoint of dissolution contrast of exposed areas and unexposed areas, and more preferably 20 to 500 parts by weight, based on 100 parts by weight of (Component B) photo acid generator.

### (Pattern production method)

The pattern production method of the present invention is not particularly limited as long as it is a method of producing a pattern using the photosensitive resin composition of the present invention. However, the pattern production method preferably includes a film forming step of removing the solvent from the photosensitive resin composition of the present invention and thereby forming a film; an exposure step of patternwise exposing the film by an active radiation; a development step of developing the exposed film using an aqueous developer liquid to form a pattern; and a bake step of heating the pattern.

Generally, a photoresist is a temporary coating used to selectively protect a specific region on a substrate from other regions, so that the operation of the subsequent processes is carried out only at the region on the substrate that is not covered with the photoresist, and when the subsequent operation is completed, the photoresist is removed.

On the contrary, in the MEMS structural member according to the present invention, the pattern produced by using the photosensitive resin composition is not removed, and is used as a permanent structural member of the MEMS produced.

It is more preferable that the pattern production method according to the present invention include the following step of (1) to (6).
(1) A coating step of coating the photosensitive resin composition of the present invention on a substrate;
(2) A solvent removal step of removing the solvent from the applied photosensitive resin composition;
(3) An exposure step of patternwise exposing the photosensitive resin composition from which the solvent has been removed, to an active radiation;
(4) A development step of developing the exposed photosensitive resin composition using an aqueous developer liquid;
(5) A step of exposing the developed photosensitive resin composition to an active radiation (post-exposure); and
(6) A bake step of thermally curing the developed photosensitive resin composition.

The film forming step is preferably the coating step and the solvent removal step described above.

Hereinafter, the respective steps will be described in order.
(1) When the photosensitive resin composition of the present invention is applied on a predetermined substrate, and the solvent is removed under reduced pressure and/or by heating (prebake), a desired dry film can be formed. Examples of the substrate material that can be used in the present invention include silicon, silicon dioxide, silicon nitride, alumina, glass, glass-ceramics, gallium arsenide, indium phosphide, copper, aluminum, nickel, iron, steel, a copper-silicon alloy, indium tin oxide-coated glass; organic films of polyimides and polyesters; and any substrates including patterned regions of metal, semiconductors and insulating materials, but the examples are not limited to these. Depending on the occasion, a bake step can be carried out on the substrate, before the photosensitive resin composition of the present invention is applied, in order to remove the absorbed moisture. There are no particular limitations on the coating method, and for example, methods such as a slit coating method, a spray method, a roll coating method, and a rotary coating method can be used. In the case of a large-sized substrate, a slit coating method is preferable among others. Here, the large-sized substrate means a substrate having a size which measures 1 m or larger on each side.

In the solvent removal step of (2), the solvent is removed from the film applied under reduced pressure (vacuum) and/or by heating, and thereby a dry coating film is formed on the substrate. The heating conditions are such that the acid-decomposable group in the monomer unit (a1) of Component A at the unexposed area is decomposed, while Component A is not made soluble in an alkali developer liquid. The heating conditions may vary depending on the types or mixing ratios of the various Components, but are preferably about 30 to 300 seconds at 70°C to 120°C.

The photosensitive resin composition of the present invention is suitably used as a so-called thick film resist or a so-called thick film MEMS structural member, which have a film thickness after drying of 4 µm or greater. This is because, since the present invention has high sensitivity, shape controllability is satisfactory. The film thickness is preferably 4 to 500 µm, and particularly preferably 4 to 100 µm.

In the (3) exposure step, the substrate provided with a dry coating film is irradiated with an active radiation. The exposure may be carried out via a mask, or a predetermined pattern may be directly drawn. An active radiation having a wavelength of from 300 nm to 450 nm can be used preferably. After the exposure step, post-exposure bake (PEB) is carried out as necessary.

For the exposure to an active radiation, a low pressure mercury lamp, a high pressure mercury lamp, an ultrahigh pressure mercury lamp, a chemical lamp, a laser generating apparatus, an LED light source or the like can be used.

In the case of using a mercury lamp, an active radiation having a wavelength of g-line (436 nm), i-line (365 nm), or h-line (405 nm) can be preferably used. A mercury lamp is more advantageous than laser light from the viewpoint that the mercury lamp is appropriate for exposure of a large area.

When a laser is used, 343 nm and 355 nm are used in the case of a solid (YAG) laser, and 351 nm (XeF) is used in the case of an excimer laser. Furthermore, 375 nm and 405 nm are used in the case of a semiconductor laser. Among these, 355 nm and 405 nm are more preferable from the viewpoints of stability and cost. Laser light can be irradiated on the coating film in a single dose or in several divided doses.

The energy density per pulse of laser light is preferably from 0.1 mJ/cm² to 10,000 mJ/cm². In order to sufficiently cure the coating film, an energy density of 0.3 mJ/cm² or greater is more preferable, and 0.5 mJ/cm² or greater is most preferable. In order to prevent the decomposition of the coating film due to an abrasion phenomenon, an energy density of 1,000 mJ/cm² or less is more preferable, and 100 mJ/cm² or less is most preferable. Furthermore, the pulse width is preferably from 0.1 nsec to 30,000 nsec. In order to prevent the decomposition of a color coating film due to an abrasion phenomenon, a pulse width of 0.5 nsec or longer is more preferable, and 1 nsec or longer is most preferable. In order to increase the alignment accuracy at the time of scan exposure, a pulse width of 1,000 nsec or shorter is more preferable, and 50 nsec or shorter is most preferable.

Furthermore, the frequency of the laser is preferably from 1 Hz to 50,000 Hz. In order to shorten the exposure treatment time, the frequency is more preferably 10 Hz or greater, and most preferably 100 Hz or greater. In order to increase the alignment accuracy at the time of scan exposure, the frequency is more preferably 10,000 Hz or less, and most preferably 1,000 Hz or less.

A laser is more advantageous than a mercury lamp, from the viewpoint that focusing is easy, a mask for the pattern formation in the exposure step is unnecessary, and the cost can be reduced.

The exposing apparatus that can be used in the present invention is not particularly limited, but commercially available products such as Callisto (manufactured by V Technology Co., Ltd.), AEGIS (manufactured by V Technology Co., Ltd.), DF2200G (manufactured by Dainippon Screen Co., Ltd.) or the like can be used. Apparatuses other than those described above can also be suitably used.

Furthermore, if necessary, the irradiation light can also be regulated through a spectrometric filter such as a long wavelength cutoff filter, a short wavelength cutoff filter, or a band pass filter.

In order to accelerate the decomposition reaction described above in an area produced by an acid catalyst, PEB (post-exposure bake) can be carried out as necessary. Production of a carboxyl group from an acid-decomposable group can be accelerated through the PEB.

The acid-decomposable group in the monomer unit (a1) according to the present invention has low activation energy for acid decomposition, and is easily decomposed by the acid originating from the acid generator due to exposure, so that a positive image can be formed by development without necessarily performing PEB to produce a carboxyl group.

In addition, when the PEB is carried out at a relatively low temperature, hydrolysis of the acid-decomposable group can also be accelerated without causing a crosslinking reaction. When the PEB is carried out, the temperature is preferably from 30°C to 130°C, more preferably from 40°C to 110°C, and particularly preferably from 50°C to 90°C.

In the development step of (4), Component A having a free carboxyl group is developed using an alkaline developer liquid. When the exposed area containing the resin composition having a carboxyl group which is easily dissolved by the alkaline developer liquid is removed, a positive image is formed.

As the basic compound that can be used in the alkaline developer liquid, for example, aqueous solutions of alkali metal hydroxides such as lithium hydroxide, sodium hydroxide, and potassium hydroxide; alkali metal carbonates such as sodium carbonate and potassium carbonate; alkali metal hydrogen carbonates such as sodium hydrogen carbonate and potassium hydrogen carbonate; ammonium hydroxides such as tetramethylammonium hydroxide, tetraethylammonium hydroxide, and choline hydroxide; sodium silicate and sodium metasilicate can be used. Furthermore, an aqueous solution prepared by adding an appropriate amount of a water-soluble organic solvent such as methanol or ethanol, or a surfactant to an aqueous solution of an alkali can also be used as the developer liquid.

The pH of the developer liquid is preferably 10.0 to 14.0.

The development time is preferably 30 to 180 seconds, and the technique of development may be any of a paddling method, a dipping method, a showering method and the like. After the development, it is preferable to perform washing under flowing water for 10 to 90 seconds, and to thereby form a desired pattern.

(5) Prior to the heat treatment, it is preferable to expose the substrate with a pattern formed thereon by re-exposure (post) to an active radiation, to generate an acid from (Component B) photo acid generator that is present in the unexposed area, and to thereby making the acid to function as a catalyst for accelerating crosslinking.

That is, the method for forming a cured film according to the present invention preferably includes a re-exposure step of re-exposing the substrate to an active radiation, between the development step and the bake step.

The exposure in the re-exposure step may be carried out by the same means as that used in the exposure step, but in the re-exposure step, it is preferable to perform full-area exposure on the side of the substrate where a film has been formed using the photosensitive resin composition of the present invention. A preferable dose of exposure for the re-exposure step is 100 to 1,000 mJ/cm².

In the base step of (6), when the resulting positive image is heated, a cured film can be formed by thermally decomposing the acid-decomposable group in the monomer unit (a1) to produce a carboxyl group, and crosslinking the carboxyl group with an epoxy group and/or an oxetanyl group. Furthermore, when (Component D) thermal crosslinking agent is used, it is preferable to thermally cross-link the thermal crosslinking agent as well in the bake step.

In order to obtain a profile that is rectangular or close to a rectangle, so-called two-stage baking is performed in which heating is carried out in two stages at different temperatures. The film is cured to a certain extent by the first stage baking to determine the shape, and the film is further baked by the second stage baking so that necessary durability can be imparted. The temperature for the first stage baking is 90°C to 150°C, and the time is preferably 10 to 60 minutes. The temperature for the second stage baking is 180°C to 250°C, and the time is preferably 30 to 90 minutes.

The taper angle for the cross-sectional shape of the pattern after the bake step is preferably 60° or greater, more preferably 70° or greater, and particularly preferably 80° or greater.

Since a profile that is rectangular or close to a rectangle can be obtained even after the bake step by using the photosensitive resin composition of the present invention, the pattern obtained by exposing, developing and thermally curing the photosensitive resin composition of the present invention is useful as an etching resist or a MEMS structural member in particular.

### (MEMS structure and method for production thereof, dry etching method, wet etching method, MEMS shutter device, and image display apparatus)

The method for producing a MEMS (Micro Electro Mechanical System) structure of the present invention preferably includes a step of producing a structure using a pattern produced by the pattern production method of the present invention as a sacrificial layer at the time of lamination of the structure; and a step of removing the sacrificial layer by a plasma treatment.

The MEMS structure of the present invention is a MEMS structure produced by using a pattern produced by the pattern production method of the present invention as a sacrificial layer at the time of lamination of the structure.

The MEMS shutter device of the present invention is a MEMS shutter device produced by the method for producing a MEMS structure of the present invention.

The image forming apparatus of the present invention preferably includes the MEMS shutter device of the present invention.

A MEMS (Micro Electro Mechanical System) refers to an electromechanical element or system having a microscopic structure having a size in the micrometer-scale, or a micromachine, and an example thereof may be a device in which a mechanical driving part, a sensor, an actuator, and an electronic circuit are integrated on a silicon substrate, a glass substrate or an organic material.

Furthermore, examples of the MEMS shutter device and the image forming apparatus including a MEMS shutter device include those described in JP-T-2008-533510.

When a pattern produced by the pattern production method of the present invention is used as a sacrificial layer for the production of a MEMS structure, an inorganic substance such as a metal, a metal oxide, a silicon compound or a semiconductor, or an organic substance such as polyimide can be laminated on the pattern using various film-forming processes such as coating, deposition, sputtering, chemical vapor deposition (CVD), and plating. Also, different materials of two or more kinds can be laminated into multiple layers.

Examples of the base material for the MEMS sacrificial layer that can be used in the present invention include silicon, silicon dioxide, silicon nitride, alumina, glass, glass-ceramic, gallium arsenide, indium phosphide, copper, aluminum, nickel, iron, steel, copper-silicon alloy, indium tin oxide-coated glass; an organic films of polyimides and polyesters; and any substrates including a patterned region of a metal, a semiconductor and an insulating material, but the base material is not limited to these. Depending on the situation, a bake step can be carried out on the substrate before the photosensitive resin composition of the present invention is applied, in order to remove absorbed moisture.

When a pattern produced by the pattern production method of the present invention is used as a dry etching resist, a dry etching treatment such as ashing, plasma etching, or ozone etching can be carried out as an etching treatment. Particularly, it is preferable to use the pattern as an etching resist for a dry etching process using a fluorine-based gas.

The dry etching method of the present invention preferably includes a step of performing dry etching using a pattern produced by the pattern production method of the present invention as a resist for dry etching; and a step of removing the pattern by a plasma treatment or a chemical treatment.

Examples of the material to be dry etched that can be used in the present invention include silicon, silicon dioxide, silicon nitride, alumina, glass, glass-ceramic, gallium arsenide, indium phosphide, copper, aluminum, nickel, iron, steel, copper-silicon alloy, indium tin oxide-coated glass; an organic films of polyimides and polyesters; and any substrates including a patterned region of a metal, a semiconductor and an insulating material, but the base material is not limited to these.

The method of generating plasma is not particularly limited, and a reduced pressure plasma method and an atmospheric plasma method can all be applied.

For the plasma etching, for example, an inert gas selected from helium, argon, krypton and xenon; O₂, CF₄, C₂F₄, N₂, CO₂, SF₆, CHF₃, or a reactive gas containing at least O, N, F or Cl can be preferably used.

When a pattern produced by the pattern production method of the present invention is used as a wet etching resist, a wet etching treatment using a well known agent such as an acid, an alkali or a solvent can be carried out.

The wet etching method of the present invention preferably includes a step of performing wet etching using a pattern produced by the pattern production method of the present invention as a resist for wet etching; and a step of removing the pattern by a plasma treatment or a chemical treatment.

Furthermore, examples of the material to be wet etched that can be used in the present invention include silicon, silicon dioxide, silicon nitride, alumina, glass, glass-ceramic, gallium arsenide, indium phosphide, copper, aluminum, nickel, iron, steel, copper-silicon alloy, indium tin oxide-coated glass; an organic films of polyimides and polyesters; and any substrates including a patterned region of a metal, a semiconductor and an insulating material, but the base material is not limited to these.

Examples of the wet etching treatment include an oxidation etching treatment using an aqueous solution of sodium permanganate, a strong alkali aqueous solution treatment using sodium hydroxide, and a hydrofluoric acid treatment.

When the pattern is peeled after the production of a MEMS or after the etching treatment, peeling can be carried out by a well known dry plasma process such as ashing, or a well known wet process such as an alkali chemical treatment. Since the cured product of the present invention has been cured through a bake step, peeling by a dry plasma process is particularly preferable.

When the pattern is used as a sacrificial layer for MEMS, it is preferable to perform peeling by a dry process, in order to remove the resist from the complicated shape of the MEMS. Particularly, an oxygen plasma treatment is preferable.

When the pattern is used as a planar resist as a resist for wet etching or dry etching, an oxygen plasma treatment is suitably used, but it is also possible to peel and remove the resist by a heating treatment using a chemical liquid .

The MEMS structure of the present invention is a structure containing a mechanical driving part, and when a resist pattern formed using the photosensitive resin composition of the present invention is used as a permanent film, the MEMS structure is incorporated as a partition wall of a structure or as a part of the mechanical driving part. Such a MEMS structure is used as, for example, a surface acoustic wave (SAW) filter, a bulk acoustic wave (SAW) filter, or a part for a gyrosensor, a microshutter for display, an image sensor, an electronic paper, an inkjet head, a biochip, a sealant, or the like.

When a pattern produced by the pattern production method of the present invention is used as a MEMS structure, an inorganic substance such as a metal, a metal oxide, a silicon compound or a semiconductor, or an organic substance such as polyimide can be laminated on the pattern using various film-forming processes such as coating, deposition, sputtering, CVD, and plating. Also, different materials of two or more kinds can be laminated into multiple layers.

Examples of the base material for the MEMS structure that can be used in the present invention include silicon, silicon dioxide, silicon nitride, alumina, glass, glass-ceramic, gallium arsenide, indium phosphide, copper, aluminum, nickel, iron, steel, copper-silicon alloy, indium tin oxide-coated glass; an organic films of polyimides and polyesters; and any substrates including a patterned region of a metal, a semiconductor and an insulating material, but the base material is not limited to these. Depending on the situation, a bake step can be carried out on the substrate before the photosensitive resin composition of the present invention is applied, in order to remove absorbed moisture.

Examples of the MEMS include the micromachine members described in JP-A-2000-343463, and the magnetic actuator parts described in JP-A-2001-71299.

The method for producing a MEMS structure of the present invention preferably uses a pattern produced by the pattern production method of the present invention as a member for a MEMS structure.

The MEMS structure of the present invention preferably has a pattern produced by the pattern production method of the present invention as a member of the MEMS structure.

### EXAMPLES

Next, the present invention will be described more specifically based on Examples. However, the present invention is not intended to be limited to these Examples. Unless particularly stated otherwise, "parts" and "percent (%)" are on a weight basis.

In the following Synthesis Examples, the following abbreviations represent the following compounds.
V-55: 2,2'-Azobis(2,4-dimethylvaleronitrile)
GMA: Glycidyl methacrylate
PGMEA: Propylene glycol monomethyl ether acetate

### <Synthesis of polymer A-1>

0.5 parts of phenothiazine was added to 144.2 parts (2 molar equivalents) of ethyl vinyl ether, and while the reaction system was cooled to 10°C or below, 86.1 parts (1 molar equivalent) of methacrylic acid was added dropwise thereto. Subsequently, the reaction system was stirred for 4 hours at room temperature (25°C). 5.0 parts of pyridinium p-toluenesulfonate was added to the system, and then the mixture was stirred for 2 hours at room temperature and left to stand overnight at room temperature. 5 parts of sodium hydrogen carbonate and 5 parts of sodium sulfate were added to the reaction liquid, and the mixture was stirred for 1 hour at room temperature. Insoluble materials were filtered, and then the filtrate was concentrated under reduced pressure at 40°C. A residual yellow oily substance was distilled under reduced pressure, and 134.0 parts of 1-ethoxyethyl methacrylate in a fraction having a boiling point (bp.) of 43°C to 45°C/7 mmHg was obtained as a colorless oily substance.

A mixed solution of 116.2 parts (0.7 molar equivalents) of 1-ethoxyethyl methacrylate thus obtained, 42.6 parts (0.3 molar equivalents) of GMA, and 132.5 parts of PGMEA was heated to 70°C under a nitrogen gas stream. While this mixed solution was stirred, a mixed solution of a radical polymerization initiator V-65 (manufactured by Wako Pure Chemical Industries, Ltd., 12.4 parts) and 100.0 parts of PGMEA was added dropwise to the mixed solution over 2.5 hours. After completion of the dropwise addition, the reaction solution was allowed to react for 4 hours at 70°C, and thereby a PGMEA solution of a polymer A-1 (solids concentration: 40%) was obtained. The weight average molecular weight (Mw) of the polymer A-1 thus obtained, as measured by gel permeation chromatography (GPC), was 22,000.

### <Synthesis of polymers A-2 to A-34>

Polymers A-2 to A-34 were respectively synthesized in the same manner as in the synthesis of the polymer A-1, except that the various monomers used in the synthesis of the polymer A-1 were changed to the monomers forming the respective monomer units (a1) to (a5) described in Table 1, and the use amounts of the monomers forming the respective monomer units were changed as described in Table 1. The addition amount of the radical polymerization initiator V-65 was adjusted to obtain the molecular weight described in Table 1.

**(Table 1)**

| Polymer | Monomer unit(a1) | | Monomer unit (a2) | | Monomer unit (a3) | | | | Monomer unit (a4) | | | | Solvent | Mw |
|---|---|---|---|---|---|---|---|---|---|---|---|---|---|---|
| | Type | Molar ratio | Type | Molar ratio | Type | Molar ratio | Type | Molar ratio | Type | Molar ratio | Type | Molar ratio | | |
| A-1 | MAEVE | 70 | GMA | 30 | - | - | - | - | - | - | - | - | C1 | 22,000 |
| A-2 | MATHF | 70 | GMA | 30 | - | - | - | - | - | - | - | - | C1 | 22,000 |
| A-3 | MATHF | 50 | GMA | 30 | - | - | - | - | HEMA | 20 | - | - | C1 | 22,000 |
| A-4 | MATHF | 50 | GMA | 30 | - | - | - | - | - | - | MAA | 20 | C1 | 22,000 |
| A-5 | MATHF | 50 | OXE-30 | 30 | - | - | - | - | HEMA | 20 | - | - | C1 | 22,000 |
| A-6 | MATHF | 50 | OXE-30 | 30 | - | - | - | - | - | - | MAA | 20 | C1 | 22,000 |
| A-7 | MAEVE | 40 | GMA | 30 | St | 20 | - | - | HEMA | 10 | - | - | C1 | 22,000 |
| A-8 | MACHOE | 40 | GMA | 30 | St | 20 | - | - | HEMA | 10 | - | - | C1 | 22,000 |
| A-9 | MAEVE | 40 | GMA | 30 | St | 20 | DCPM | 10 | - | - | - | - | C1 | 22,000 |
| A-10 | MACHOE | 40 | GMA | 30 | St | 20 | DCPM | 10 | - | - | - | - | C1 | 22,000 |
| A-11 | MAEVE | 40 | GMA | 30 | - | - | - | - | HEMA | 20 | MAA | 10 | C1 | 22,000 |
| A-12 | MATHF | 40.5 | GMA | 37.5 | - | - | - | - | HEMA | 12.5 | MAA | 9.5 | C1 | 48,000 |
| A-13 | MAEVE | 40 | OXE-30 | 30 | - | - | - | - | HEMA | 20 | MAA | 10 | C1 | 7,500 |
| A-14 | MAEVE | 40 | OXE-30 | 30 | - | - | - | - | HEMA | 20 | MAA | 10 | C1 | 15,500 |
| A-15 | MAEVE | 40 | OXE-30 | 30 | - | - | - | - | HEMA | 20 | MAA | 10 | C1 | 22,000 |
| A-16 | MATHF | 40.5 | OXE-30 | 37.5 | - | - | - | - | HEMA | 12.5 | MAA | 9.5 | C1 | 7,500 |
| A-17 | MATHF | 40.5 | OXE-30 | 37.5 | - | - | - | - | HEMA | 12.5 | MAA | 9.5 | C1 | 15,500 |
| A-18 | MATHF | 40.5 | OXE-30 | 37.5 | - | - | - | - | HEMA | 12.5 | MAA | 9.5 | C1 | 22,000 |
| A-19 | MATHF | 40.5 | OXE-30 | 37.5 | - | - | - | - | HEMA | 12.5 | MAA | 9.5 | C1 | 30,000 |
| A-20 | MATHF | 40.5 | OXE-30 | 37.5 | - | - | - | - | HEMA | 12.5 | MAA | 9.5 | C1 | 48,000 |
| A-21 | MATHF | 30.5 | OXE-30 | 47.5 | - | - | - | - | HEMA | 12.5 | MAA | 9.5 | C1 | 22,000 |
| A-22 | MATHF | 30.5 | OXE-30 | 37.5 | - | - | - | - | HEMA | 22.5 | MAA | 9.5 | C1 | 22,000 |
| A-23 | MATHF | 20.5 | OXE-30 | 47.5 | - | - | - | - | HEMA | 22.5 | MAA | 9.5 | C1 | 22,000 |
| A-24 | MATHF | 20.5 | OXE-30 | 37.5 | - | - | - | - | HEMA | 32.5 | MAA | 9.5 | C1 | 22,000 |
| A-25 | MATHF | 30.5 | OXE-30 | 37.5 | St | 10 | - | - | HEMA | 12,5 | MAA | 9.5 | C1 | 22,000 |
| A-26 | MATHF | 20.5 | OXE-30 | 37.5 | St | 10 | - | - | HEMA | 22.5 | MAA | 9.5 | C1 | 22,000 |
| A-27 | Protected phenol 1 | 40.5 | OXE-30 | 37.5 | - | - | - | - | HEMA | 12.5 | MAA | 9.5 | C1 | 22,000 |
| A-28 | Protected phenol 1 | 30.5 | OXE-30 | 37.5 | - | - | - | - | HEMA | 22.5 | MAA | 9.5 | C1 | 22,000 |
| A-29 | MATHF | 63 | - | - | - | - | - | - | HEMA | 27.5 | MAA | 9.5 | C1 | 22,000 |
| A-30 | MATHF | 63 | - | - | St | 20 | - | - | HEMA | 7.5 | MAA | 9.5 | C1 | 22,000 |
| A-31 | MATHF | 63 | - | - | St | 37 | - | - | - | - | - | - | C1 | 22,000 |
| A-32 | - | - | OXE-30 | 70 | - | - | - | - | HEMA | 20 | MAA | 10 | C1 | 22,000 |
| A-33 | - | - | OXE-30 | 70 | St | 20 | - | - | - | - | MAA | 10 | C1 | 22,000 |
| A-34 | - | - | OXE-30 | 70 | St | 30 | - | - | - | - | - | - | C1 | 22,000 |

The molar ratio described in Table 1 is a copolymerization ratio of the monomer units derived from the various monomers described in the Type column. The symbol "-" in Table 1 indicates that the relevant monomer unit is not used.

The abbreviations in Table 1 are as follows.
MAEVE: 1-Ethoxyethyl methacrylate
MATHF: Tetrahydrofuran-2-yl methacrylate
MACHOE: 1-(Cyclohexyloxy)ethyl methacrylate
GMA: Glycidyl methacrylate
OXE-30: (3-Ethyloxetan-3-yl)methyl methacrylate (manufactured by Osaka Organic Chemical Industry, Ltd.)
Protected phenol 1: An ethyl acetal protected compound of a phenolic hydroxyl group obtained by the following Synthesis Example.
St: Styrene
DCPM: Dicyclopentanyl methacrylate
HEMA: 2-Hydroxyethyl methacrylate
MAA: Methacrylic acid
C-1: Propylene glycol monomethyl ether acetate

### <Synthesis of protected phenol 1 (ethyl acetal protected body of 4-hydroxybenzoic acid (2-methacryloyloxyethyl) ester)>

To a solution of 21 g of 4-hydroxybenzoic acid (2-hydroxyethyl) ester in 100 ml of acetonitrile, 20 ml of N,N-dimethylacetamide was added under stirring, and 20 g of methacrylic acid chloride was further added thereto. The mixture was allowed to react while stirred for 8 hours at 35°C, and then the reaction mixture was poured into ice water. Precipitated crystals were collected by filtration, and were recrystallized from ethyl acetate/n-hexane. Thus, 4-hydroxybenzoic acid (2-methacryloyloxyethyl) ester was obtained.

The phenol thus obtained as described above was allowed to react with ethyl vinyl ether in the presence of an acid catalyst, and thereby an ethyl acetal protected body of a phenolic hydroxyl group (protected phenol 1) was obtained.

### (Examples 1-1 to 1-85, and Comparative Examples 1-1 to 1-6)

### (1) Preparation of photosensitive resin composition

The various Components shown in the following Table 2-1 to Table 4-1 were mixed to obtain homogeneous solutions, and then each of the solutions was filtered using a polytetrafluoroethylene filter having a pore size of 0.1 µm. Thus, the photosensitive resin compositions of Examples 1-1 to 1-85 and Comparative Examples 1-1 to 1-6 were prepared. The following evaluations were respectively carried out using the photosensitive resin compositions of Examples 1-1 to 1-85 and Comparative Examples 1-1 to 1-6 thus obtained. The evaluation results are shown in Table 2-2 to Table 4-2.

### <Evaluation of photosensitive resin compositions>

### (1) Evaluation of sensitivity (no PEB)

A photosensitive resin composition was spin coated on a silicon wafer having a silicon oxide film, and then the silicon wafer was pre-baked on a hot plate at 90°C for 120 seconds. Thus, a coating film having a thickness of 4 µm was formed.

Subsequently, the film was exposed through a predetermined mask using an i-line stepper (FPA-3000 i5⁺ manufactured by Canon, Inc.). After the exposure, the substrate was left to stand for 10 minutes at room temperature, and then was developed by a paddling method using a 0.4% aqueous solution of tetramethylammonium hydroxide at 23°C for 60 seconds. The substrate was rinsed with ultrapure water for 45 seconds. The optimum exposure amount (Eopt) which was capable of resolution of a line-and-space pattern with a line width of 10 µm at 1:1 by these operations, was defined as sensitivity. The sensitivity is such that a smaller value indicates higher sensitivity. Particularly, an exposure amount which gives a sensitivity lower than 70 mJ/cm² is preferable. Meanwhile, PEB was not carried out.

### (2) Evaluation of taper angle and evaluation of pattern profile

A photosensitive resin composition was spin coated on a silicon wafer having a silicon oxide film, and then the silicon wafer was pre-baked on a hot plate at 90°C for 120 seconds. Thus, a coating film having a thickness of 4 µm was formed.

Subsequently, the film was exposed in an amount of 70 mJ through a predetermined mask using an i-line stepper (FPA-3000 i5⁺ manufactured by Canon, inc.). After the exposure, the substrate was left to stand for 10 minutes at room temperature, and then was developed by a paddling method using a 0.4% aqueous solution of tetramethylammonium hydroxide at 23°C for 60 seconds. The substrate was rinsed with ultrapure water for 45 seconds. Subsequently, the substrate was baked by performing a two-stage bake treatment (first stage: 140°C - 30 min, second stage: 230°C - 60 min).

Thereafter, the cross-section of a line-and-space pattern with a line width of 10 µm was observed with a scanning electron microscope (SEM), and the taper angle was measured.

Furthermore, the profile shape was evaluated based on the taper angle and the overall rectangle formability. As the profile is closer to rectangle in shape, if it is a resist for MEMS, a structure having an originally desired shape (rectangular shape) can be laminated on the resist, and if it is a resist for dry etching, the material to be etched can be accurately processed by a dry etching process. Grades 3 to 5 were considered as levels without any problem in practical used. The image of the shape is shown in FIG. 1.

In this evaluation, since it is intended to form a rectangular line-and-space pattern, a high taper angle is considered excellent as shown below. However, if the desired pattern is different, it is not necessary that the pattern be rectangular.
5: A profile that is rectangular or close to a rectangle, with a taper angle of the line cross-section being equal to or larger than 80° and equal to or less than 90°
4: A profile that is close to a rectangle, with a taper angle of the line cross-section being equal to or larger than 70° and less than 80°
3: A profile that is trapezoidal, with a taper angle of the line cross-section being equal to or larger than 60° and less than 70°
2: A profile with a taper angle of the line cross-section being equal to or larger than 40° and less than 80°
1: A profile with a taper angel of the line cross-section being less than 40° (3) Evaluation of chemical resistance

A cured film produced by the same process as that used for the evaluation of pattern profile, was immersed in a 5% aqueous solution of oxalic acid at 40°C for 10 minutes, and any changes in the film thickness before and after the immersion were evaluated. Grades 3 to 5 were considered as levels without any problem in practical used.
5: A change in the film thickness of less than ±1% occurred.
4: A change in the film thickness of equal to or more than ±1 % and less than 5% occurred.
3: A change in the film thickness of equal to or more than ±5% and less than 10% occurred.
2: A change in the film thickness of equal to or more than ±10% occurred.
1: Film peeling was confirmed.

### (4) Evaluation of development defect

A photosensitive resin composition was spin coated on a silicon wafer having a silicon oxide film, and then the silicon wafer was pre-baked on a hot plate at 90°C for 120 seconds. Thus, a coating film having a thickness of 4 µm was formed.

Subsequently, the film was exposed in an amount of 70 mJ through a predetermined mask using an i-line stepper (FPA-3000 i5⁺ manufactured by Canon, Inc.). After the exposure, the substrate was left to stand for 10 minutes at room temperature, and then was developed by a paddling method using a 0.4% aqueous solution of tetramethylammonium hydroxide at 23°C for 60 seconds. The substrate obtained after development was observed with an optical microscope, and the number of development defects was counted.
5: There was zero development defect per wafer.
4: There were 1 to 3 development defects per wafer.
3: There were 4 to 10 development defects per wafer.
2: There were 11 to 20 development defects per wafer.
1: There were 21 or more development defects per wafer.

### (5) Production of MEMS shutter display and evaluation of operation (evaluation of display unevenness)

A MEMS shutter device and a display apparatus using a 5-inch MEMS shutter device were produced according to the method described in JP-T-2008-533510 using a photosensitive resin composition obtained as a sacrificial layer. The produced display apparatus was driven, and the display unevenness was subjected to a sensory evaluation by visual inspection to perform an evaluation based on the following 5 criteria.
5: 10 or fewer display unevenness defects
4: 11 to 20 display unevenness defects
3: 21 to 50 display unevenness defects
2: 51 to 100 display unevenness defects
1: 101 or more display unevenness defects.

**(Table 2-1)**

| | Component A | | Photo acid generator | | Basic compound | | Additive | | Surfactant | | Adhesion improving agent | | Solvent | |
|---|---|---|---|---|---|---|---|---|---|---|---|---|---|---|
| | Type | Parts | Type | Parts | Type | Parts | Type | Parts | Type | Parts | Type | Parts | Type | Parts |
| Ex. 1-1 | A-1 | 75 | B1 | 1.7 | I1/I2 | 0.01/0 01 | E5 | 20 | J1 | 0.25 | H1 | 3 | C1 | 200 |
| Ex. 1-2 | A-2 | 75 | B1 | 1.7 | I1/I2 | 0.01/0.01 | E5 | 20 | J1 | 0.25 | H1 | 3 | C1 | 200 |
| Ex. 1-3 | A-3 | 75 | B1 | 1.7 | I1/I2 | 0.01/0 01 | E5 | 20 | J1 | 0.25 | H1 | 3 | C1 | 200 |
| Ex. 1-4 | A-4 | 75 | B1 | 1.7 | I1/I2 | 0.01/0 01 | E5 | 20 | J1 | 0.25 | H1 | 3 | C1 | 200 |
| Ex. 1-5 | A-5 | 75 | B1 | 1.7 | I1/I2 | 0.01/0 01 | E5 | 20 | J1 | 0.25 | H1 | 3 | C1 | 200 |
| Ex. 1-6 | A-6 | 75 | B1 | 1.7 | I1/I2 | 0.01/0 01 | E5 | 20 | J1 | 0.25 | H1 | 3 | C1 | 200 |
| Ex. 1-7 | A-7 | 75 | B1 | 1.7 | I1/I2 | 0.01/0.01 | E5 | 20 | J1 | 0.25 | H1 | 3 | C1 | 200 |
| Ex. 1-8 | A-8 | 75 | B1 | 1.7 | I1/I2 | 0.01/0 01 | E5 | 20 | J1 | 0.25 | H1 | 3 | C1 | 200 |
| Ex. 1-9 | A-9 | 75 | B1 | 1.7 | I1/I2 | 0.01/0 01 | E5 | 20 | J1 | 0.25 | H1 | 3 | C1 | 200 |
| Ex. 1-10 | A-10 | 75 | B1 | 1.7 | I1/I2 | 0.01/0 01 | E5 | 20 | J1 | 0.25 | H1 | 3 | C1 | 200 |
| Ex. 1-11 | A-11 | 75 | B1 | 1.7 | I1/I2 | 0.01/0 01 | E5 | 20 | J1 | 0.25 | H1 | 3 | C1 | 200 |
| Ex. 1-12 | A-12 | 75 | B1 | 1.7 | I1/I2 | 0.01/0 01 | E5 | 20 | J1 | 0.25 | H1 | 3 | C1 | 200 |
| Ex. 1-13 | A-13 | 75 | B1 | 1.7 | I1/I2 | 0.01/0 01 | E5 | 20 | J1 | 0.25 | H1 | 3 | C1 | 200 |
| Ex. 1-14 | A-14 | 75 | B1 | 1 7 | I1/I2 | 0.01/0 01 | E5 | 20 | J1 | 0.25 | H1 | 3 | C1 | 200 |
| Ex. 1-15 | A-15 | 75 | B1 | 1.7 | I1/I2 | 0.01/0 01 | E5 | 20 | J1 | 0.25 | H1 | 3 | C1 | 200 |
| Ex. 1-16 | A-16 | 75 | B1 | 1.7 | I1/I2 | 0.01/0 01 | E5 | 20 | J1 | 0.25 | H1 | 3 | C1 | 200 |
| Ex. 1-17 | A-17 | 75 | B1 | 1.7 | I1/I2 | 0. 01/0.01 | E5 | 20 | J1 | 0.25 | H1 | 3 | C1 | 200 |
| Ex. 1-18 | A-18 | 75 | B1 | 1.7 | I1/I2 | 0.01/0 01 | E5 | 20 | J1 | 0.25 | H1 | 3 | C1 | 200 |
| Ex. 1-19 | A-19 | 75 | B1 | 1.7 | I1/I2 | 0.01/0.01 | E5 | 20 | J1 | 0.25 | H1 | 3 | C1 | 200 |
| Ex. 1-20 | A-20 | 75 | B1 | 1.7 | I1/I2 | 0.01/0.01 | E5 | 20 | J1 | 0.25 | H1 | 3 | C1 | 200 |
| Ex. 1-21 | A-21 | 75 | B1 | 1.7 | I1/I2 | 0.01/0.01 | E5 | 20 | J1 | 0.25 | H1 | 3 | C1 | 200 |
| Ex. 1-22 | A-22 | 75 | 61 | 1.7 | I1/I2 | 0.01/0 01 | E5 | 20 | J1 | 0.25 | H1 | 3 | C1 | 200 |
| Ex. 1-23 | A-23 | 75 | B1 | 1.7 | I1/I2 | 0.01/0 01 | E5 | 20 | J1 | 0.25 | H1 | 3 | C1 | 200 |
| Ex. 1-24 | A-24 | 75 | B1 | 1.7 | I1/I2 | 0.01/0 01 | E5 | 20 | J1 | 0.25 | H1 | 3 | C1 | 200 |
| Ex. 1-25 | A-25 | 75 | B1 | 1.7 | I1/I2 | 0.01/0.01 | E5 | 20 | J1 | 0.25 | H1 | 3 | C1 | 200 |
| Ex. 1-26 | A-26 | 75 | B1 | 1.7 | I1/I2 | 0.01/0 01 | E5 | 20 | J1 | 0.25 | H1 | 3 | C1 | 200 |
| Ex. 1-27 | A-27 | 75 | B1 | 1.7 | I1/I2 | 0.01/0 01 | E5 | 20 | J1 | 0.25 | H1 | 3 | C1 | 200 |
| Ex. 1-28 | A-28 | 75 | B1 | 1.7 | I1/I2 | 0.01/0.01 | E5 | 20 | J1 | 0.25 | H1 | 3 | C1 | 200 |
| Comp. Ex. 1-1 | A-29 | 75 | B1 | 1.7 | I1/I2 | 0.01/0 01 | E5 | 20 | J1 | 0.25 | H1 | 3 | C1 | 200 |
| Comp. Ex. 1-2 | A-30 | 75 | B1 | 1.7 | I1/I2 | 0.01/0.01 | E5 | 20 | J1 | 0.25 | H1 | 3 | C1 | 200 |
| Comp. Ex. 1-3 | A-31 | 75 | B1 | 1.7 | I1/I2 | 0.01/0 01 | E5 | 20 | J1 | 0.25 | H1 | 3 | C1 | 200 |
| Comp. Ex. 1-4 | A-32 | 75 | B1 | 1.7 | I1/I2 | 0.01/0.01 | E5 | 20 | J1 | 0.25 | H1 | 3 | C1 | 200 |
| Comp. Ex. 1-5 | A-33 | 75 | B1 | 1.7 | I1/I2 | 0.01/0 01 | E5 | 20 | J1 | 0.25 | H1 | 3 | C1 | 200 |
| Comp. Ex. 1-6 | A-34 | 75 | B1 | 1.7 | I1/I2 | 0.01/0 01 | E5 | 20 | J1 | 0.25 | H1 | 3 | C1 | 200 |

**(Table 2-2)**

| | Sensitivity (mJ) | Taper angle (degree) | Profile | Chemical resistance | Development defect | Display unevenness |
|---|---|---|---|---|---|---|
| Ex. 1-1 | 200 | 74 | 4 | 4 | 3 | 4 |
| Ex. 1-2 | 200 | 72 | 4 | 4 | 3 | 4 |
| Ex 1-3 | 120 | 75 | 4 | 4 | 4 | 4 |
| Ex. 1-4 | 40 | 82 | 5 | 4 | 5 | 5 |
| Ex. 1-5 | 120 | 63 | 3 | 4 | 4 | 3 |
| Ex. 1-6 | 40 | 65 | 3 | 4 | 5 | 3 |
| Ex. 1-7 | 140 | 77 | 4 | 5 | 4 | 4 |
| Ex. 1-8 | 150 | 83 | 5 | 5 | 4 | 5 |
| Ex 1-9 | 200 | 77 | 4 | 5 | 3 | 4 |
| Ex. 1-10 | 220 | 83 | 5 | 5 | 3 | 5 |
| Ex. 1-11 | 60 | 77 | 4 | 4 | 5 | 4 |
| Ex. 1-12 | 70 | 83 | 5 | 4 | 5 | 5 |
| Ex. 1-13 | 10 | 60 | 3 | 4 | 5 | 3 |
| Ex. 1-14 | 30 | 75 | 4 | 4 | 5 | 4 |
| Ex. 1-15 | 60 | 80 | 5 | 4 | 5 | 5 |
| Ex. 1-16 | 15 | 63 | 3 | 4 | 5 | 3 |
| Ex. 1-17 | 25 | 70 | 4 | 4 | 5 | 4 |
| Ex. 1-18 | 35 | 72 | 4 | 4 | 5 | 4 |
| Ex. 1-19 | 50 | 80 | 5 | 4 | 5 | 5 |
| Ex. 1-20 | 70 | 84 | 5 | 4 | 5 | 5 |
| Ex 1-21 | 70 | 76 | 4 | 4 | 5 | 4 |
| Ex. 1-22 | 35 | 77 | 4 | 4 | 5 | 4 |
| Ex. 1-23 | 150 | 81 | 5 | 4 | 5 | 5 |
| Ex. 1-24 | 70 | 82 | 5 | 4 | 5 | 5 |
| Ex. 1-25 | 70 | 76 | 4 | 5 | 5 | 5 |
| Ex. 1-26 | 35 | 77 | 4 | 5 | 5 | 5 |
| Ex. 1-27 | 70 | 72 | 4 | 4 | 5 | 4 |
| Ex. 1-28 | 120 | 75 | 4 | 4 | 5 | 4 |
| Comp. Ex. 1-1 | 20 | 37 | 1 | 4 | 5 | 1 |
| Comp Ex. 1-2 | 40 | 28 | 1 | 5 | 5 | 1 |
| Comp. Ex. 1-3 | 200 | 25 | 1 | 5 | 3 | 1 |
| Comp. Ex. 1-4 | 300 | 44 | 2 | 4 | 2 | 2 |
| Comp Ex. 1-5 | Undevelopable | Undevelopable | - | - | - | - |
| Comp Ex. 1-6 | Undevelopable | Undevelopable | - | - | - | - |

**(Table 3-1)**

| | Component A | | Photo acid generator | | Sensitizer | | Basic compound | | Additives | | | | Surfactant | | Adhesion improving agent | | Solvent | |
|---|---|---|---|---|---|---|---|---|---|---|---|---|---|---|---|---|---|---|
| | Type | Parts | Type | Parts | Type | Parts | Type | Parts | Type | Parts | Type | Parts | Type | Parts | Type | Parts | Type | Parts |
| Ex. 1-29 | A-17 | 75 | B2 | 1.7 | F1 | 1.7 | I1/I2 | 001/0.01 | - | - | E5 | 20 | J1 | 0.25 | H1 | 3 | C1 | 200 |
| Ex. 1-30 | A-17 | 75 | B3 | 1.7 | F1 | 1.7 | I1/I2 | 001/001 | - | - | E5 | 20 | J1 | 0.25 | H1 | 3 | C1 | 200 |
| Ex. 1-31 | A-17 | 93 | B1 | 1.7 | - | - | I1/I2 | 0.01/0.01 | D1 | 2 | - | - | J1 | 0.25 | H1 | 3 | C1 | 200 |
| Ex. 1-32 | A-17 | 91 | B1 | 1.7 | - | - | I1/I2 | 001/0.01 | D1 | 4 | - | - | J1 | 0.25 | H1 | 3 | C1 | 200 |
| Ex. 1-33 | A-17 | 88 | B1 | 1.7 | - | - | I1/I2 | 0.01/0.01 | D1 | 7 | - | - | J1 | 0.25 | H1 | 3 | C1 | 200 |
| Ex. 1-34 | A-17 | 85 | B1 | 1.7 | - | - | I1/I2 | 0.01/0.01 | D1 | 2 | E9 | 8 | J1 | 0.25 | H1 | 3 | C1 | 200 |
| Ex. 1-35 | A-17 | 83 | B1 | 1.7 | - | - | I1/I2 | 0.01/0.01 | D1 | 4 | E8 | 8 | J1 | 0.25 | H1 | 3 | C1 | 200 |
| Ex. 1-36 | A-17 | 80 | B1 | 1.7 | - | - | I1/I2 | 0.01/0.01 | D1 | 7 | E9 | 8 | J1 | 0.25 | H1 | 3 | C1 | 200 |
| Ex. 1-37 | A-17 | 85 | B1 | 1.7 | - | - | I1/I2 | 0.01/0.01 | D2 | 2 | E9 | 8 | J1 | 0.25 | H1 | 3 | C1 | 200 |
| Ex. 1-38 | A-17 | 83 | B1 | 1.7 | - | - | I1/I2 | 0.01/0.01 | D2 | 4 | E9 | 8 | J1 | 0.25 | H1 | 3 | C1 | 200 |
| Ex. 1-39 | A-17 | 80 | B1 | 1.7 | - | - | I1/I2 | 0.01/0.01 | D2 | 7 | E9 | 8 | J1 | 0.25 | H1 | 3 | C1 | 200 |
| Ex. 1-40 | A-17 | 75 | B1 | 1.7 | - | - | I1/I2 | 0.01/0.01 | - | - | E1 | 20 | J1 | 0.25 | H1 | 3 | C1 | 200 |
| Ex. 1-41 | A-17 | 75 | B1 | 1.7 | - | - | I1/I2 | 0.01/0.01 | - | - | E2 | 20 | J1 | 0.25 | H1 | 3 | C1 | 200 |
| Ex. 1-42 | A-17 | 75 | B1 | 1.7 | - | - | I1/I2 | 0.01/0.01 | - | - | E3 | 20 | J1 | 0.25 | H1 | 3 | C1 | 200 |
| Ex. 1-43 | A-17 | 75 | B1 | 1.7 | - | - | I1/I2 | 0.01/0.01 | - | - | E4 | 20 | J1 | 0.25 | H1 | 3 | C1 | 200 |
| Ex. 1-44 | A-17 | 75 | B1 | 1.7 | - | - | I1/I2 | 0.0110.01 | - | - | E6 | 20 | J1 | 0.25 | H1 | 3 | C1 | 200 |
| Ex. 1-45 | A-17 | 75 | B1 | 1.7 | - | - | I1/I2 | 0.01/0.01 | - | - | E7 | 20 | J1 | 0.25 | H1 | 3 | C1 | 200 |
| Ex. 1-46 | A-17 | 75 | B1 | 1.7 | - | - | I1/I2 | 0.01/0.01 | - | - | E8 | 20 | J1 | 0.25 | H1 | 3 | C1 | 200 |
| Ex. 1-47 | A-17 | 75 | B1 | 1.7 | - | - | I1/I2 | 0.01/0.01 | - | - | E9 | 20 | J1 | 0.25 | H1 | 3 | C1 | 200 |
| Ex.1-48 | A-17 | 75 | B1 | 1.7 | - | - | I1/I2 | 0.01/0.01 | - | - | E10 | 20 | J1 | 0.25 | H1 | 3 | C1 | 200 |
| Ex. 1-49 | A-17 | 95 | B1 | 1.7 | - | - | I1/I2 | 0.01/0.01 | - | - | - | - | J1 | 0.25 | H1 | 3 | C1 | 200 |
| Ex. 1-50 | A-17 | 90 | B1 | 1.7 | - | - | I1/I2 | 0.01/0.01 | - | - | E5 | 5 | J1 | 0.25 | H1 | 3 | C1 | 200 |
| Ex. 1-51 | A-17 | 85 | B1 | 1.7 | - | - | I1/I2 | 0.01/0.01 | - | - | E5 | 10 | J1 | 0.25 | H1 | 3 | C1 | 200 |
| Ex. 1-52 | A- 17 | 65 | B1 | 1.7 | - | - | I1/I2 | 0.01/0.01 | - | - | E5 | 30 | J1 | 0.25 | H1 | 3 | C1 | 200 |
| Ex. 1-53 | A-17 | 67 | B1 | 1.7 | - | - | I1/I2 | 0.01/0.01 | Ac1 | 20 | E9 | 8 | J1 | 0.25 | H1 | 3 | C1 | 200 |
| Ex. 1-54 | A-17 | 67 | B1 | 1.7 | - | - | I1/I2 | 0.01/0.01 | Ac2 | 20 | E9 | 8 | J1 | 0.25 | H1 | 3 | C1 | 200 |
| Ex. 1-55 | A-17 | 67 | B1 | 1.7 | - | - | I1/I2 | 0.01/0.01 | Ac3 | 20 | E9 | 8 | J1 | 0.25 | H1 | 3 | C1 | 200 |
| Ex. 1-56 | A-17 | 67 | B1 | 1.7 | - | - | I1/I2 | 0.01/0.01 | Ac4 | 20 | E9 | 8 | J1 | 0.25 | H1 | 3 | C1 | 200 |
| Ex. 1-57 | A-20 | 75 | B1 | 1.7 | - | - | I1/I2 | 0.01/0.01 | - | - | E1 | 20 | J1 | 0.25 | H1 | 3 | C1 | 200 |
| Ex. 1-58 | A-20 | 75 | B1 | 1.7 | - | - | I1/I2 | 0.01/0.01 | - | | E2 | 20 | J1 | 0.25 | H1 | 3 | C1 | 200 |
| Ex. 1-59 | A-20 | 75 | B1 | 1.7 | - | - | I1/I2 | 0.01/0.01 | - | - | E3 | 20 | J1 | 0.25 | H1 | 3 | C1 | 200 |
| Ex. 1-60 | A-20 | 75 | B1 | 1.7 | - | - | I1/I2 | 0.01/0.01 | - | - | E4 | 20 | J1 | 0.25 | H1 | 3 | C1 | 200 |
| Ex. 1-61 | A-20 | 75 | B1 | 1.7 | - | - | I1/I2 | 0.01/0.01 | Ac3 | 20 | - | - | J1 | 0.25 | H1 | 3 | C1 | 200 |
| Ex. 1-62 | A-21 | 83 | B1 | 1.7 | - | - | I1/I2 | 0.01/0.01 | D1 | 4 | E9 | 8 | J1 | 0.25 | H1 | 3 | C1 | 200 |
| Ex. 1-63 | A-22 | 83 | B1 | 1.7 | | - | I1/I2 | 0.01/0.01 | D1 | 4 | E9 | 6 | J1 | 0.25 | H1 | 3 | C1 | 200 |
| Ex. 1-64 | A-23 | 83 | B1 | 1.7 | - | - | I1/I2 | 0.01/0.01 | D1 | 4 | E9 | 8 | J1 | 0.25 | H1 | 3 | C1 | 200 |
| Ex. 1-65 | A-24 | 83 | B1 | 1.7 | - | - | I1/I2 | 0.01/0.01 | D1 | 4 | E9 | 8 | J1 | 0.25 | H1 | 3 | C1 | 200 |

**(Table 3-2)**

| | Sensitivity (mJ) | Taper angle (degree) | Profile | Chemical resistance | Development defect | Display unevenness |
|---|---|---|---|---|---|---|
| Ex. 1-29 | 30 | 71 | 4 | 4 | 5 | 4 |
| Ex. 1-30 | 20 | 70 | 4 | 4 | 5 | 4 |
| Ex. 1-31 | 50 | 73 | 4 | 4 | 5 | 4 |
| Ex. 1-32 | 110 | 79 | 4 | 4 | 4 | 4 |
| Ex. 1-33 | 230 | 80 | 5 | 4 | 3 | 5 |
| Ex. 1-34 | 60 | 75 | 4 | 4 | 5 | 4 |
| Ex. 1-35 | 120 | 81 | 5 | 4 | 4 | 5 |
| Ex. 1-36 | 250 | 82 | 5 | 4 | 3 | 5 |
| Ex. 1-37 | 70 | 74 | 4 | 4 | 5 | 4 |
| Ex. 1-38 | 130 | 81 | 5 | 4 | 4 | 5 |
| Ex. 1-39 | 270 | 82 | 5 | 4 | 3 | 5 |
| Ex. 1-40 | 25 | 76 | 4 | 4 | 5 | 4 |
| Ex 1-41 | 40 | 74 | 4 | 4 | 5 | 4 |
| Ex. 1-42 | 25 | 73 | 4 | 4 | 5 | 4 |
| Ex. 1-43 | 25 | 71 | 4 | 4 | 5 | 4 |
| Ex. 1-44 | 25 | 68 | 3 | 4 | 5 | 3 |
| Ex. 1-45 | 25 | 67 | 3 | 4 | 5 | 3 |
| Ex. 1-46 | 25 | 65 | 3 | 4 | 5 | 3 |
| Ex. 1-47 | 45 | 65 | 3 | 4 | 5 | 3 |
| Ex 1-48 | 40 | 63 | 3 | 4 | 5 | 3 |
| Ex. 1-49 | 40 | 62 | 3 | 4 | 5 | 3 |
| Ex 1-50 | 35 | 65 | 3 | 4 | 5 | 3 |
| Ex. 1-51 | 30 | 68 | 3 | 4 | 5 | 3 |
| Ex 1-52 | 20 | 75 | 4 | 4 | 5 | 4 |
| Ex. 1-53 | 60 | 65 | 3 | 4 | 5 | 3 |
| Ex. 1-54 | 80 | 67 | 3 | 4 | 5 | 3 |
| Ex. 1-55 | 120 | 72 | 4 | 4 | 5 | 4 |
| Ex. 1-56 | 200 | 75 | 4 | 4 | 3 | 4 |
| Ex. 1-57 | 70 | 86 | 5 | 4 | 5 | 5 |
| Ex. 1-58 | 95 | 85 | 5 | 4 | 5 | 5 |
| Ex. 1-59 | 70 | 84 | 5 | 4 | 5 | 5 |
| Ex. 1-60 | 70 | 84 | 5 | 4 | 5 | 5 |
| Ex. 1-61 | 160 | 84 | 5 | 4 | 5 | 5 |
| Ex. 1-62 | 140 | 84 | 5 | 4 | 5 | 5 |
| Ex. 1-63 | 110 | 84 | 5 | 4 | 5 | 5 |
| Ex 1-64 | 250 | 86 | 5 | 4 | 5 | 5 |
| Ex. 1-65 | 200 | 86 | 5 | 4 | 5 | 5 |

**(Table 4-1)**

| | Component A | | Photo acid generator | | Sensitizer | | Basic compound | | Additives | | | | | | Surfactant | | Adhesion improving agent | | Solvent | |
|---|---|---|---|---|---|---|---|---|---|---|---|---|---|---|---|---|---|---|---|---|
| | Type | Parts | Type | Parts | Type | Parts | Type | Parts | Type | Parts | Type | Parts | Type | Parts | Type | Parts | Type | Parts | Type | Parts |
| Ex. 1-66 | A-17 | 67 | B1 | 1.7 | - | - | I1/I2 | 0.01/0.01 | D1 | 4 | E9 | 24 | | - | J1 | 0.25 | H1 | 3 | C1 | 200 |
| Ex. 1-67 | A-17 | 67 | B1 | 1.7 | - | - | I1/I2 | 0.01/0.01 | D1 | 4 | E5 | 8 | E9 | 16 | J1 | 0.25 | H1 | 3 | C1 | 200 |
| Ex. 1-68 | A-17 | 90 | B1 | 1.7 | - | - | I1/I2 | 0.01/0.01 | D3 | 5 | - | - | - | - | J1 | 0.25 | H1 | 3 | C1 | 200 |
| Ex. 1-69 | A-17 | 85 | B1 | 1.7 | - | - | I1/I2 | 0.01/0.01 | D3 | 10 | - | - | - | - | J1 | 0.25 | H1 | 3 | C1 | 200 |
| Ex. 1-70 | A-17 | 80 | B1 | 1.7 | - | - | I1/I2 | 0.01/0.01 | D3 | 15 | - | - | - | - | J1 | 0.25 | H1 | 3 | C1 | 200 |
| Ex. 1-71 | A-17 | 66 | B1 | 1.7 | - | - | I1/I2 | 0.01/0.01 | D3 | 5 | E5 | 8 | E9 | 16 | J1 | 0.25 | H1 | 3 | C1 | 200 |
| Ex. 1-72 | A-17 | 61 | B1 | 1.7 | - | - | I1/I2 | 0.01/0.01 | D3 | 10 | E5 | 8 | E9 | 16 | J1 | 0.25 | H1 | 3 | C1 | 200 |
| Ex. 1-73 | A-17 | 56 | B1 | 1.7 | - | - | I1/I2 | 0.01/0.01 | D3 | 15 | E5 | 8 | E9 | 16 | J1 | 0.25 | H1 | 3 | C1 | 200 |
| Ex. 1-14 | A-17 | 66 | B1 | 1.7 | - | - | I1/I2 | 0.01/0.01 | D4 | 5 | E5 | 8 | E9 | 18 | J1 | 0.25 | H1 | 3 | C1 | 200 |
| Ex. 1-75 | A-17 | 61 | B1 | 1.7 | - | - | I1/I2 | 0.01/0.01 | D4 | 10 | E5 | 8 | E9 | 16 | J1 | 0.25 | H1 | 3 | C1 | 200 |
| Ex. 1-76 | A-17 | 56 | B1 | 1.7 | - | - | I1/I2 | 0.0110.01 | D4 | 15 | E5 | 8 | E9 | 16 | J1 | 0.25 | H1 | 3 | C1 | 200 |
| Ex. 1-77 | A-17 | 66 | B1 | 1.7 | | - | I3 | 0.02 | D3 | 5 | E9 | 16 | E11 | 8 | J1 | 0.25 | H1 | 3 | C1 | 200 |
| Ex. 1-78 | A-17 | 61 | B1 | 1.7 | - | - | I3 | 0.02 | D3 | 10 | E9 | 16 | E11 | 8 | J1 | 0.25 | H1 | 3 | C1 | 200 |
| Ex. 1-79 | A-17 | 56 | B1 | 1.7 | - | | I3 | 0.02 | D3 | 95 | E9 | 16 | E11 | 8 | J1 | 0.25 | H1 | 3 | C1 | 200 |
| Ex. 1-80 | A-17 | 66 | B1 | 1.7 | - | - | I3 | 0.02 | D3 | 5 | E9 | 16 | E12 | 8 | J1 | 0.25 | H1 | 3 | C1 | 200 |
| Ex. 1-81 | A-17 | 61 | B1 | 1.7 | - | - | I3 | 0.02 | D3 | 10 | E9 | 16 | E12 | 8 | J1 | 0.25 | H1 | 3 | C1 | 200 |
| Ex. 1-82 | A-17 | 56 | B1 | 1.7 | - | - | I3 | 0.02 | D3 | 15 | E9 | 16 | E12 | 8 | J1 | 0.25 | H1 | 3 | C1 | 200 |
| Ex. 1-83 | A-17 | 66 | B1 | 1.7 | - | - | I3 | 0.02 | D3 | 5 | E9 | 16 | E13 | 8 | J1 | 0.25 | H1 | 3 | C1 | 200 |
| Ex. 1-84 | A-1 7 | 61 | B1 | 1.7 | | - | I3 | 0.02 | D3 | 10 | E9 | 16 | E13 | 8 | J1 | 0.25 | H1 | 3 | C1 | 200 |
| Ex. 1-85 | A-17 | 56 | B1 | 1.7 | | - | I3 | 0.02 | D3 | 15 | E9 | 16 | E13 | 8 | J1 | 0.25 | H1 | 3 | C1 | 200 |

**(Table 4-2)**

| | Sensitivity (mJ) | Taper angle (degree) | Profile | Chemical resistance | Development defect | Display unevenness |
|---|---|---|---|---|---|---|
| Ex. 1-66 | 200 | 82 | 5 | 4 | 4 | 5 |
| Ex. 1-67 | 60 | 82 | 5 | 4 | 4 | 5 |
| Ex. 1-68 | 20 | 73 | 4 | 4 | 5 | 4 |
| Ex. 1-69 | 30 | 78 | 4 | 4 | 4 | 4 |
| Ex. 1-70 | 50 | 79 | 4 | 4 | 3 | 5 |
| Ex. 1-71 | 25 | 75 | 4 | 4 | 5 | 4 |
| Ex. 1-72 | 40 | 81 | 5 | 4 | 4 | 5 |
| Ex. 1-73 | 60 | 82 | 5 | 4 | 3 | 5 |
| Ex. 1-74 | 25 | 72 | 4 | 4 | 5 | 4 |
| Ex. 1-75 | 40 | 79 | 4 | 4 | 4 | 4 |
| Ex. 1-76 | 60 | 80 | 5 | 4 | 3 | 5 |
| Ex. 1-77 | 25 | 73 | 4 | 4 | 5 | 4 |
| Ex. 1-78 | 40 | 79 | 4 | 4 | 4 | 4 |
| Ex. 1-79 | 60 | 80 | 5 | 4 | 3 | 5 |
| Ex. 1-80 | 30 | 73 | 4 | 4 | 5 | 4 |
| Ex. 1-81 | 45 | 79 | 4 | 4 | 4 | 4 |
| Ex. 1-82 | 70 | 80 | 5 | 4 | 3 | 5 |
| Ex 1-83 | 20 | 71 | 4 | 4 | 5 | 4 |
| Ex. 1-84 | 30 | 77 | 4 | 4 | 4 | 4 |
| Ex. 1-85 | 50 | 79 | 4 | 4 | 3 | 4 |

In addition, the abbreviations in Table 2-1 to Table 4-1 are as follows.
B1: CGI1397 (compound shown below)
B2: α-(*p*-Toluenesulfonyloxyimino)phenylacetonitrile (The synthesis method is as shown below.)
B3: Oxime sulfonate compound synthesized by the following synthesis method
F1: 9,10-Dibutoxyanthracene (DBA)
I1: 1,5-Diazabicyclo[4.3.0]-5-nonene
I2: Triphenylimidazole
I3: Cyclohexylmorpholinoethyl thiourea (CHMETU)
C1: Propylene glycol monomethyl ether acetate
H1: 3-Glycidoxypropyltrimethoxysilane (KBM-403 (manufactured by Shin-Etsu Chemical Co., Ltd.))
J1: Compound W-3 shown below
D1: NIKALAC MW-100LM (manufactured by Sanwa Chemical Co., Ltd.)
D2: NIKALAC MX-270 (manufactured by Sanwa Chemical Co., Ltd.)
D3: DURANATE MF-K60X (blocked isocyanate-based crosslinking agent, active methylene-protected polyfunctional type, manufactured by Asahi Kasei Chemicals Corp.)
D4: DURANATE MF-B60X (blocked isocyanate-based crosslinking agent, oxime-protected polyfunctional type, manufactured by Asahi Kasei Chemicals Corp.)
E1: EPICLON 7050 (manufactured by DIC Corp., epoxy equivalent: 1,700 to 2,100 g/eq)
E2: Epoxy resin 1004 (manufactured by Mitsubishi Chemical Corp., epoxy equivalent: 875 to 975 g/eq)
E3: YD-012 (manufactured by Nippon Steel Chemical Co., Ltd., epoxy equivalent: 600 to 700 g/eq)
E4: YD-011 (manufactured by Nippon Steel Chemical Co., Ltd., epoxy equivalent: 450 to 500 g/eq)
E5: EPICLON EXA-4816 (manufactured by DIC Corp., epoxy equivalent: 403 g/eq)
E6: EPICLON EXA-4822 (manufactured by DIC Corp., epoxy equivalent: 385 g/eq)
E7: EPICLON EXA-5300-70 (manufactured by DIC Corp., epoxy equivalent: 300 to 340 g/eq)
E8: EPICLON 860 (manufactured by DIC Corp., epoxy equivalent: 235 to 255 g/eq)
E9: JER157S65 (manufactured by Mitsubishi Chemical Corp., epoxy equivalent: 200 to 220 g/eq)
E10: Epoxy resin 827 (manufactured by Mitsubishi Chemical Corp., epoxy equivalent: 180 to 190 g/eq)
E11: EPICLON HP-4700 (manufactured by DIC Corp., epoxy equivalent: 165 g/eq)
E12: EPICLON HP-4710 (manufactured by DIC Corp., epoxy equivalent: 165 g/eq)
E13: JER YX4000HK (manufactured by Mitsubishi Chemical Corp., epoxy equivalent: 195 g/eq)
Ac1: Copolymer of benzyl acrylate (BnA)/methacrylic acid (MAA) = 60/40 (molar ratio) (Mw: 8,000, carboxy equivalent: 350 g/eq)
Ac2: Copolymer of BnA/MAA = 70/30 (molar ratio) (Mw: 8,000, carboxy equivalent: 497 g/eq)
Ac3: Copolymer of BnA/MAA = 80/20 (molar ratio) (Mw: 8,000, carboxy equivalent: 790 g/eq)
Ac4: Polymethyl methacrylate (PMMA, homopolymer)

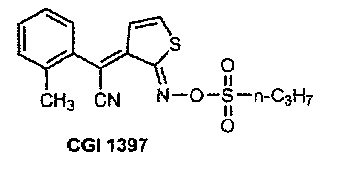

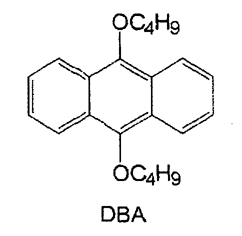

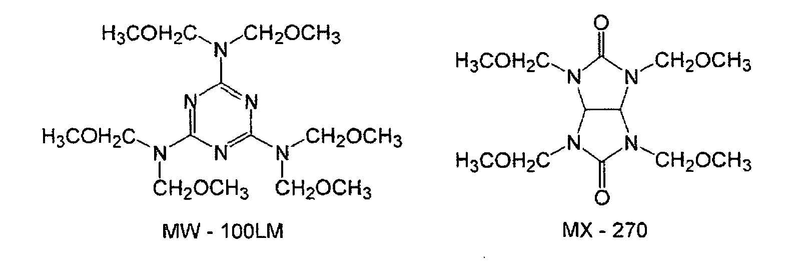

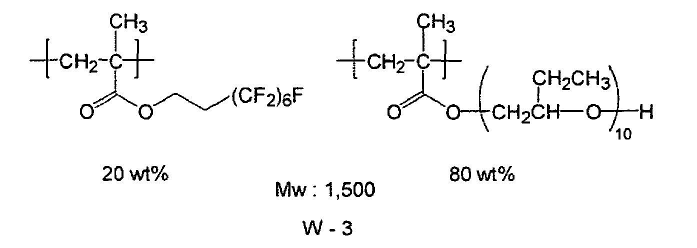

### <Synthesis of B2>

α-(*p*-Toluenesulfonyloxyimino)phenylacetonitrile was synthesized according to the method described in paragraph 0108 of JP-T-2002-528451.

### <Synthesis of B3>

Aluminum chloride (10.6 g) and 2-chloropropionyl chloride (10.1 g) were added to a suspension solution of 2-naphthol (10 g) and chlorobenzene (30 mL), and the mixture liquid was heated to 40°C to allow the mixture to react for 2 hours. Under ice cooling, a 4 N aqueous HCl solution (60 mL) was added dropwise to the reaction liquid, ethyl acetate (50 mL) was added thereto, and the mixture was partitioned. Potassium carbonate (19.2 g) was added to the organic layer, and the mixture was allowed to react at 40°C for 1 hour. Subsequently, a 2 N aqueous HCl solution (60 mL) was added thereto, and the mixture was partitioned. The organic layer was concentrated, and then crystals were reslurried in diisopropyl ether (10 mL). The slurry was filtered and dried, and thus a ketone compound (6.5 g) was obtained.

Acetic acid (7.3 g) and a 50% aqueous solution of hydroxylamine (8.0 g) were added to a suspension solution of the ketone compound thus obtained (3.0 g) and methanol (30 mL), and the mixture was heated to reflux. After the system was left to cool, water (50 mL) was added, and precipitated crystals were filtered and washed with cold methanol. The crystals were dried, and thus an oxime compound (2.4 g) was obtained.

The oxime compound (1.8 g) thus obtained was dissolved in acetone (20 mL), and under ice cooling, triethylamine (1.5 g) and p-toluenesulfonyl chloride (2.4 g) were added thereto. The mixture was heated to room temperature, and was allowed to react for 1 hour. Water (50 mL) was added to the reaction liquid, and precipitated crystals were filtered. Subsequently, the crystals were reslurried in methanol (20 mL), and the slurry was filtered and dried. Thus, B3 (2.3 g) was obtained.

The ¹H-NMR spectrum (300 MHz, CDCl₃) of B3 was as follows: δ = 8.3(d, 1H), 8.0(d, 2H), 7.9(d, 1H), 7.8(d, 1 H), 7.6(dd, 1 H), 7.4(dd, 1H) 7.3(d, 2H), 7.1 (d, 1H), 5.6(q, 1 H), 2.4(s, 3H), 1.7(d, 3H).

Furthermore, (2) the evaluation of the taper angle and the evaluation of pattern profile, and (5) the production of a MEMS shutter display and the operation evaluation were carried out in the same manner as in Example 1-17, except that the photosensitive resin composition of Example 1-17 was used, and the conditions of the two-stage bake treatment for the (2) evaluation of the taper angle and the evaluation of the pattern profile were changed to the conditions described in Table 5. The evaluation results are shown together in Table 5.

**(Table 5)**

| Composition of Example 1-17 | | Taper angle (degree) | Profile | Display unevenness |
|---|---|---|---|---|
| 1^{st} stage bake | 2^{nd} stage bake | | | |
| None | 230°C-60min | 35 | 1 | 1 |
| 80°C-30min | 230°C-60min | 58 | 2 | 2 |
| 90°C-30min | 230°C-60min | 62 | 3 | 3 |
| 100°C-30min | 230°C-60min | 64 | 3 | 3 |
| 110°C-30min | 230°C-60min | 65 | 3 | 3 |
| 120°C-30min | 230°C-60min | 66 | 3 | 3 |
| 130°C-30min | 230°C-60min | 68 | 3 | 3 |
| 140°C-30min | 230°C-60min | 70 | 4 | 4 |
| 150°C-30min | 230°C-60min | 65 | 3 | 3 |
| 160°C-30min | 230°C-60min | 58 | 2 | 2 |
| 170°C-30min | 230°C-60min | 53 | 2 | 2 |
| 180°C-30mín | 230°C-60min | 49 | 2 | 2 |

### (Example 1-86)

The same operation as in Examples 1-1 to 1-85 was carried out, except that the thickness of the coating film was changed from 4 µm to 10 µm, 50 µm, and 100 µm, respectively, and (2) the evaluation of the taper angle and the evaluation of the pattern profile, (3) the evaluation of chemical resistance, and (4) the evaluation of development defect were carried out. The same evaluation results as the evaluation results obtained with a thickness of 4 µm were obtained.

### (Examples 2-1 to 2-65, and Comparative Examples 2-1 to 2-6)

### (1) Preparation of photosensitive resin composition

The various Components shown in the following Table 6-1 and Table 7-1 were mixed to obtain uniform solutions, and then each of the solutions was filtered using a polytetrafluoroethylene filter having a pore size of 0.1 µm. Thus, the photosensitive resin compositions of Examples 2-1 to 2-65 and Comparative Examples 2-1 to 2-6 were prepared. The following evaluations were respectively carried out using the photosensitive resin compositions of Examples 2-1 to 2-65 and Comparative Examples 2-1 to 2-6 thus obtained. The evaluation results are shown in Table 6-2 and Table 7-2.

### <Evaluation of photosensitive resin composition>

### (1) Evaluation of sensitivity (no PEB)

A photosensitive resin composition was spin coated on a silicon wafer having a silicon oxide film, and then the silicon wafer was pre-baked on a hot plate at 90°C for 120 seconds. Thus, a coating film having a thickness of 4 µm was formed.

Subsequently, the film was exposed through a predetermined mask using an i-line stepper (FPA-3000 i5⁺ manufactured by Canon, Inc.). After the exposure, the substrate was left to stand for 10 minutes at room temperature, and then was developed by a paddling method using a 0.4% aqueous solution of tetramethylammonium hydroxide at 23°C for 60 seconds. The substrate was rinsed with ultrapure water for 45 seconds. The optimum exposure amount (Eopt) which was capable of resolution of a line-and-space pattern with a line width of 10 µm at 1:1 by these operations, was defined as sensitivity. The sensitivity is such that a smaller value indicates higher sensitivity. Particularly, an exposure amount which gives a sensitivity lower than 70 mJ/cm² is preferable. Meanwhile, PEB was not carried out.

### (2) Evaluation of taper angle and evaluation of pattern profile

A photosensitive resin composition was spin coated on a silicon wafer having a silicon oxide film, and then the silicon wafer was pre-baked on a hot plate at 90°C for 120 seconds. Thus, a coating film having a thickness of 4 µm was formed.

Subsequently, the film was exposed in an amount of 70 mJ through a predetermined mask using an i-line stepper (FPA-3000 i5⁺ manufactured by Canon, Inc.). After the exposure, the substrate was left to stand for 10 minutes at room temperature, and then was developed by a paddling method using a 0.4% aqueous solution of tetramethylammonium hydroxide at 23°C for 60 seconds. The substrate was rinsed with ultrapure water for 45 seconds. Subsequently, the substrate was baked by performing a two-stage bake treatment (first stage: 140°C - 30 min, second stage: 230°C - 60 min).

Thereafter, the cross-section of a line-and-space pattern with a line width of 10 µm was observed with a scanning electron microscope (SEM), and the taper angle was measured.

Furthermore, the profile shape was evaluated based on the taper angle and the overall rectangle formability. As the profile is closer to rectangle in shape, if it is a resist for MEMS, a structure having an originally desired shape (rectangular shape) can be laminated on the resist, and if it is a resist for dry etching, the material to be etched can be accurately processed by a dry etching process. Grades 3 to 5 were considered as levels without any problem in practical used. The image of the shape is shown in FIG. 1.

In this evaluation, since it is intended to form a rectangular line-and-space pattern, a high taper angle is considered excellent as shown below. However, if the desired pattern is different, it is not necessary that the pattern be rectangular.
5: A profile that is rectangular or close to a rectangle, with a taper angle of the line cross-section being equal to or larger than 80° and equal to or less than 90°
4: A profile that is close to a rectangle, with a taper angle of the line cross-section being equal to or larger than 70° and less than 80°
3: A profile that is trapezoidal, with a taper angle of the line cross-section being equal to or larger than 60° and less than 70°
2: A profile with a taper angle of the line cross-section being equal to or larger than 40° and less than 60°
1: A profile with a taper angel of the line cross-section being less than 40° (3) Evaluation of pencil hardness

A solid cured film having a thickness of 4 µm was produced in the same manner as in the evaluation for the pattern profile, provided that mask exposure was not carried out.

The pencil hardness of the sample thus obtained was measured using a continuous loading scratching intensity tester, "TRIBOGEAR TYPE 18L," manufactured by Shinto Scientific Co., Ltd. The pencil was "Mitsubishi Pencil Uni for scratching value test", and the load was 500 g. For other conditions, the measurement was carried out according to the method described in JIS K5600.

As for the MEMS structural member, strength to a certain degree or higher is required, and if the sample is rated as 3 or higher for the present evaluation, the sample can be suitably used as a member of a structure.
5: Pencil hardness of 7H or higher
4: Pencil hardness of 6H
3: Pencil hardness of 5H
2: Pencil hardness of 4H
1: Pencil hardness of 3H or lower

### (4) Evaluation of pressure cooker test (PCT) resistance of photosensitive resin composition

An aluminum thin film having a thickness of 1,000Å was formed on a silicon wafer by sputtering, and patterning was carried out as described above, using the substrate and using the various photosensitive resin compositions. Subsequently, each test specimen was placed in a highly accelerated stress test (HAST) chamber (manufactured by Espec Corp.), and was maintained in a constant temperature constant humidity state for 20 hours at 121°C and 100% RH under 2 atmospheric pressure (PCT). Subsequently, the specimen was taken out, and the adhesive force of the pattern having a shape schematically shown in FIG. 1 was measured to evaluate the PCT resistance. A force was applied from the lateral side of the pattern using a shear tool, and the shear strength at the time point where the pattern peeled off was designated as the adhesive force.

### Evaluation criteria

5: Adhesive force of 100 gf or greater
4: Adhesive force of equal to or greater than 50 gf and less than 100 gf
3: Adhesive force of equal to or greater than 20 gf and less than 50 gf
2: Adhesive force of equal to or greater than 5 gf and less than 20 gf
1: Adhesive force of less than 5 gf (below the measurement limit)

**(Table 6-1)**

| | Component A | | Photo acid generator | | Basic compound | | Additive | | Surfactant | | Adhesion improving agent | | Solvent | |
|---|---|---|---|---|---|---|---|---|---|---|---|---|---|---|
| | Type | Parts | Type | Parts | Type | Parts | Type | Parts | Type | Parts | Type | Parts | Type | Parts |
| Ex. 2-1 | A-1 | 75 | B1 | 1.7 | I1/I2 | 0.01/0.01 | E5 | 20 | J1 | 0.25 | H1 | 3 | C1 | 200 |
| Ex. 2-2 | A-2 | 75 | B1 | 1.7 | I1/I2 | 0.01/0.01 | E5 | 20 | J1 | 0.25 | H1 | 3 | C1 | 200 |
| Ex 2-3 | A-3 | 75 | B1 | 1 7 | I1/I2 | 0.01/0.01 | E5 | 20 | J1 | 0.25 | H1 | 3 | C1 | 200 |
| Ex. 2-4 | A-4 | 75 | B1 | 1.7 | I1/I2 | 0.0110.01 | E5 | 20 | J1 | 0.25 | H1 | 3 | C1 | 200 |
| Ex 2-5 | A-5 | 75 | B1 | 1.7 | I1/I2 | 0.01/0.01 | E5 | 20 | J1 | 0.25 | H1 | 3 | C1 | 200 |
| Ex. 2-6 | A-6 | 75 | B1 | 1.7 | I1/I2 | 0.01/0.01 | E5 | 20 | J1 | 0.25 | H1 | 3 | C1 | 200 |
| Ex. 2-7 | A-7 | 75 | B1 | 1.7 | I1/I2 | 0.01/0.01 | E5 | 20 | J1 | 0.25 | H1 | 3 | C1 | 200 |
| Ex. 2-8 | A-8 | 75 | B1 | 1.7 | I1/I2 | 0.01/0.01 | E5 | 20 | J1 | 0.25 | H1 | 3 | C1 | 200 |
| Ex. 2-9 | A-9 | 75 | B1 | 1.7 | I1/I2 | 0.01/0.01 | E5 | 20 | J1 | 0.25 | H1 | 3 | C1 | 200 |
| Ex. 2-10 | A-10 | 75 | B1 | 1.7 | I1/I2 | 0.01/0.01 | E5 | 20 | J1 | 0.25 | H1 | 3 | C1 | 200 |
| Ex. 2-11 | A-11 | 75 | B1 | 1 7 | I1/I2 | 0.01/0.01 | E5 | 20 | J1 | 0.25 | H1 | 3 | C1 | 200 |
| Ex 2-12 | A-12 | 75 | B1 | 1.7 | I1/I2 | 0.01/0.01 | E5 | 20 | J1 | 0.25 | H1 | 3 | C1 | 200 |
| Ex. 2-13 | A-13 | 75 | B1 | 1.7 | I1/I2 | 0.01/0 01 | E5 | 20 | J1 | 0.25 | H1 | 3 | C1 | 200 |
| Ex. 2-14 | A-14 | 75 | B1 | 1.7 | I1/I2 | 0.01/0 01 | E5 | 20 | J1 | 0.25 | H1 | 3 | C1 | 200 |
| Ex 2-15 | A-15 | 75 | B1 | 1.7 | I1/I2 | 0.01/0.01 | E5 | 20 | J1 | 025 | H1 | 3 | C1 | 200 |
| Ex 2-16 | A-16 | 75 | B1 | 1.7 | I1/I2 | 0.01/0.01 | E5 | 20 | J1 | 0.25 | H1 | 3 | C1 | 200 |
| Ex. 2-17 | A-17 | 75 | B1 | 1 7 | I1/I2 | 0.01/0.01 | E5 | 20 | J1 | 0.25 | H1 | 3 | C1 | 200 |
| Ex. 2-18 | A-18 | 75 | B1 | 1.7 | I1/I2 | 0.01/0.01 | E5 | 20 | J1 | 0.25 | H1 | 3 | C1 | 200 |
| Ex 2-19 | A-19 | 75 | B1 | 1.7 | I1/I2 | 0.01/0 01 | E5 | 20 | J1 | 0.25 | H1 | 3 | C1 | 200 |
| Ex 2-20 | A-20 | 75 | B1 | 1.7 | I1/I2 | 0.01/0.01 | E5 | 20 | J1 | 0.25 | H1 | 3 | C1 | 200 |
| Ex 2-21 | A-21 | 75 | B1 | 1 7 | I1/I2 | 0.01/0.01 | E5 | 20 | J1 | 0.25 | H1 | 3 | C1 | 200 |
| Ex. 2-22 | A-22 | 75 | B1 | 1.7 | I1/I2 | 0.01/0.01 | E5 | 20 | J1 | 0.25 | H1 | 3 | C1 | 200 |
| Ex 2-23 | A-23 | 75 | B1 | 1.7 | I1/I2 | 0.01/0.01 | E5 | 20 | J1 | 0.25 | H1 | 3 | C1 | 200 |
| Ex 2-24 | A-24 | 75 | B1 | 1.7 | I1/I2 | 0.01/001 | E5 | 20 | J1 | 0 25 | H1 | 3 | C1 | 200 |
| Ex 2-25 | A-25 | 75 | B1 | 1.7 | I1/I2 | 0.01/0.01 | E5 | 20 | J1 | 025 | H1 | 3 | C1 | 200 |
| Ex 2-26 | A-26 | 75 | B1 | 1.7 | I1/I2 | 0.01/0.01 | E5 | 20 | J1 | 0.25 | H1 | 3 | C1 | 200 |
| Ex. 2-27 | A-27 | 75 | B1 | 1.7 | I1/I2 | 0.01/0.01 | E5 | 20 | J1 | 0.25 | H1 | 3 | C1 | 200 |
| Ex 2-28 | A-28 | 75 | B1 | 1.7 | I1/I2 | 0.01/0.01 | E5 | 20 | J1 | 0.25 | H1 | 3 | C1 | 200 |
| Comp. Ex. 2-1 | A-29 | 75 | B1 | 1.7 | I1/I2 | 0.01/0.01 | E5 | 20 | J1 | 0.25 | H1 | 3 | C1 | 200 |
| Comp Ex. 2-2 | A-30 | 75 | B1 | 1.7 | I1/I2 | 0.01/0.01 | E5 | 20 | J1 | 0.25 | H1 | 3 | C1 | 200 |
| Comp Ex. 2-3 | A-31 | 75 | B1 | 1 7 | I1/I2 | 0.01/0.01 | E5 | 20 | J1 | 0.25 | H1 | 3 | C1 | 200 |
| Comp. Ex. 2-4 | A-32 | 75 | B1 | 1.7 | I1/I2 | 0.01/0.01 | E5 | 20 | J1 | 0.25 | H1 | 3 | C1 | 200 |
| Comp. Ex. 2-5 | A-33 | 75 | B1 | 1.7 | I1/I2 | 0.01/0.01 | E5 | 20 | J1 | 0.25 | H1 | 3 | C1 | 200 |
| Comp. Ex. 2-6 | A-34 | 75 | B1 | 1.7 | I1/I2 | 0.01/0.01 | E5 | 20 | J1 | 0.25 | H1 | 3 | C1 | 200 |

**(Table 6-2)**

| | Sensitivity (mJ) | Taper angle (degree) | Profile | Pencil hardness | PCT evaluation |
|---|---|---|---|---|---|
| Ex. 2-1 | 200 | 74 | 4 | 3 | 4 |
| Ex. 2-2 | 200 | 72 | 4 | 3 | 4 |
| Ex. 2-3 | 120 | 75 | 4 | 4 | 5 |
| Ex. 2-4 | 40 | 82 | 5 | 4 | 5 |
| Ex. 2-5 | 120 | 63 | 3 | 4 | 5 |
| Ex. 2-6 | 40 | 65 | 3 | 4 | 5 |
| Ex. 2-7 | 140 | 77 | 4 | 5 | 5 |
| Ex. 2-8 | 150 | 83 | 5 | 5 | 5 |
| Ex. 2-9 | 200 | 77 | 4 | 5 | 4 |
| Ex. 2-10 | 220 | 83 | 5 | 5 | 4 |
| Ex. 2-11 | 60 | 77 | 4 | 4 | 5 |
| Ex. 2-12 | 70 | 83 | 5 | 4 | 5 |
| Ex. 2-13 | 10 | 60 | 3 | 4 | 5 |
| Ex. 2-14 | 30 | 75 | 4 | 4 | 5 |
| Ex. 2-15 | 60 | 80 | 5 | 4 | 5 |
| Ex. 2-16 | 15 | 63 | 3 | 4 | 5 |
| Ex. 2-17 | 25 | 70 | 4 | 4 | 5 |
| Ex. 2-18 | 35 | 72 | 4 | 4 | 5 |
| Ex. 2-19 | 50 | 80 | 5 | 4 | 5 |
| Ex. 2-20 | 70 | 84 | 5 | 4 | 5 |
| Ex. 2-21 | 70 | 76 | 4 | 5 | 5 |
| Ex. 2-22 | 35 | 77 | 4 | 4 | 5 |
| Ex. 2-23 | 150 | 81 | 5 | 5 | 5 |
| Ex. 2-24 | 70 | 82 | 5 | 4 | 5 |
| Ex. 2-25 | 70 | 76 | 5 | 4 | 5 |
| Ex. 2-26 | 35 | 77 | 5 | 4 | 5 |
| Ex. 2-27 | 70 | 72 | 4 | 5 | 5 |
| Ex. 2-28 | 120 | 75 | 4 | 5 | 5 |
| Comp. Ex. 2-1 | 20 | 37 | 1 | 2 | 2 |
| Comp. Ex. 2-2 | 40 | 28 | 1 | 2 | 2 |
| Comp. Ex. 2-3 | 200 | 25 | 1 | 1 | 2 |
| Comp. Ex. 2-4 | 300 | 44 | 2 | 4 | 5 |
| Comp. Ex. 2-5 | Undevelopable | Undevelopable | - | 5 | 5 |
| Comp. Ex. 2-6 | Undevelopable | Undevelopable | - | 5 | 5 |

**(Table 7-1)**

| | Component A | | Photo acid generator | | Sensitizer | | Basic compound | | Additives | | | | Surfactant | | Adhesion improving agent | | Solvent | |
|---|---|---|---|---|---|---|---|---|---|---|---|---|---|---|---|---|---|---|
| | Type | Parts | Type | Parts | Type | Parts | Type | Parts | Type | Parts | Type | Parts | Type | Parts | Type | Parts | Type | Parts |
| Ex. 2-29 | A-17 | 75 | B2 | 1.7 | F1 | 1.7 | I1/I2 | 0.01/0.01 | - | - | E5 | 20 | J1 | 0.25 | H1 | 3 | C1 | 200 |
| Ex. 2-30 | A-17 | 75 | B3 | 1.7 | F1 | 1.7 | I1/I2 | 0.01/0.01 | - | - | E5 | 20 | J1 | 0.25 | H1 | 3 | C1 | 200 |
| Ex. 2-31 | A-17 | 93 | B1 | 1.7 | - | - | I1/I2 | 0.01/0.01 | D1 | 2 | - | - | J1 | 0.25 | H1 | 3 | C1 | 200 |
| Ex. 2-32 | A-17 | 91 | B1 | 1.7 | - | - | I1/I2 | 0.01/0.01 | D1 | 4 | - | - | J1 | 0.25 | H1 | 3 | C1 | 200 |
| Ex 2-33 | A-17 | 88 | B1 | 1.7 | - | - | I1/I2 | 0.01/0.01 | D1 | 7 | - | - | J1 | 0.25 | H1 | 3 | C1 | 200 |
| Ex. 2-34 | A-17 | 85 | B1 | 1.7 | - | - | I1/I2 | 0.01/0.01 | D1 | 2 | E9 | 8 | J1 | 0.25 | H1 | 3 | C1 | 200 |
| Ex. 2-35 | A-17 | 83 | B1 | 1.7 | - | - | I1/I2 | 0.01/0.01 | D1 | 4 | E9 | 8 | J1 | 0.25 | H1 | 3 | C1 | 200 |
| Ex. 2-36 | A-17 | 80 | B1 | 1.7 | - | - | I1/I2 | 0.01/0.01 | D1 | 7 | E9 | 8 | J1 | 0.25 | H1 | 3 | C1 | 200 |
| Ex. 2-37 | A-17 | 85 | B1 | 1.7 | - | - | I1/I2 | 0.01/0.01 | D2 | 2 | E9 | 8 | J1 | 0.25 | H1 | 3 | C1 | 200 |
| Ex. 2-38 | A-17 | 83 | B1 | 1.7 | - | - | I1/I2 | 0.01/0.01 | D2 | 4 | E9 | 8 | J1 | 0.25 | H1 | 3 | C1 | 200 |
| Ex. 2-39 | A-17 | 80 | B1 | 1.7 | - | - | I1/I2 | 0.01/0.01 | D2 | 7 | E9 | 8 | J1 | 0.25 | H1 | 3 | C1 | 200 |
| Ex. 2-40 | A-17 | 75 | B1 | 1.7 | - | - | I1/I2 | 0.01/0.01 | - | - | E1 | 20 | J1 | 0.25 | H1 | 3 | C1 | 200 |
| Ex. 2-41 | A-17 | 75 | B1 | 1.7 | - | - | I1/I2 | 0.01/0.01 | - | - | E2 | 20 | J1 | 0.25 | H1 | 3 | C1 | 200 |
| Ex. 2-42 | A-17 | 75 | B1 | 1.7 | - | - | I1/I2 | 0.01/0.01 | - | - | E3 | 20 | J1 | 0.25 | H1 | 3 | C1 | 200 |
| Ex. 2-43 | A-17 | 75 | B1 | 1.7 | - | - | I1/I2 | 0.01/0.01 | - | - | E4 | 20 | J1 | 0.25 | H1 | 3 | C1 | 200 |
| Ex. 2-44 | A-17 | 75 | B1 | 1.7 | - | - | I1/I2 | 0.01/0.01 | - | - | E6 | 20 | J1 | 0.25 | H1 | 3 | C1 | 200 |
| Ex. 2-45 | A-17 | 75 | B1 | 1.7 | - | - | I1/I2 | 0.01/0.01 | - | - | E7 | 20 | J1 | 0.25 | H1 | 3 | C1 | 200 |
| Ex. 2-46 | A-17 | 75 | B1 | 1.7 | - | - | I1/I2 | 0.01/0.01 | - | - | E8 | 20 | J1 | 0.25 | H1 | 3 | C1 | 200 |
| Ex. 2-47 | A-17 | 75 | B1 | 1.7 | - | - | I1/I2 | 0.01/0.01 | - | - | E9 | 20 | J1 | 0.25 | H1 | 3 | C1 | 200 |
| Ex. 2-48 | A-17 | 75 | B1 | 1.7 | - | - | I1/I2 | 0.01/0.01 | - | - | E10 | 20 | J1 | 0.25 | H1 | 3 | C1 | 200 |
| Ex. 2-49 | A-17 | 95 | B1 | 1.7 | - | - | I1/I2 | 0.01/0.01 | - | - | - | - | J1 | 0.25 | H1 | 3 | C1 | 200 |
| Ex. 2-50 | A-17 | 90 | B1 | 1.7 | - | - | I1/I2 | 0.01/0.01 | - | - | E5 | 5 | J1 | 0.25 | H1 | 3 | C1 | 200 |
| Ex. 2-51 | A-17 | 85 | B1 | 1.7 | - | - | I1/I2 | 0.01/0.01 | - | - | E5 | 10 | J1 | 0.25 | H1 | 3 | C1 | 200 |
| Ex. 2-52 | A-17 | 65 | B1 | 1.7 | - | - | I1/I2 | 0.01/0.01 | - | - | E5 | 30 | J1 | 0.25 | H1 | 3 | C1 | 200 |
| Ex. 2-53 | A-17 | 67 | B1 | 1.7 | - | - | I1/I2 | 0.01/0.01 | Ac1 | 20 | E9 | 8 | J1 | 0.25 | H1 | 3 | C1 | 200 |
| Ex. 2-54 | A-17 | 67 | B1 | 1.7 | - | - | I1/I2 | 0.01/0.01 | Ac2 | 20 | E9 | 8 | J1 | 0.25 | H1 | 3 | C1 | 200 |
| Ex. 2-55 | A-17 | 67 | B1 | 1.7 | - | - | I1/I2 | 0.01/0.01 | Ac3 | 20 | E9 | 8 | J1 | 0.25 | H1 | 3 | C1 | 200 |
| Ex. 2-56 | A-17 | 67 | B1 | 1.7 | - | - | I1/I2 | 0.01/0.01 | Ac4 | 20 | E9 | 8 | J1 | 0.25 | H1 | 3 | C1 | 200 |
| Ex. 2-57 | A-20 | 75 | B1 | 1.7 | - | - | I1/I2 | 0.01/0.01 | - | - | E1 | 20 | J1 | 0.25 | H1 | 3 | C1 | 200 |
| Ex. 2-58 | A-20 | 75 | B1 | 1.7 | - | - | I1/I2 | 0.01/0.01 | - | - | E2 | 20 | J1 | 0.25 | H1 | 3 | C1 | 200 |
| Ex. 2-59 | A-20 | 75 | B1 | 1.7 | - | - | I1/I2 | 0.01/0.01 | - | - | E3 | 20 | J1 | 0.25 | H1 | 3 | C1 | 200 |
| Ex. 2-60 | A-20 | 75 | B1 | 1.7 | - | - | I1/I2 | 0.01/0.01 | - | - | E4 | 20 | J1 | 0.25 | H1 | 3 | C1 | 200 |
| Ex. 2-61 | A-20 | 75 | B1 | 1.7 | - | - | I1/I2 | 0.01/0.01 | Ac3 | 20 | - | - | J1 | 0.25 | H1 | 3 | C1 | 200 |
| Ex. 2-62 | A-21 | 83 | B1 | 1.7 | - | | I1/I2 | 0.01/0.01 | D1 | 4 | E9 | 8 | J1 | 0.25 | H1 | 3 | C1 | 200 |
| Ex. 2-63 | A-22 | 83 | B1 | 1.7 | - | - | I1/I2 | 0.01/0.01 | D1 | 4 | E9 | 8 | J1 | 0.25 | H1 | 3 | C1 | 200 |
| Ex. 2-64 | A-23 | 83 | B1 | 1.7 | - | - | I1/I2 | 0.01/0.01 | D1 | 4 | E9 | 8 | J1 | 0.25 | H1 | 3 | C1 | 200 |
| Ex. 2-65 | A-24 | 83 | B1 | 1.7 | - | - | I1/I2 | 0.01/0.01 | D1 | 4 | E9 | 8 | J1 | 0.25 | H1 | 3 | C1 | 200 |

**(Table 7-2)**

| | Sensitivity (mJ) | Taper angle (degree) | Profile | Pencil hardness | PCT evaluation |
|---|---|---|---|---|---|
| Ex. 2-29 | 30 | 71 | 4 | 4 | 5 |
| Ex. 2-30 | 20 | 70 | 4 | 4 | 5 |
| Ex. 2-31 | 50 | 73 | 4 | | 5 |
| Ex. 2-32 | 110 | 79 | 4 | 5 | 5 |
| Ex. 2-33 | 230 | 80 | 5 | 5 | 5 |
| Ex. 2-34 | 60 | 75 | 4 | 4 | 5 |
| Ex. 2-35 | 120 | 81 | 5 | 5 | 5 |
| Ex. 2-36 | 250 | 82 | 5 | 5 | 5 |
| Ex. 2-37 | 70 | 74 | 4 | 4 | 5 |
| Ex. 2-38 | 130 | 81 | 5 | 5 | 5 |
| Ex. 2-39 | 270 | 82 | 5 | 5 | 5 |
| Ex. 2-40 | 25 | 76 | 4 | 4 | 5 |
| Ex. 2-41 | 40 | 74 | 4 | 4 | 5 |
| Ex. 2-42 | 25 | 73 | 4 | 4 | 5 |
| Ex. 2-43 | 25 | 71 | 4 | 4 | 5 |
| Ex. 2-44 | 25 | 68 | 3 | 3 | 5 |
| Ex. 2-45 | 25 | 67 | 3 | 3 | 5 |
| Ex. 2-46 | 25 | 65 | 3 | 3 | 5 |
| Ex. 2-47 | 45 | 65 | 3 | 3 | 5 |
| Ex. 2-48 | 40 | 63 | 3 | 3 | 5 |
| Ex. 2-49 | 40 | 62 | 3 | 3 | 5 |
| Ex. 2-50 | 35 | 65 | 3 | 3 | 5 |
| Ex. 2-51 | 30 | 68 | 3 | 3 | 5 |
| Ex. 2-52 | 20 | 75 | 4 | 4 | 5 |
| Ex. 2-53 | 60 | 65 | 3 | 3 | 5 |
| Ex. 2-54 | 80 | 67 | 3 | 3 | 5 |
| Ex. 2-55 | 120 | 72 | 4 | 4 | 5 |
| Ex. 2-56 | 200 | 75 | 4 | 4 | 5 |
| Ex. 2-57 | 70 | 86 | 5 | 5 | 5 |
| Ex. 2-58 | 95 | 85 | 5 | 5 | 5 |
| Ex. 2-59 | 70 | 84 | 5 | 5 | 5 |
| Ex. 2-60 | 70 | 84 | 5 | 5 | 5 |
| Ex. 2-61 | 160 | 84 | 5 | 5 | 5 |
| Ex. 2-62 | 140 | 84 | 5 | 5 | 5 |
| Ex. 2-63 | 110 | 84 | 5 | 5 | 5 |
| Ex. 2-64 | 250 | 86 | 5 | 5 | 5 |
| Ex. 2-65 | 200 | 86 | 5 | 5 | 5 |

The abbreviations in Table 6-1 and Table 7-1 are as follows.
B1: CGI1397 (compound shown below)
B2: α-(*p*-Toluenesulfonyloxyimino)phenylacetonitrile (The synthesis method is as shown below)
B3: Oxime sulfonate compound synthesized by the following synthesis method
F1: 9,10-Dibutoxyanthracene (DBA)
I1: 1,5-Diazabicyclo[4.3.0]-5-nonene
I2: Triphenylimidazole
C1: Propylene glycol monomethyl ether acetate
H1: 3-Glycidoxypropyltrimethoxysilane (KBM-403 (manufactured by Shin-Etsu Chemical Co., Ltd.))
J1: Compound W-3 shown below
D1: NIKALAC MW-100LM (manufactured by Sanwa Chemical Co., Ltd.) D2: NIKALAC MX-270 (manufactured by Sanwa Chemical Co., Ltd.)
E1: EPICLON 7050 (manufactured by DIC Corp., epoxy equivalent: 1,750 to 2,100 g/eq)
E2: Epoxy resin 1004 (manufactured by Mitsubishi Chemical Corp., epoxy equivalent: 875 to 975 g/eq)
E3: YD-012 (manufactured by Nippon Steel Chemical Co., Ltd., epoxy equivalent: 600 to 700 g/eq)
E4: YD-011 (manufactured by Nippon Steel Chemical Co., Ltd., epoxy equivalent: 450 to 500 g/eq)
E5: EPICLON EXA-4816 (manufactured by DIC Corp., epoxy equivalent: 403 g/eq)
E6: EPICLON EXA-4822 (manufactured by DIC Corp., epoxy equivalent: 385 g/eq)
E7: EPICLON EXA-5300-70 (manufactured by DIC Corp., epoxy equivalent: 300 to 340 g/eq)
E8: EPICLON 860 (manufactured by DIC Corp., epoxy equivalent: 235 to 255 g/eq)
E9: JER157S65 (manufactured by Mitsubishi Chemical Corp., epoxy equivalent: 200 to 220 g/eq)
E10: Epoxy resin 827 (manufactured by Mitsubishi Chemical Corp., epoxy equivalent: 180 to 190 g/eq)
Ac1: Copolymer of benzyl acrylate (BnA)/methacrylic acid (MAA) = 60/40 (molar ratio) (Mw: 8,000, carboxy equivalent: 350 g/eq)
Ac2: Copolymer of BnA/MAA = 70/30 (molar ratio) (Mw: 8,000, carboxy equivalent: 497 g/eq)
Ac3: Copolymer of BnA/MAA = 80/20 (molar ratio) (Mw: 8,000, carboxy equivalent: 790 g/eq)
Ac4: Polymethyl methacrylate (PMMA, homopolymer)

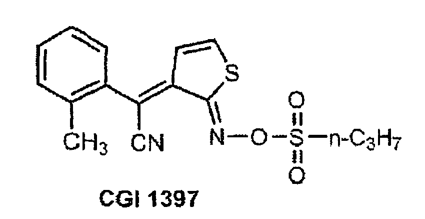

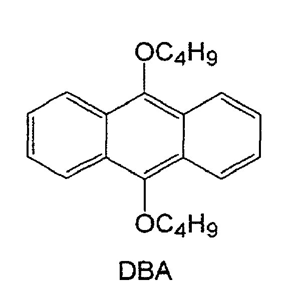

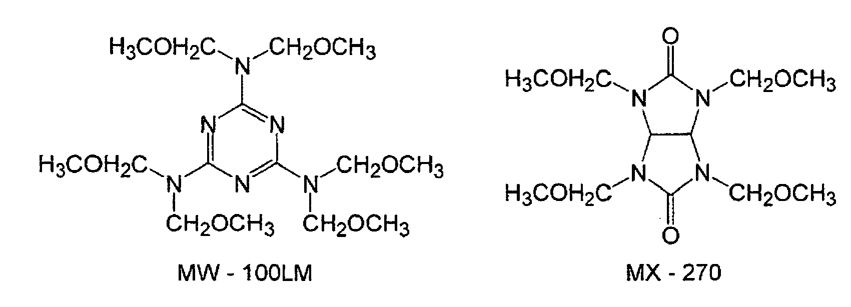

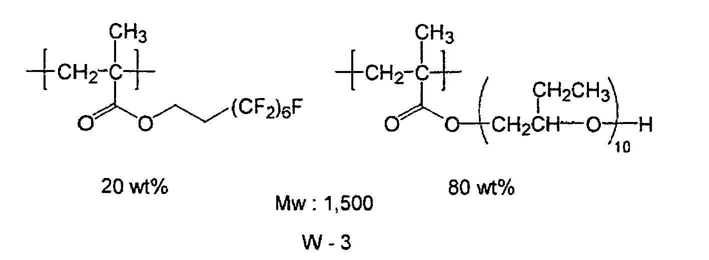

### <Synthesis of B2>

α-(*p*-Toluenesulfonyloxyimino)phenylacetonitrile was synthesized according to the method described in paragraph 0108 of JP-T-2002-528451.

### <Synthesis of B3>

Aluminum chloride (10.6 g) and 2-chloropropionyl chloride (10.1 g) were added to a suspension solution of 2-naphthol (10 g) and chlorobenzene (30 mL), and the mixture liquid was heated to 40°C to allow the mixture to react for 2 hours. Under ice cooling, a 4 N aqueous HCl solution (60 mL) was added dropwise to the reaction liquid, ethyl acetate (50 mL) was added thereto, and the mixture was partitioned. Potassium carbonate (19.2 g) was added to the organic layer, and the mixture was allowed to react at 40°C for 1 hour. Subsequently, a 2 N aqueous HCl solution (60 mL) was added thereto, and the mixture was partitioned. The organic layer was concentrated, and then crystals were reslurried in diisopropyl ether (10 mL). The slurry was filtered and dried, and thus a ketone compound (6.5 g) was obtained.

Acetic acid (7.3 g) and a 50% aqueous solution of hydroxylamine (8.0 g) were added to a suspension solution of the ketone compound thus obtained (3.0 g) and methanol (30 mL), and the mixture was heated to reflux. After the system was left to cool, water (50 mL) was added, and precipitated crystals were filtered and washed with cold methanol. The crystals were dried, and thus an oxime compound (2.4 g) was obtained.

The oxime compound (1.8 g) thus obtained was dissolved in acetone (20 mL), and under ice cooling, triethylamine (1.5 g) and p-toluenesulfonyl chloride (2.4 g) were added thereto. The mixture was heated to room temperature, and was allowed to react for 1 hour. Water (50 mL) was added to the reaction liquid, and precipitated crystals were filtered. Subsequently, the crystals were reslurried in methanol (20 mL), and the slurry was filtered and dried. Thus, 83 (2.3 g) was obtained.

The ¹H-NMR spectrum (300 MHz, CDCl₃) of B3 was as follows: δ = 8.3(d, 1H), 8.0(d, 2H), 7.9(d, 1H), 7.8(d, 1H), 7.6(dd, 1H), 7.4(dd, 1H) 7.3(d, 2H), 7.1 (d, 1H), 5.6(q, 1H), 2.4(s, 3H), 1.7(d, 3H).

Furthermore, (2) the evaluation of the taper angle and the evaluation of pattern profile, (3) the evaluation of the pencil hardness, and (4) the evaluation of PCT resistance of the photosensitive resin composition were carried out in the same manner as in Example 2-17, except that the photosensitive resin composition of Example 2-17 was used, and the conditions of the two-stage bake treatment for the (2) evaluation of the taper angle and the evaluation of the pattern profile were changed to the conditions described in Table 8. The evaluation results are shown together in Table 8.

**(Table 8)**

| Composition of Example 2-17 | | Taper angle (degree) | Profile | Pencil hardness | PCT resistance |
|---|---|---|---|---|---|
| 1^{st} stage bake | 2^{nd} stage bake | | | | |
| None | 230°C-60min | 35 | 1 | 3 | 5 |
| 80°C-30min | 230°C-60min | 58 | 2 | 3 | 5 |
| 90°C-30min | 230°C-60min | 62 | 3 | 4 | 5 |
| 100°C-30min | 230°C-60min | 64 | 3 | 4 | 5 |
| 110°C-30min | 230°C-60min | 65 | 3 | 4 | 5 |
| 120°C-30min | 230°C-60min | 66 | 3 | 4 | 5 |
| 130°C-30min | 230°C-60min | 68 | 3 | 4 | 5 |
| 140°C-30min | 230°C-60min | 70 | 4 | 4 | 5 |
| 150°C-30min | 230°C-60min | 65 | 3 | 4 | 5 |
| 160°C-30min | 230°C-60min | 58 | 2 | 4 | 5 |
| 170°C-30min | 230°C-60min | 53 | 2 | 4 | 5 |
| 180°C-30min | 230°C-60min | 49 | 2 | 4 | 5 |

### (Example 2-66)

The same operation as in Examples 2-1 to 2-65 was carried out, except that the thickness of the coating film was changed from 4 µm to 10 µm, 50 µm, and 100 µm, respectively, and (2) the evaluation of the taper angle and the evaluation of the pattern profile, (3) the evaluation of pencil hardness, and (4) the evaluation of PCT resistance of the photosensitive resin composition were carried out. The same evaluation results as the evaluation results obtained with a thickness of 4 µm were obtained.

### (Example 2-67)

In order to produce the micromachine described in JP-A-2000-343463 as a MEMS, MEMS devices were produced using the photosensitive resin compositions of Examples 2-1 to 2-65 and Comparative Examples 2-1 to 2-6 of the present invention as the resist film of FIG. 20 shown in the patent document. The performance of the microsensors was evaluated.

As a result, when the photosensitive resin compositions of Example 2-1 to 2-65 were used, satisfactory device characteristics were obtained, but the device characteristics were unsatisfactory when the photosensitive resin compositions of Comparative Examples 2-1 to 2-6 were used.

## Claims

1. A method for producing a pattern comprising:
forming a film by removing the solvent from a photosensitive resin composition
containing Component A being a polymer including a monomer unit a1 having a residue of a carboxyl group or a phenolic hydroxyl group protected with an acid-decomposable group,
and a monomer unit a2 having an epoxy group and/or an oxetanyl group; Component B being a photo acid generator; and Component C a being solvent,
exposing the film patternwise to an active radiation;
developing the exposed film with an aqueous developer liquid to form a pattern;
and
baking the pattern by heating it in two stages, the first stage baking being carried out at a temperature in the range of 90°C to 150°C and the second stage baking being carried out at a temperature in the range of 180°C to 250°C.

2. A method according to Claim 1, further comprising exposing the pattern to active radiation after the developing step and before the baking step.

3. A method according to Claim 1 or Claim 2, wherein the thickness of the pattern after the baking is 4 to 100 µm.

4. A method according to any preceding Claim, wherein the photosensitive resin composition further contains Component D being a thermal crosslinking agent.

5. A method according to any preceding Claim, wherein Component A further comprises a monomer unit a3 having a cyclic structure in addition to the monomer units a1 and a2.

6. A method according to any preceding Claim, wherein Component A further includes a monomer unit a4 having a carboxyl group or a hydroxyl group, in addition to the monomer units a1 and a2.

7. A method for producing a MEMS structure comprising:
either (i) producing a structure by using a pattern produced by the method according to any preceding Claim as a sacrificial layer at the time of lamination of the structure, and removing the sacrificial layer by plasma treatment; or
(ii) using a pattern produced by the method according to any preceding Claim as a component of the MEMS structure.

8. The use of a cured film of a photosensitive resin composition as a sacrificial layer at the time of lamination of a MEMS structure or as a component of a MEMS structure,
the cured film being formed by performing heating in two stages, the heating in the first stage being carried out at a temperature in the range of 90°C to 150°C, and the heating in the second stage being carried out at a temperature in the range of 180°C to 250°C, and
the photosensitive resin composition comprising:
Component A a being polymer including a monomer unit a1 having a residue of a carboxyl group or a phenolic hydroxyl group protected with an acid-decomposable group,
and a monomer unit a2 having an epoxy group and/or an oxetanyl group;
Component B being a photo acid generator; and
Component C a being solvent.

9. The use of a cured film according to Claim 8, wherein Component A further includes a monomer unit a3 having a cyclic structure, in addition to the monomer units a1 and a2.

10. The use of a cured film according to Claim 8 or Claim 9, wherein Component A further includes a monomer unit a4 having a carboxyl group or a hydroxyl group, in addition to the monomer units a1 and a2.

## Patentansprüche

1. Verfahren zur Herstellung eines Musters, umfassend:
Bilden eines Films durch Entfernen des Lösungsmittels von einer fotoempfindlichen Harzzusammensetzung, enthaltend eine Komponente (A), die ein Polymer ist, das eine Monomereinheit (a1) mit einem Rest einer Carbonsäuregruppe oder einer phenolischen Hydroxylgruppe, geschützt mit einer Säure-zersetzbaren Gruppe, aufweist, und eine Monomereinheit (a2), die eine Epoxygruppe und/oder eine Oxetanylgruppe aufweist; eine Komponente (B), die ein Foto-säurebildner ist; und eine Komponente (C), die ein Lösungsmittel ist;
musterweises Belichten des Films mit aktiver Strahlung;
Entwickeln des belichteten Films mit einer wässrigen Entwicklerflüssigkeit, um ein Muster zu bilden; und
Backen des Musters durch Erwärmen hiervon in zwei Schritten, wobei der erste Schritt des Backens bei einer Temperatur im Bereich von 90 bis 150°C durchgeführt wird, und der zweite Schritt des Backens bei einer Temperatur im Bereich von 180 bis 250°C durchgeführt wird.

2. Verfahren gemäß Anspruch 1, ferner umfassend das Belichten des Musters mit aktiver Strahlung nach dem Entwicklungsschritt und vor dem Backschritt.

3. Verfahren gemäß Anspruch 1 oder Anspruch 2, worin die Dicke des Musters nach dem Backen 4 bis 100 µm beträgt.

4. Verfahren gemäß irgendeinem vorhergehenden Anspruch, worin die fotoempfindliche Harzzusammensetzung ferner eine Komponente (D), die ein thermales Vernetzungsmittel ist, enthält.

5. Verfahren irgendeinem vorhergehenden Anspruch, worin die Komponente (A) zusätzlich zu den Monomereinheiten (a1) und (a2) eine Monomereinheit (a3) umfasst, die eine zyklische Struktur aufweist.

6. Verfahren gemäß irgendeinem vorhergehenden Anspruch, worin die Komponente (A) zusätzlich zu den Monomereinheiten (a1) und (a2) eine Monomereinheit (a4) umfasst, die eine Carboxylgruppe oder eine Hydroxylgruppe aufweist.

7. Verfahren zur Herstellung einer MEMS-Struktur, umfassend:
entweder
(i) Herstellen einer Struktur unter Verwendung eines Musters, das mit dem Verfahren gemäß irgendeinem vorhergehenden Anspruch hergestellt ist, als zu opfernde Schicht zum Zeitpunkt der Laminierung der Struktur und Entfernen der zu opfernden Schicht durch Plasmabehandlung; oder
(ii) Verwenden eines Musters, das durch das Verfahren gemäß irgendeinem vorhergehenden Anspruch hergestellt ist, als eine Komponente der MEMS-Struktur.

8. Verwendung eines gehärteten Films aus einer fotoempfindlichen Harzzusammensetzung als zu opfernde Schicht zum Zeitpunkt der Laminierung einer MEMS-Struktur oder als eine Komponente einer MEMS-Struktur,
wobei der gehärtete Film gebildet ist durch Durchführen von Erwärmen in zwei Schritten, wobei das Erwärmen im ersten Schritt bei einer Temperatur im Bereich von 90 bis 150°C durchgeführt wird, und das Erwärmen im zweiten Schritt bei einer Temperatur im Bereich von 180 bis 250°C durchgeführt wird, und
worin die fotoempfindliche Harzzusammensetzung umfasst:
eine Komponente (A), die ein Polymer ist, umfassend eine Monomereinheit (a1), die einen Rest einer Carboxylgruppe oder einer phenolischen Hydroxylgruppe, geschützt mit einer Säure-zersetzbaren Gruppe, aufweist, und eine Monomereinheit (a2), die eine Epoxygruppe und/oder eine Oxetanylgruppe aufweist;
eine Komponente (B), die ein Foto-Säurebildner ist; und
eine Komponente (C), die ein Lösungsmittel ist.

9. Verwendung eines gehärteten Films gemäß Anspruch 8, worin die Komponente (A) zusätzlich zu den Monomereinheiten (a1) und (a2) ferner eine Monomereinheit (a3) umfasst, die eine zyklische Struktur aufweist.

10. Verwendung eines gehärteten Films gemäß Anspruch 8 oder Anspruch 9, worin die Komponente (A) zusätzlich zu den Monomereinheiten (a1) und (a2) ferner eine Monomer (a4) umfasst, die eine Carboxylgruppe oder eine Hydroxylgruppe aufweist.

## Revendications

1. Procédé de production d'un motif comprenant :
la formation d'un film par élimination du solvant d'une composition de résine photosensible contenant un constituant A étant un polymère comprenant une unité monomère a1 présentant un résidu d'un groupe carboxyle ou d'un groupe hydroxyle phénolique protégé avec un groupe acide-décomposable, et une unité monomère a2 présentant un groupe époxy et/ou un groupe oxétanyle ; un constituant B étant un générateur de photoacide ; et un constituant C étant un solvant,
l'exposition du film à la manière d'un motif à un rayonnement actif ;
le développement du film exposé avec un liquide de révélateur aqueux pour former un motif ;
et
la cuisson du motif par chauffage de celui-ci en deux étapes, la cuisson de première étape étant réalisée à une température dans l'intervalle de 90°C à 150°C et la cuisson de seconde étape étant réalisée à une température dans l'intervalle de 180°C à 250°C.

2. Procédé selon la revendication 1, comprenant de plus l'exposition du motif à un rayonnement actif après l'étape de développement et avant l'étape de cuisson.

3. Procédé selon la revendication 1 ou la revendication 2, dans lequel l'épaisseur du motif après la cuisson est de 4 à 100 µm.

4. Procédé selon l'une quelconque des revendications précédentes, dans lequel la composition de résine photosensible contient de plus un constituant D étant un agent de réticulation thermique.

5. Procédé selon l'une quelconque des revendications précédentes, dans lequel le constituant A comprend de plus une unité monomère a3 présentant une structure cyclique en plus des unités monomères a1 et a2.

6. Procédé selon l'une quelconque des revendications précédentes, dans lequel le constituant A comprend de plus une unité monomère a4 présentant un groupe carboxyle ou un groupe hydroxyle, en plus des unités monomères a1 et a2.

7. Procédé de production d'une structure MEMS comprenant :
soit (i) la production d'une structure en utilisant un motif produit par le procédé selon l'une quelconque des revendications précédentes comme une couche sacrificielle au moment de la stratification de la structure, et l'élimination de la couche sacrificielle par un traitement au plasma ; soit
(ii) l'utilisation d'un motif produit par le procédé selon l'une quelconque des revendications précédentes comme un constituant de la structure MEMS.

8. Utilisation d'un film durci d'une composition de résine photosensible comme une couche sacrificielle au moment de la stratification d'une structure MEMS ou comme un constituant d'une structure MEMS,
le film durci étant formé par réalisation d'un chauffage en deux étapes, le chauffage dans la première étape étant réalisé à une température dans l'intervalle de 90°C à 150°C, et le chauffage dans la seconde étape étant réalisé à une température dans l'intervalle de 180°C à 250°C, et
la composition de résine photosensible comprenant :
le constituant A étant un polymère comprenant une unité monomère a1 présentant un résidu d'un groupe carboxyle ou d'un groupe hydroxyle phénolique protégé avec un groupe acide-décomposable, et une unité monomère a2 présentant un groupe époxy et/ou un groupe oxétanyle ;
le constituant B étant un générateur de photo acide ; et
le constituant C étant un solvant.

9. Utilisation d'un film durci selon la revendication 8, dans laquelle le constituant A comprend de plus une unité monomère a3 présentant une structure cyclique, en plus des unités monomères a1 et a2.

10. Utilisation d'un film durci selon la revendication 8 ou la revendication 9, dans laquelle le constituant A comprend de plus une unité monomère a4 présentant un groupe carboxyle ou un groupe hydroxyle, en plus des unités monomères a1 et a2.
